# EUROPEAN PATENT APPLICATION

(11) **EP 4 810 968 A1**
(43) Date of publication of application: **23.09.2026**
(21) Application number: 26165617.7
(22) Date of filing: 17.03.2026
(51) Int. Cl.: G01R 31/317, G01R 13/02

(54) **CONFIGURATION OF PARALLEL TESTING SYSTEMS**

(30) Priority: 18.03.2025 US 202563773888 P; 17.02.2026 US 202619541896
(71) Applicant: Chroma ATE Inc., Taoyuan City 333001 (TW)
(72) Inventor: Costello, Michael, Chandler, 85225 (US); Lu, Amy, Chandler, 85225 (US); Watson, Kyle, Chandler, 85225 (US); Wu, Shan Pei, Chandler, 85225 (US)
(74) Representative: Finnegan Europe LLP

(57) **Abstract**

The disclosure is directed to systems and method with improved coordination for multiple parametric test channels. The system can be configured to receive a testing routine and distribute test operations to a plurality of test channels comprising channel processors, testing circuits coupled to test pins configurable to be connected to the device under test (DUT), and trigger interfaces coupled to the testing circuits. Additionally, some implementations can include a hub device coupled to the processing system and to the trigger interfaces, the hub device includes programmable logic gates configured to define a trigger group including at least two of the trigger interfaces and to generate trigger signals according to the testing routine. Further, at least a portion of the channel processors perform operations according to the testing routine upon receipt of the trigger signals. The disclosure enables synchronized yet autonomous multi-channel testing that improves test throughput and timing accuracy.

## Description

### FIELD OF DISCLOSURE

The disclosed technology generally relates to systems, devices, apparatuses, and methods for synchronizing operations in multi-channel test systems, and in particular to synchronization architectures that coordinate independent test channels during parametric testing of circuits and/or semiconductor devices. Without limitation, the disclosed systems and methods involve the use of hub devices for synchronization, programmable logic implementing trigger groups, and/or channel processors executing test routines that respond to trigger signals for ordered execution of force and sense operations. The synchronization techniques described herein may be configured to align timing across multiple test channels while allowing the channels to operate autonomously between synchronization events, thereby improving timing determinism, reducing inter-channel skew, and increasing overall measurement throughput and efficiency in semiconductor device testing applications.

### BACKGROUND

Modern electronics rely on semiconductor devices. As semiconductor device geometries shrink to the nanometer scale and circuit architectures become more complex, assuring electrical performance and long-term reliability grows increasingly difficult. Semiconductor manufacturers therefore rely on systematic electrical testing during production to screen out defective parts and verify that devices satisfy applicable specifications before shipment.

Parametric testing is one category of semiconductor testing that focuses on direct measurement of electrical characteristics of devices and test structures. Representative parameters include voltages, currents, resistances, capacitances, impedances, leakage levels, breakdown voltages, and capacitance characteristics, which collectively provide information about device functionality and process health. Parametric tests may be performed at multiple points in the manufacturing flow, such as at wafer probe, after packaging, and during final test.

Wafer-level testing, conducted while the devices remain on the wafer, is particularly valuable because it can reveal process excursions and device anomalies before additional cost is invested in assembly and packaging. During wafer probe, test equipment applies electrical stimuli to pads on the wafer and measures resulting responses to determine whether the observed values fall within target limits. Similar principles apply at package and final test, where measurements confirm proper assembly and electrical connectivity.

Early-stage parametric measurements provide direct visibility into intrinsic device behavior without the confounding effects of packaging. By exercising test structures and representative devices distributed across the wafer, engineers can assess across-wafer uniformity, track shifts in key parameters such as threshold voltage and leakage, and build statistical models of device variation. The resulting data support yield analysis, process tuning, and device characterization, and therefore play a critical role in maintaining product quality.

### SUMMARY

In advanced parametric test environments, many applications call for force or sense in numerous pins or structures at once to either perform more complex measurements, improve wafer-level throughput, and/or reduce cost of test. Parallel parametric test platforms and per-pin architectures can perform such parallel testing enabling multiple pins to be biased and measured concurrently rather than serially. However, as the number of independently controllable pins increases, maintaining precise timing relationships among force and sense operations across channels becomes increasingly challenging. Small timing mismatches, race conditions, or delay margins can degrade measurement fidelity and complicate correlation between bench and production systems.

Some synchronization schemes often rely on scheduling operations or fixed trigger topologies that broadcast simple start or stop events to instruments or channels. While these approaches can align coarse timing, they provide limited flexibility for coordinating heterogeneous test sequences in which different pins execute different routines, branch based on local measurements, or require multiple, conditional rendezvous points. In such scenarios, enforcing accurate yet fast cross-channel synchronization frequently requires complex host-side orchestration or conservative timing margins that reduce effective parallelism.

The disclosed technology is directed to overcoming these, and other, limitations and improve the technical field. In some implementation, in the disclosed technology a test system is configured with a processor that compiles and controls a testing routine to a plurality of test channels and a hub device. The hub device can be implemented with programmable logic gates and configured to define trigger groups. The hub device can be flexibly configured to generate trigger signals for trigger groups according to user-provided testing routines, and to apply different logical relationships (e.g., AND and/or OR conditions) between trigger-in events on multiple pins. In some implementations, channel processors associated with the test channels perform operations based on the testing routine upon receipt of the trigger signals. By allowing dynamic grouping of multiple pins and reassigning group membership as tests progress, the disclosed trigger groups provide fine-grained, reconfigurable synchronization between channels. This capability can tighten timing alignment between multi-pin force and sense operations, and support heterogeneous test sequences while maintaining precise cross-channel control.

In addition, the disclosed systems can employ independent test channels with local channel processors and testing circuits at each test pin. These channel processors can execute tests, perform localized processing, and generate or respond to trigger events with limited, or no, host system intervention, enabling autonomous execution and data reduction at the pin or channel. In some embodiments, entire wafer test algorithms, including loops, conditionals, and measurement processing, can be downloaded to the channel processors, which then operate under coordination of the trigger groups while the host primarily manages high-level control and result collection. Coordinating such per-pin processing through programmable trigger groups allows the system to synchronize operations accurately while preserving high degrees of parallelism, reducing host-to-tester communication overhead, and improving both test throughput and timing determinism compared to architectures that rely on centralized sequencing or external trigger buses.

Some aspects of the disclosed technology involve a test system that coordinates many independent pins through a synchronization hub. A host-side processing system provides a testing routine, and each test channel includes its own channel processor, local testing circuit, and trigger interface tied to a test pin on the device under test. The channels are connected to a shared hub that contains programmable logic. The hub can define trigger groups that link two or more trigger interfaces and apply logical relationships between their trigger events. It generates trigger signals according to the testing routine, and each participating channel processor advances its local operation-such as a force or measurement step-when it receives the appropriate trigger signal at its trigger interface. This structure lets pins run their own routines between synchronization points while still meeting tight timing relationships at those points by leveraging the timing groups. The disclosed systems can improve both parallelism and control.

Other aspects of the disclosed technology are directed to a hub device that can be integrated into different test platforms to manage synchronization between channels. The hub exposes a first connection toward a processing system and a second connection toward multiple test channels. Inside the hub, programmable logic gates are fed by demultiplexers that receive trigger-in signals from the channels through a first routing module, and the outputs of the logic gates are distributed back to the channels by multiplexers through a second routing module. Group configuration registers store masks that describe which channels belong to which trigger groups, so the hub can be reprogrammed to change synchronization patterns without rewiring. By steering trigger-in signals through logic functions and mapping their outputs back to trigger-out signals on selected channels, this device can allow flexible, mask-based grouping of pins and precise generation of shared trigger events, enabling dynamic synchronization schemes that can adapt to different devices, test plans, and production needs.

Further aspects of the disclosed technology relate to a method that uses downloadable routines and trigger groups to synchronize a multi-channel parametric tester. A testing routine is first received at the processing system and compiled into channel routines that are loaded into memories on the individual test channels. The processing system then configures the hub to define one or more trigger groups that link trigger interfaces on selected channels. During execution, the hub uses its programmable logic and inputs from the processing system or channels to generate a trigger signal for a given group and sends that signal to the associated trigger interfaces. The channel routines instruct the local processors to wait at synchronization points until the trigger signal arrives, and then proceed with their next operations in line with the overall test procedure. This method lets entire wafer-level algorithms run locally on the channels while the hub enforces synchronization events, reducing host-tester traffic and enabling fast, accurate coordination across many pins.

### BRIEF DESCRIPTION OF THE DRAWINGS

Details of one or more aspects of the subject matter described in this disclosure are set forth in the accompanying drawings and the description below. However, the accompanying drawings illustrate only some typical aspects of this disclosure and are therefore not to be considered limiting of its scope. Other features, aspects, and advantages will become apparent from the description, the drawings, and the claims.
FIG. 1 illustrates a schematic view of a multi-channel parallel device testing system according to an embodiment of the present disclosure.
FIG. 2 illustrates a top-front view of a test head of the multi-channel parallel device testing system according to an embodiment of the present disclosure.
FIG. 3 illustrates a bottom-back view of the test head of the multi-channel parallel device testing system according to an embodiment of the present disclosure.
FIG. 4 illustrates a front view of the test head of the multi-channel parallel device testing system according to an embodiment of the present disclosure.
FIG. 5 illustrates a schematic view of a retractable electrical contact interface apparatus in a retracted position according to an embodiment of the present disclosure.
FIG. 6 illustrates a schematic view of a power supply of the top assembly according to an embodiment of the present disclosure.
FIG. 7 illustrates a hub block diagram of the multi-channel parallel device testing system according to an embodiment of the present disclosure.
FIG. 8 illustrates a hub architecture and communication according to an embodiment of the present disclosure.
FIG. 9 illustrates a parameter block diagram of the top assembly according to an embodiment of the present disclosure.
FIG. 10 illustrates a schematic circuit of a test channel in the multi-channel parallel device testing system according to an embodiment of the present disclosure.
FIG. 11 illustrates a block diagram for an adaptable testing channel according to an embodiment of the present disclosure.
FIG. 12 illustrates a block diagram of a resource card according to an embodiment of the present disclosure.
FIG. 13 illustrates a schematic circuit of the pulse daughter board according to an embodiment of the present disclosure.
FIG. 14 illustrates a block diagram of a Frequency Measurement Unit (FMU) reciprocal mode according to an embodiment of the present disclosure.
FIG. 15 illustrates a measurement path of a Capacitance Measurement Unit (CMU) according to an embodiment of the present disclosure.
FIG. 16 illustrates a block diagram of the CMU according to an embodiment of the present disclosure.
FIG. 17 illustrates a block diagram of Measuring Unit (MU) with Transimpedance Amplifier (TIA) according to an embodiment of the present disclosure.
FIG. 18 illustrates a schematic circuit of the test channel of the multi-channel parallel device testing system according to an embodiment of the present disclosure.
FIG. 19 illustrates a schematic circuit of the test channel of the multi-channel parallel device testing system for high impedance device under test (DUT) according to an embodiment of the present disclosure.
FIG. 20 illustrates a block diagram of multiple test channels in a multi-channel parallel device testing system according to an embodiment of the present disclosure.
FIG. 21 illustrates a block diagram of multiple test channels in a multi-channel parallel device testing system for high impedance DUT according to an embodiment of the present disclosure.
FIG. 22 illustrates an embodiment of a test system according to an embodiment of the present disclosure.
FIG. 23 illustrates another embodiment of a test system for high impedance DUT according to an embodiment of the present disclosure.
FIG. 24 illustrates a schematic circuit for measuring a C-V characteristic of a MOSFET on a wafer that the multi-channel parallel device testing system is mounted according to an embodiment of the present disclosure.
FIG. 25 illustrates a schematic circuit for measuring a C-V characteristic according to an embodiment of the present disclosure.
FIG. 26 illustrates a schematic of a single high channel and other low channels testing according to an embodiment of the present disclosure.
FIG. 27A illustrates a schematic of a first high-speed pulse IV test according to an embodiment of the present disclosure.
FIG. 27B illustrates a schematic of a second high-speed pulse IV test according to an embodiment of the present disclosure.
FIG. 28 illustrates a calibration block diagram according to an embodiment of the present disclosure.
FIG. 29A illustrates a schematic of a first grouped trigger implementation according to an embodiment of the present disclosure.
FIG. 29B illustrates a schematic of a second grouped trigger implementation according to an embodiment of the present disclosure.
FIG. 29C illustrates a schematic of a third grouped trigger implementation according to an embodiment of the present disclosure.
FIG. 29D illustrates a schematic of a fourth grouped trigger implementation according to an embodiment of the present disclosure.
FIG. 30 illustrates a block diagram of a system including a hub for trigger groups and per-channel processing according to an embodiment of the present disclosure.
FIG. 31 illustrates a flow chart of a method for configuration of a testing system according to an embodiment of the present disclosure.

### DETAILED DESCRIPTION

Some of the disclosed embodiments are described with reference to the accompanying drawings. In the figures, the left-most digit(s) of a reference number identifies the figure in which the reference number first appears. Wherever convenient, the same reference numbers are used throughout the drawings to refer to the same or like parts. In the following detailed description, numerous specific details are set forth in order to provide a thorough understanding of the disclosed example systems or methods. However, it will be understood by those skilled in the art that the principles of the example methods and systems may be practiced without every specific detail. Well-known methods, procedures, and components have not been described in detail so as not to obscure the principles of some of the disclosed methods and systems. Unless explicitly stated, the example methods and processes described herein are neither constrained to a particular order or sequence nor constrained to a particular system configuration. Additionally, some of the described methods and systems or elements thereof can occur or be performed (e.g., executed) simultaneously, at the same point in time, or concurrently.

It is to be understood that both the foregoing general description and the following detailed description are example and explanatory only and are not restrictive of this disclosure. The accompanying drawings, which are incorporated in and constitute a part of this specification, illustrate several disclosed methods and systems and together with the description, serve to outline principles of some of the disclosed methods and systems.

In some implementations, a parametric test system includes a host computer or embedded controller that receives a testing routine written in a scripting language or graphical test environment. That testing routine describes which pins of a device under test should be biased, measured, or monitored over time. The system can include many test channels, each built with its own small processor, local testing circuit, and trigger interface connected to a test pin. The testing circuit can contain a source/measure resource, range switches, and protection elements that directly interface to the DUT pad. The trigger interface exposes at least one input and one output signal that carry timing events between the channel and a hub device. The hub device can use configurable logic to map relationships between trigger interfaces. For example, two or more trigger interfaces may be grouped so that a condition on one channel causes a synchronized response on others. The testing routine loaded in the host can specify when a given channel should wait for a group-related trigger and when it should proceed with local operations. This structure allows channels to run independent code between synchronization points while still enforcing specific ordering when multiple pins must act together, improving timing control and parallel test efficiency compared with systems that step every channel from the host on a command-by-command basis.

In some designs, the hub can perform group synchronization by routing trigger-in events from the test channels through demultiplexers into a bank of AND gates. Each channel's trigger-out line on the channel card can feed a shared high-speed backplane signal, which arrives at an input port on the hub. Demultiplexers inside the hub then steer that incoming signal onto one of several internal lines that feed the AND gate inputs. The mapping from channels to gate inputs is controlled by a first routing module that can be implemented as a register-controlled crossbar or a set of small switching matrices. On the output side, each AND gate can produce a group event that represents an "all ready" condition for the channels assigned to that gate. A set of multiplexers, driven by a second routing module, then distributes this group event back out toward specific trigger-in pins on the channel cards as trigger-out signals from the perspective of the hub. This arrangement allows the same physical backplane wiring to support many different logical groupings, simply by reprogramming the demultiplexers, routing fabric, and multiplexers. The benefit is a compact, flexible hardware structure that can express complex synchronization patterns without dedicating individual wires for every possible channel combination.

Other implementations may favor broadcast-style synchronization where a single event on any channel within a group should cause a shared trigger for other members. In these cases, the hub can use OR logic and selection switches rather than AND logic and demultiplexers. Each channel presents a trigger signal to a selection switch bank that decides whether that channel participates in a given OR group. The selection switches can be realized as pass transistors, small FET-based crossbar elements, or digital multiplexers controlled by configuration registers. Outputs of the selected switches feed inputs of OR gates, each OR gate creating a "group event" whenever at least one member channel asserts its input. The OR gate outputs serve as the basis for the trigger signal delivered back to the group, for example by driving a shared line that several channels monitor. This form of grouping is useful for cooperative tasks such as "start on first ready channel," "abort if any channel reports an error," or "advance once any measurement completes," and helps reduce idle time across the tester by allowing work to continue as soon as any qualifying event occurs.

Some hub configurations can implement barrier-like synchronization using AND logic. Each channel in a group asserts a trigger-in signal when it reaches a defined point in its local routine, such as after completing a bias step or a measurement. These trigger-in events are wired or routed to inputs of an AND gate inside the hub. The AND gate output moves to an active state only when all inputs have asserted, which means that every channel in the group has reached the synchronization point. The hub can then fan this output back to the channels as a trigger-out signal, signaling that they may proceed with the next phase of their routines. In effect, the AND gate enforces a rendezvous point across channels, eliminating race conditions where some pins would otherwise move ahead while others lag behind. This is particularly beneficial for tests that depend on coherent conditions across several terminals of a transistor or circuit, such as biasing a gate, drain, and bulk to specific levels before measuring a source current, as the system guarantees that all pins have reached the correct state before the measurement proceeds.

In some implementations, the hub can be built around a field-programmable gate array (FPGA) clocked by a system clock. The FPGA can host the trigger logic, routing modules, and configuration registers, allowing the synchronization behavior to be updated by downloading a new configuration bitstream or by changing register contents at runtime. The FPGA can tie into a test-head backplane that carries trigger lines from each channel card and may also receive information about DUT identity, probe touchdown configuration, or test plan context from the processing system. When a new DUT is contacted by the probe card, the host can map that DUT's pins to specific test channels and instruct the FPGA to build trigger groups around those channels. Because the FPGA operates synchronously with a system clock, the propagation delay from trigger-in to trigger-out can be controlled and characterized, giving the system deterministic timing for synchronization events.

To support flexible grouping, in some embodiments the hub can include a bank of configuration registers where each register holds a bit mask representing membership of test channels in a trigger group. For example, if the system supports sixty-four channels, each mask can be a sixty-four-bit value where a "1" bit signals that the corresponding channel participates in that group. The routing modules and AND/OR logic read these masks to decide which channel trigger lines should connect into each logic gate and which channels should receive that gate's output. In one implementation, firmware on the processing system writes these masks over a serial control interface whenever the test plan or DUT mapping changes. This mask-based approach makes it easy to enable or disable channels in a group, support overlapping groups, or create nested synchronization schemes without rewiring the hardware. The benefit is that engineering teams can reconfigure group structures through software, which speeds up test development and allows the same physical tester to adapt quickly to different wafer layouts and test strategies.

In some scenarios, synchronization should occur as soon as any member of a set of channels reaches a condition. To support this, the hub can use OR logic for certain trigger groups. Here, each channel in the group may send a trigger-in signal when a local criterion is met, such as detecting a threshold crossing or an error condition. OR gates combine these signals so that the group trigger becomes active as soon as any input asserts. The hub forwards this group trigger back to selected channels as trigger-out events, prompting them to execute an appropriate response, such as stopping a stress test, logging a failure, or branching to a recovery routine. OR-based groups can be useful in stress or reliability testing, where a failure on one sample can be used to halt testing across related devices, and in timing-sensitive measurements where the earliest event among several channels defines the time reference for analysis.

In test environments where many DUTs or regions of a wafer are exercised in parallel, the software controlling the tester can treat trigger groups as reusable resources. At startup, the system may create a pool of group identifiers, each with associated masks and logic settings in the hub. When the host prepares to run a testing routine on a particular set of pins, it allocates an available group identifier from the pool, assigns the relevant channels to that group, and communicates this configuration to the hub. Once the test routine finishes for that DUT or region, the host clears the masks and returns the group identifier to the pool.

The channel processors in this architecture can run small programs that not only send simple commands to the testing circuits but also perform computation on measured data. A representative program might execute a sense operation to measure current, perform arithmetic to compare the result with a target threshold, and then adjust the forced voltage or current accordingly. The logic can include loops that repeat a bias-and-measure sequence until a convergence condition is met, or branching that chooses between different test paths based on measurement outcomes. Because these operations happen on the channel hardware, the system avoids the latency of sending raw data back to the host after every step and waiting for a response. The test head can therefore perform complex algorithms such as staircase sweeps, binary searches for breakdown points, or dynamic stress adjustments at the pin, while the host only receives summarized results or key parameters. This local intelligence can reduce communication traffic and can shorten total test time.

To support autonomous operation, each test channel can include a local memory that stores code and data for that channel's routine. Before testing begins, a host compiler can transform the high-level testing routine into a set of per-channel routines tailored to the specific pin assignments. The compiler analyzes which channels are actually used for a given DUT and which roles they play, such as gate, drain, source, or reference. It may then load only the relevant routines into the memories of those channels, leaving others idle or loaded with default idle code. This preloading happens during a setup phase, for example while the probe is stepping to a new location on the wafer. At run time, the channels execute their local code directly from their memories without, or with little, host supervision.

Within these per-channel routines, the local processor can orchestrate several categories of activity. A routine might start by configuring the testing circuit for a force operation, such as applying a specified voltage or current to the DUT pin. After a programmed delay, the processor can initiate a sense operation that acquires a measurement value from an analog-to-digital converter or other measurement block. The routine may then compute derived quantities, such as averages over several samples, slopes of I-V segments, or normalized values relative to a reference. Once the local computation is complete, the processor can send a compact result back to the host, such as a single parameter or pass/fail status, rather than streaming every raw data point. This approach reduces the amount of data that must cross the host interface, which is especially beneficial when many channels operate in parallel or when the tester runs long stress experiments that would otherwise generate very large data sets.

In some aspects, the hub device not only handles triggers but also exposes a small, shared memory region that all channel processors can read and write. This memory can hold global variables that serve as communication flags, counters, or shared data values such as reference voltages or measured thresholds. For example, one channel might write a measured breakdown voltage into a global variable, while another channel reads that value to determine how to bias a related structure. Because the memory resides in the hub, access latency can be lower and more uniform than if the channels had to reach all the way to the host, and the hub can enforce arbitration rules or priority schemes to avoid conflicts. This shared-variable mechanism can complement the trigger-based synchronization and enables more sophisticated coordination patterns, such as shared state machines or cooperative algorithms across channels.

The testing circuit on each channel can be built including a potential node that connects to the DUT pin. A pulse resource feeds this node through a controlled path that allows generation of transient voltage or current waveforms, such as square pulses, ramps, or arbitrary patterns synthesized by a digital-to-analog converter. A measuring resource attaches to the same node through selectable range paths, for example a high-current branch and a low-current branch that differ in shunt resistance, gain, or protection limits. A mode switch interconnects the pulse resource, measuring resource, and the potential node so that the channel can choose whether the node is driven by the pulser, monitored by the measuring circuitry, or both in coordinated fashion. When the mode switch connects the pulser, the system can stress the DUT with fast edges or high-voltage events. When the measuring resource is connected via the high-current branch, the system can observe large conduction currents or breakdown events. When the low-current branch is selected, the system can resolve tiny leakage currents with improved sensitivity.

Some implementations may encode trigger codes into multi-bit codes carried along the trigger paths. The hub can take raw trigger events and package them into codes that distinguish between different causes, such as a barrier synchronization event, a broadcast start event, or an error condition. For example, an AND-based group event might be given one code value, an OR-based event another value, and an error reported by any channel in the group a third value. These codes can travel over the same physical lines that carry trigger signals, but the channel processors decode the bits and decide how to respond. A channel routine might proceed with a measurement if it receives a synchronization code, reinitialize its state machine if it receives a start code, or log a failure and halt further actions if it receives an error code. By embedding this semantic information into the trigger mechanism, the system can support richer coordination without dedicating separate wires or control lines for each event type, which simplifies wiring and allows the hub and channels to evolve with new event types through firmware updates.

The architecture can be sized for modest systems with a small number of channels or scaled up for large test heads that serve high-pin-count devices. In larger systems, the host software can compile the testing routine into individual channel routines that include explicit trigger-wait instructions at key synchronization points. With dozens of channels active, the system may maintain many distinct trigger groups at once, each regulating a subset of channels associated with specific DUT terminals or structures. The hub's logic fabric can generate and distribute group triggers efficiently across all these groups without excessive delay or contention. To accomplish this, the design may partition the logic into segments or use hierarchical grouping where local groups feed higher-level groups. This scalability can allow the same conceptual synchronization scheme to apply whether the system is testing a small analog component or a complex system-on-chip with hundreds of pins. Higher channel counts and multiple groups, used together with compiled channel routines, enable fine-grained parallelism while maintaining control over the ordering of critical operations.

Moreover, to simplify configuration, the host can prepare a trigger mask that defines which channels should respond to a given hub-trigger signal. This mask can be distinct from the group membership mask and may be used to gate which channels actually start their routines when a global start trigger is asserted. During setup, the host may load channel routines into the per-channel memories and then writes the trigger mask and group configuration into the hub. When the system is ready to begin testing, the host could assert a start event that the hub forwards according to the mask. Channels whose bits are set in the mask begin executing their loaded routines upon receiving this event, while others remain idle or continue running previous code.

In some implementations, a testing routine can assign three specific channels as gate, drain, and source roles for a given DUT instance. Each role has its own channel routine that includes force steps, sense steps, and synchronization steps. For example, the gate channel may ramp voltage according to a predefined sequence while the drain channel forces a constant voltage or current and the source channel senses resulting current. Synchronization steps tied to trigger signals can help ensuring that the three channels reach specific bias points before a measurement takes place or before the next step of the ramp begins. By structuring tests around role-specific channels, the system can reuse patterns across different DUTs while only remapping which physical pins play which roles.

In some aspects, channel routines can include delay operations that pause execution between a force step and a sense step to wait for synchronization and/or trigger signals. These delays may be fixed or adaptive, based on monitoring phenomena such as dI/dt or dV/dt until they fall below a threshold. In a multi-channel context, one channel might perform a forced change and then send a trigger to indicate the change has occurred, while another channel waits not only for that trigger but also for its own local delay to expire before measuring.

In some aspects, the hub can interface on one side with a system controller and on the other side with test channel cards. One connector or backplane interface carries configuration commands and status information to and from the processing system, while another interface carries trigger lines to the channels. Internally, banks of demultiplexers can receive trigger-in signals from channels and route them, under control of a first routing structure, to inputs of logic gates that perform AND, OR, or more complex functions. On the output side, multiplexers under control of a second routing structure may steer the resulting trigger-out signals back to selected channels. Group configuration registers can store masks that express membership of channels in each logical group, and these masks influence both routing structures so that a given group's logic receives only its members' trigger-in signals and drives only its members' trigger-out lines. Delivering this hub as a separate, configurable device makes it easier to integrate advanced synchronization into a variety of tester platforms without redesigning the entire test head, and allows future improvements in the trigger fabric to be adopted by replacing or upgrading the hub.

In further aspects of the disclosed technology, a method may involve the implementation of parallel parametric testing. A user can define a testing routine that specifies which measurements to perform and how to coordinate them across pins. The host processing system compiles this routine into channel-specific routines that account for the roles and capabilities of each test channel. These routines are loaded into the memories on the channel hardware, preparing the test head for autonomous operation. Next, the host configures the hub by assigning channels to trigger groups and programming the logic so that triggers are generated from appropriate combinations of events and delivered to the correct receivers. During execution, when the test runs on a wafer or packaged device, the channels follow their local routines but pause at designated synchronization points until they receive trigger signals from the hub. The hub generates these signals based on the programmed logic and inputs from channels or the host, ensuring that cross-channel ordering constraints in the testing routine are respected. This process allows complex, wafer-level algorithms to run primarily on the test head, with the host focusing on high-level coordination and data collection, which leads to faster test times and more predictable synchronization compared with schemes that manage every step directly from the host.

Reference will now be made in detail to some of the disclosed methods and systems, examples of which are illustrated in the accompanying drawings.

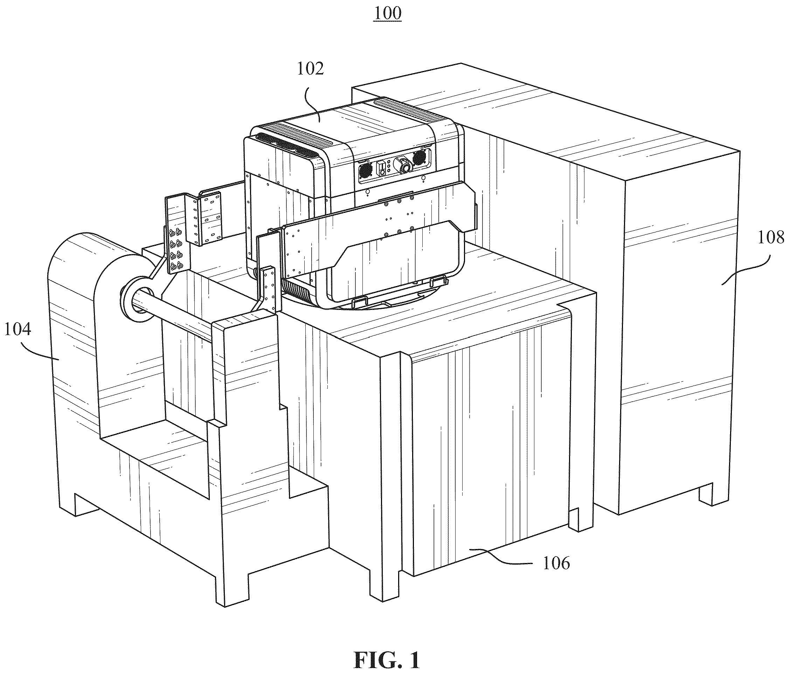

FIG. 1 illustrates a schematic view of a multi-channel parallel device testing system 100 according to an embodiment of the present disclosure. Multi-channel parallel device testing system 100 may include prober 102, tester manipulator 104, prober interface 106, and cabinet 108.

Prober 102 may be rotatably mounted on tester manipulator 104, and may be electrically connected to components in cabinet 108 by high-density cabling or a blind-mate backplane for receiving power, clock, trigger signal, and data. Tester manipulator 104 can be mounted on one side of prober interface 106. Cabinet 108 can be mounted on the other side of prober interface 106. In some embodiments, prober interface 106 can be located between tester manipulator 104 and cabinet 108. Tester manipulator 104 may mechanically center the assembly, hold, and locate prober 102 for aligning to a mating face of prober interface 106. Prober interface 106 may locate beneath prober 102 and be docked to tester manipulator 104.

When tester manipulator 104 rotates, prober 102 may be lowered onto a DUT held by prober interface 106 or may be raised away from the DUT. Cabinet 108 can be connected to prober 102 via coax/differential bundles or a blind-mate back-plane to communicate with the host PC over Ethernet/PCIe.

In some embodiments, prober 102 may function as a main instrumentation module or test head positioned at the front of system 100. In some embodiments, prober 102 can house parametric measurement electronics such as source measure units (SMUs), switching circuits, timing generators, and associated control hardware. Prober 102 may provide the primary electrical interface to a wafer or DUT, and can be configured with high-density triaxial connectors, blind-mate coaxial assemblies, or differential interfaces to reduce insertion loss and signal distortion. In certain embodiments, prober 102 may also include shielding structures, guarded pathways, or integrated calibration circuitry to maintain low leakage and high accuracy across a wide voltage and current range.

In certain embodiments, cabinet 108 may house one or more parametric measurement units, switching assemblies, power distribution modules, and/or cooling systems. Cabinet 108 can be fabricated from sheet metal, aluminum alloy, stainless steel, or composite structures depending on thermal and mechanical requirements. In some embodiments, cabinet 108 may include modular bays or racks for accommodating resource cards or measurement modules, thereby enabling flexible channel expansion. Thermal management can be provided by forced-air cooling, liquid cooling, or hybrid configurations, and cabinet 108 may further include vibration isolation mounts or shock absorbers to reduce external disturbances during sensitive measurements.

Prober 102 and tester manipulator 104 may be constructed from rigid, low-expansion materials such as granite, ceramic composites, or stabilized metal alloys to ensure positional accuracy and mechanical stability during wafer probing operations. In some embodiments, tester manipulator 104 may incorporate linear actuators, pneumatic lifts, or rotary bearings to enable controlled motion when docking and undocking prober 102. Prober interface 106 can include socketed connectors, blind-mate triaxial contacts, or custom high-density pin blocks to electrically couple the prober to cabinet 108. In alternative embodiments, prober interface 106 may incorporate shielding structures or guard traces formed from conductive materials to minimize electrical noise and crosstalk between adjacent test channels.

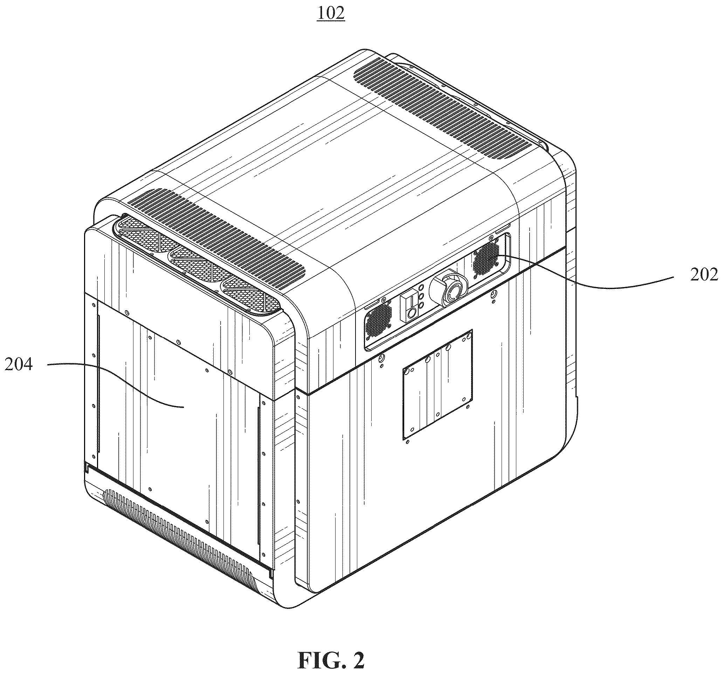

FIG. 2 illustrates a top-front view of prober 102 of system 100 according to embodiments of the present disclosure. As shown in FIG. 2, prober 102 may include interface panel 202 and side panel 204. Interface panel 202 may be located on the front upper region of prober 102. Interface panel 202 may concentrate the connectors used to link prober 102 to cabinet 108 and tester manipulator 104. Interface panel 202 may carry high-density signal connectors, power inlets, clock and trigger ports, and high-rate data links, along with interlock or status terminals. Vent grilles visible near interface panel 202 may provide airflow for cooling and may include dust filtering.

Side panel 204 may be an enclosure plate secured by multiple screws on the side of prober 102. Side panel 204 may provide service access to internal channel electronics for installation, maintenance, or replacement of modules such as HC and LC switching, analog front ends, direct digital synthesizers, analog-to-digital converters, phase-correction registers, and memory. Side panel 204 may incorporate Electro Magnetic Interference (EMI) gaskets, grounding springs, and locating features so that shielding and mechanical rigidity are maintained after reassembly.

In some embodiments, prober 102 may further include ventilation assemblies integrated into the upper and lower regions of the housing. These ventilation assemblies can be configured with forced-air fans, heat exchangers, or liquid cooling conduits to regulate internal temperatures of high-density electronics. The vent grilles may be fabricated from corrosion-resistant alloys or polymer composites, and may incorporate removable filter media to prevent dust accumulation. The placement of these cooling features proximate to interface panel 202 enables localized thermal management near high-power connectors and data links.

Prober 102 may also be constructed with modular exterior panels, including side panel 204, to facilitate flexible servicing and upgrade paths. In some embodiments, the panels may be manufactured from aluminum, stainless steel, or carbon fiber composites depending on weight and shielding requirements. The enclosure can be sealed with EMI gaskets to reduce radiated emissions, and fasteners securing the panels may be configured for tool-less or quick-release access to accelerate maintenance cycles. Optional structural reinforcements, such as internal ribs or honeycomb plates, may be included within prober 102 to improve rigidity and reduce vibration transmission during sensitive measurements.

In alternative embodiments, interface panel 202 may incorporate additional or alternative connector types depending on system configuration. For example, interface panel 202 can include fiber-optic transceivers for high-bandwidth, low-latency data transfer, or wireless communication modules to reduce cabling complexity in certain installations. Redundant power inlets and signal connectors may also be provided to support fault tolerance and hot-swap capability. In some configurations, interface panel 202 can be reconfigurable or replaceable as a module, allowing different connector layouts to be deployed based on application requirements or customer specifications.

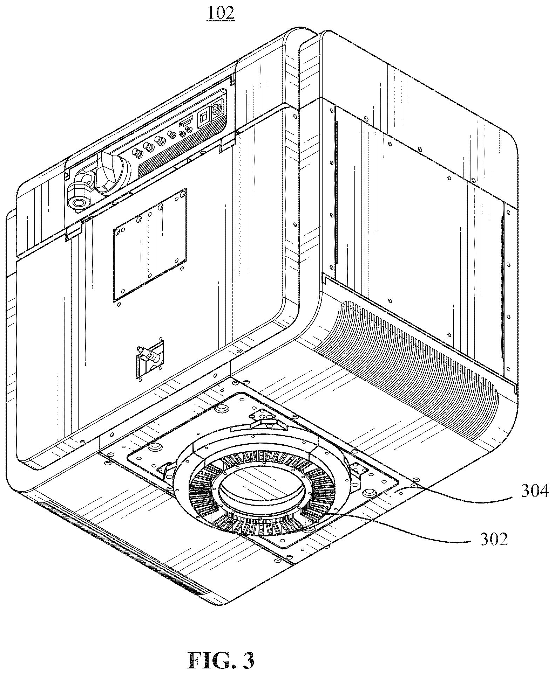

FIG. 3 illustrates a bottom-back view of prober 102 of multi-channel parallel device testing system 100 according to an embodiment of the present disclosure. As shown in FIG. 3, prober 102 may include probe card interface 302 and docking plane 304. Probe card interface 302 may be mounted at the center of docking plane 304 of prober 102 by an annular frame with multiple fasteners and alignment features. Probe card interface 302 may carry an array of probes arranged to contact wafer test points and interfaces electrically to prober 102 through blind-mate connectors that route force and sense signals to the channel front ends within prober 102.

When testing a wafer DUT, the wafer may be raised to engage the probes of probe card interface 302, while prober 102 provides mechanical alignment, shielding, and thermal management, and communicates with the DUT to deliver stimuli and acquire measurement data.

Docking plane 304 may further include mechanical guides, dowel pins, and kinematic mounts that ensure repeatable alignment between probe card interface 302 and the mating connectors within prober 102. In some embodiments, docking plane 304 can be fabricated from aluminum alloy, stainless steel, or ceramic composites to provide a stable, low-expansion platform that maintains positional accuracy across temperature variations. Docking plane 304 may also incorporate shielding layers or conductive coatings to reduce electromagnetic interference and preserve signal integrity during high-precision measurements.

Probe card interface 302 may be configured with interchangeable probe arrays to accommodate different wafer technologies, device geometries, or pad layouts. In some embodiments, probe card interface 302 can employ vertical probe needles or tips, MEMS probe tips, or cantilevered spring contacts, depending on the required pitch and current-handling capacity. The probe card may also include embedded passive components, such as decoupling capacitors or termination resistors, to improve high-frequency performance. For thermal management, probe card interface 302 and docking plane 304 may be coupled to integrated airflow channels or liquid cooling features positioned along the underside of prober 102.

Pins or connectors probe card interface 302 may be arranged in a variety of configurations to permit customization for different testing applications. In some embodiments, the pins may be organized in linear arrays, radial patterns, or high-density grids to match the pad geometry of different wafers or packaged devices. The probe tips may employ vertical spring probes, MEMS micro-springs, or cantilevered needles to accommodate variations in contact force, pitch, and current capacity. Alternative mechanisms can include adjustable probe blocks, replaceable pin inserts, or modular probe arrays that allow rapid reconfiguration without replacing the entire probe card assembly. This flexibility can enable probe card interface 302 to be adapted for logic devices, memory arrays, power semiconductors, or mixed-signal circuits with differing electrical and mechanical requirements.

In some embodiments, probe card interface 302 may further incorporate calibration and alignment mechanisms to ensure consistent electrical contact across the entire pin array. Such mechanisms can include self-planarizing probe structures that adjust tip height during initial touchdown, optical fiducials embedded in docking plane 304 to guide automated vision alignment systems, or mechanical micro-adjusters configured to fine-tune the vertical and lateral position of the probe array. Additional implementations may include integrated height sensors, strain gauges, or capacitive sensors that detect planarity deviations and provide feedback for automated compensation. These features enable probe card interface 302 to maintain accurate contact with wafer pads across varying topographies and thermal conditions, thereby improving repeatability and reducing setup time between tests.

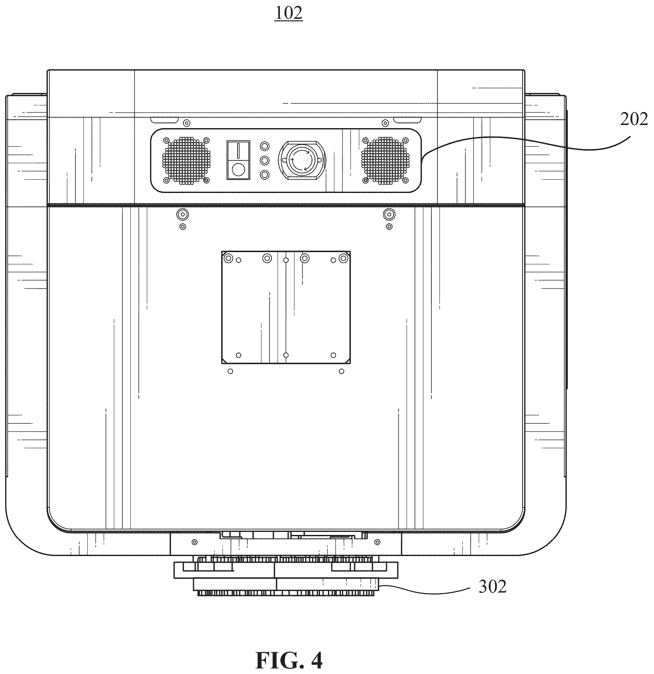

FIG. 4 illustrates a front view of prober 102 of multi-channel parallel device testing system 100 according to an embodiment of the present disclosure. An elongated I/O panel disposed near the upper front groups connectors and indicators for power input, clock and trigger signals, and high-rate data links. Vent grilles adjacent to the panel promote airflow. Fasteners and alignment features around the panel facilitate secure mounting and reliable mating to cable harnesses or a blind-mate backplane. A rectangular service cover located in the mid-lower region provides access for installation, maintenance, or replacement of internal channel electronics and cabling while preserving enclosure shielding and rigidity. Along the lower edge, a docking assembly protrudes to define a mating interface for a probe card interface 302, including an annular structure with mechanical guides and locking points that maintain planarity and repeatable alignment and provide the electrical connection to the channel front ends within the test head. The housing forms a rounded rectangular enclosure with perimeter fasteners and seams that establish a rigid frame and define airflow paths for thermal management. The positions, geometries, and number of the features shown are exemplary and may be varied to meet routing, thermal, or mechanical requirements.

In some embodiments, interface panel 202 may further incorporate modular connector blocks that allow customized layouts depending on system configuration. These blocks can be designed to carry coaxial, triaxial, differential, or fiber-optic terminations, and may be arranged in swappable sub-panels to adapt the prober 102 for different measurement environments. Indicators on interface panel 202 can include LEDs for power status, clock synchronization, error reporting, and thermal alarms, while optional LCD or touchscreen interfaces may provide direct operator feedback and local configuration.

The docking assembly coupled to probe card interface 302 may additionally be configured with spring-loaded clamps, cam locks, or quick-release latches to permit rapid exchange of probe cards without disturbing the mechanical calibration of prober 102. In certain embodiments, the assembly may incorporate precision dowel pins, keyed slots, or optical fiducials to ensure repeatable alignment across repeated docking cycles. To further maintain signal integrity, the annular structure of the docking assembly can include embedded ground rings or shield collars that provide continuous electrical shielding when probe card interface 302 is engaged.

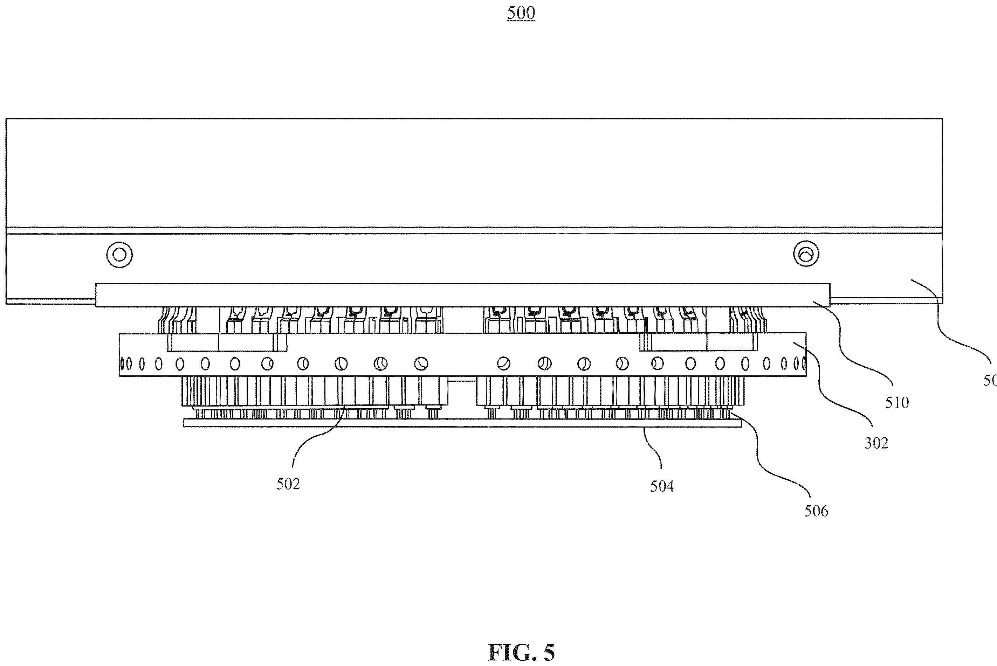

FIG. 5 illustrates a schematic view of a retractable electrical contact interface apparatus 500 in a retracted position according to an embodiment of the present disclosure. Retractable electrical contact interface apparatus 500 may include electrical contact interface assembly 502, electrical connection point 504, spring pins 506, test head housing 508, and retractable electrical contact interface module 510. Electrical connection point 504 may represent a target location for electrical connection, such as an interface of probe card interface 302 or calibration equipment.

Test head housing 508 may mechanically support retractable electrical contact interface, define an opening through which the assembly 502 travels, and provide structural alignment and electromagnetic shielding for the connection to probe card interface 302. Test head housing 508 couples to the test head chassis and presents datum surfaces that set Z-height and planarity relative to the prober. retractable electrical contact interface module 510 mounted to the test head housing 508. Retractable electrical contact module 510 may include a movable electrical contact interface assembly 502 carrying spring pins 506 and may dock to an external electrical connection point 504 on probe card interface 302.

In the retracted state shown in FIG. 5, electrical contact interface assembly 502 may be separated from the electrical connection point 504, so spring pins 506 may not be connected to or pressed by the electrical connection point 504. Assembly 502 may be partially recessed within test head housing 508 so that the leading ends of spring pins 506 may be shrouded and protected from accidental contact, debris, or electrostatic discharge. In contrast to FIG. 5, when electrical contact interface assembly 502 is moved downward to make spring pins 506 contact electrical connection point 504, and therefore establishing an electrical connection.

Accordingly, retractable electrical contact interface apparatus 500 of the present disclosure allows electrical contact interface assembly 502 to extend or retract from electrical connection point 504. This is accomplished by the movement of an actuator lever on the side of multi-channel parallel device testing system 100 which rotates the cylindrical cams to move entire retractable electrical contact interface apparatus 500 into position.

By the design of the retractable electrical contact interface apparatus 500, there may be less chance of damaging spring pins 506 and the wafer prober when docking multi-channel parallel device testing system 100, and may provide more reliable and easier attachment of tester accessories such as calibration equipment.

In addition, test head housing 508 may shield the interface when not engaged to further reduce the risk of pin damage and improving EMI/ESD containment and contamination control during docking and undocking.

In some embodiments, retractable electrical contact interface assembly 502 may be actuated by various mechanisms including motor-driven lead screws, pneumatic cylinders, or cam-based linkages that provide precise and repeatable vertical displacement. The actuation mechanism may further incorporate position sensors, encoders, or limit switches to detect the retracted and engaged states, thereby enabling automated docking sequences under software control. This configuration can reduce operator variability and ensure consistent contact force when spring pins 506 engage electrical connection point 504.

Spring pins 506 may be arranged in customizable patterns to correspond with different electrical connection point geometries. For example, spring pins 506 may be distributed in concentric rings, staggered arrays, or high-density grids depending on the interface requirements of probe card interface 302 or external calibration modules. Each spring pin may include a plunger and barrel assembly formed from conductive alloys such as beryllium copper, plated with gold or palladium for enhanced wear resistance and low contact resistance. Optional compliant bushings or elastomeric supports may also be incorporated to absorb mechanical stress and extend service life under repeated cycling.

Retractable electrical contact interface apparatus 500 may further incorporate environmental sealing or contamination barriers to preserve interface integrity. A retractable dust cover, gasket seals, or positive-pressure airflow may be used to prevent debris from entering test head housing 508 during retraction. In certain embodiments, retractable electrical contact module 510 may include integrated shielding plates or guard rings positioned adjacent to spring pins 506, thereby reducing electromagnetic interference and cross-talk between high-frequency channels.

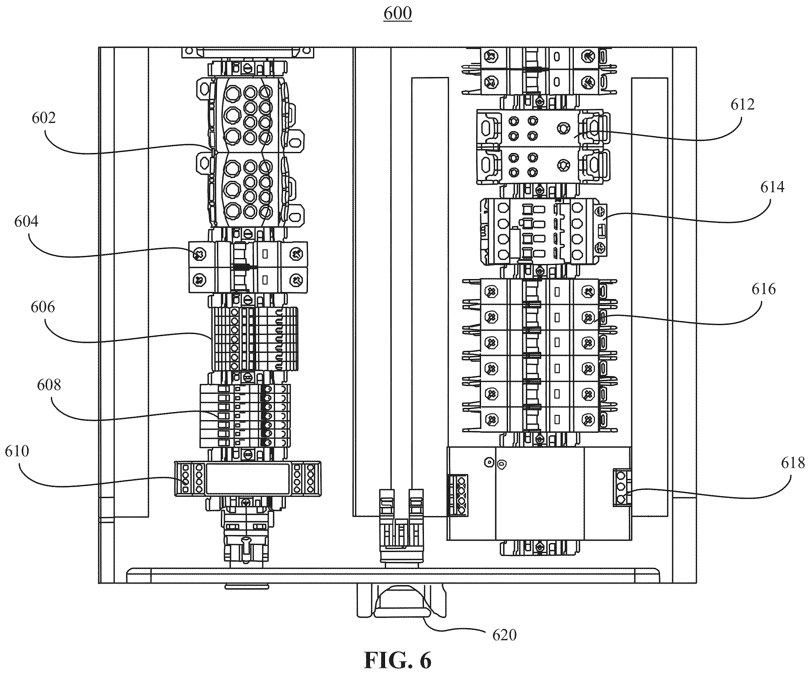

FIG. 6 illustrates a schematic view of a power supply 600 of the top assembly according to an embodiment of the present disclosure. As shown in FIG. 6, power supply 600 may include high-current multi-pin power terminal 602, breaker 604, breaker stack 606, control terminal 608, AC contactor 610, safety relay 612, thermal protection module 614, DC distribution bus 616, DC-DC power module 618, cable entry component 620.

Power supply 600 may provide voltage and current delivery to the resource cards, test elements, and probe interface. Power supply 600 may support various testing requirements, and may incorporate protection circuitry to prevent overvoltage, overcurrent, and overheating, implemented using protective devices such as fuses or breakers, contactors or relays, and thermal sensing. An external emergency shut-off button may be provided to remove power quickly and enhance operational safety. The component positions shown are exemplary and may be varied without departing from the described function.

High-current multi-pin power terminal 602 may distribute controlled power and ground to the test-head backplane and/or the resource cards and may employ keyed and locking features to prevent mis-mating. Breaker 604 may provide first-stage isolation and over-current protection for the AC input and may be tied to an emergency-off (EMO) loop. Breaker stack 606 may supply per-branch protection and, in some embodiments, may incorporate current-sensing elements for load telemetry. Control terminal 608 may accept interlock signals, trigger I/O, fan control, and status lines. AC contactor 610 may close only when host authorization is present and all interlocks are satisfied, thereby serving as the primary connect/disconnect device. Safety relay 612 may aggregate high-voltage and docking interlocks and removes power upon detection of a fault.

Thermal protection module 614 may monitor enclosure or supply temperature and assert alerts upon over-temperature. DC distribution bus 616 may fan out rails, e.g., +48 V, +12 V, +5 V-to the resource slots and may provide per-branch protection and test points. DC-DC power module 618 may convert the AC input or an intermediate bus to the required DC rails and, in some embodiments, supports redundancy, hot-swap, power-factor correction, and EMI filtering. The cable entry component 620 may guide incoming harnesses, provide strain relief, and may furnish a consolidated protective-earth bonding point to enhance electrical safety.

In typical operation, AC power may pass through breaker 604 and AC contactor 610 for isolation and protection, then enter DC-DC power module 618 to generate the required DC rails. These rails may be distributed by the DC distribution bus 616 and may be delivered to the backplane and resource cards via high-current multi-pin power terminal 602. Control and safety signaling may be handled through the control terminal 608, safety relay 612, and thermal protection module 614, ensuring immediate removal of power upon EMO activation or fault detection. The locations and types of the foregoing components may be varied without departing from the function and scope of the power supply 600.

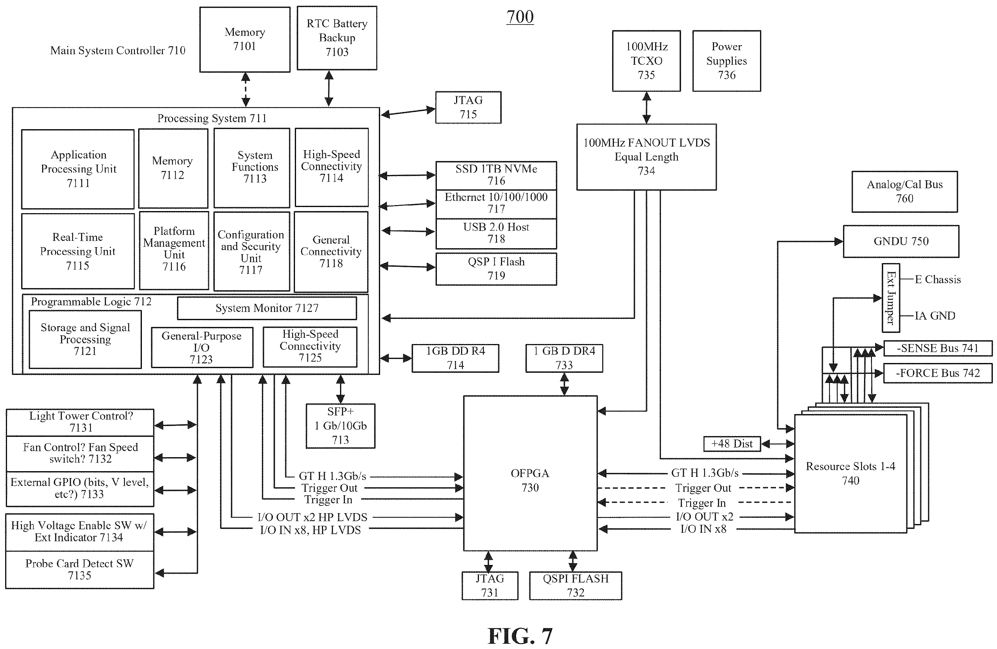

FIG. 7 illustrates a block diagram 700 of multi-channel parallel device testing system 100 in accordance with some embodiments of the present disclosure. A main system controller 710 can coordinate timing, data movement, and system services. Main system controller 710 may include a processing system 711 and programmable logic 712, supervised by a system monitor 7127.

Within processing system 711, application processing unit 7111 may execute high-level test control. Memory 7112 may represent on-chip or attached memory. System functions 7113 may provide timers and peripherals. High-speed connectivity 7114 may expose fast I/O. Real-time processing unit 7115 may service deterministic tasks. Platform management unit 7116 may handle health or telemetry. Configuration and security unit 7117 may manage secure boot or keys. General connectivity 7118 may provide standard serial and general-purpose I/O (GPIO) interfaces. Programmable logic 712 may implement data-plane functions including storage and signal processing 7121, general-purpose I/O 7123, and high-speed connectivity 7125.

Main system controller 710 may interface to external memory and debug. Memory 7101 can be a 4-gigabyte DDR4 memory module with error-correcting code (ECC), and may supply large working memory. Real-Time Clock (RTC) battery backup 7103 may preserve RTC and retention domains. Joint Test Action Group (JTAG) 715 may provide boundary scan and firmware debug.

As shown in FIG. 7, interface 713 can be a high-speed network port that accepts SFP+ modules and supports 1-Gb/s and 10-Gb/s serial links, enabling external Ethernet or other high-bandwidth connectivity for the main system controller 710. Memory device 714 can be connected to the FPGA 730 and/or processing system 711, providing high-bandwidth working storage for waveforms, configuration tables, and buffered measurement data. JTAG port 715 can be a debug interface used to test the main system controller 710 at the board level and to program or debug firmware running on processing system 711 and programmable logic 712. Storage device 716 can be a solid-state drive that offers non-volatile, high-throughput storage for operating system images, test programs, and logged measurement data. Network interface 717 can provide connectivity, allowing the controller 710 to join a LAN for remote control, data upload, or integration with factory networks. Peripheral interface 718 can allows attachment of external peripherals, such as removable flash drives, keyboards, or service tools, to the processing system 711. Memory 719 can provide means for storing boot images and configuration data for the processing system 711 and/or FPGA 730, enabling non-volatile firmware storage and in-system updates. Clock-distribution network 734 can provide a clock-distribution block that receives a reference from TCXO 735 and fans out matched-length LVDS clock signals to the FPGA 730 and other timing-sensitive components, providing low-skew, low-jitter synchronization across the system.

Output/Front-End Field Programmable Gate Array (OFPGA) 730 may perform channel timing, capture, and distribution. It can have local JTAG 731 for debug, Quad Serial Peripheral Interface (QSPI) flash 732 for bitstream storage, and local memory 733 (e.g., 1-GB DDR4) for buffering vectors and results. A precision Temperature-Compensated Crystal Oscillator (TCXO) 735 feeds Low-Voltage Differential Signaling (LVDS) 734 with equal-length fan-out that distributes a phase-aligned reference to the controller and to the OFPGA (and onward to resources). System power supplies 736 energize these subsystems.

Resources may reside in Resource Slots 1-4 740. Each slot can receive distributions and clock/trigger lines, and connects to shared analog busses: a SENSE Bus 741 and a FORCE Bus 742 for Kelvin routing. A grounding subsystem includes GNDU 750 (ground/force unit) and selectable references, and an Analog/Cal Bus 760 used to inject calibration stimuli and route analog references across slots. The OFPGA 730 fans out high-speed serial links (e.g., GT ~1.3 Gb/s), trigger out/in, and digital I/O OUT ×2 / I/O IN ×8 to the resource slots 740 to support synchronized stimulus and measurement.

In some embodiments, main system controller 710 may further include redundant power domain management and supervisory circuits, such as voltage supervisors, detectors, and over-current protection. Processing system 711 and programmable logic 712 may be connected via a high-bandwidth internal bus to enable configuration, data movement, and control hand-off. Additionally, the system monitor 7127 may oversee temperature sensors, fan control, and thermal alarms located on resource slots, OFPGA 730, and analog/digital front-end modules. The controller may also establish secure communications to external equipment via Ethernet with supported protocols such as TCP/IP, possibly over fiber optics, and may implement TLS or other encryption for data in transit.

OFPGA 730 may receive the common system reference clock (e.g. 100-MHz TCXO 735) and distribute phase-aligned clock and trigger signals both to resource slots 740 and to front-end measurement modules. For example, OFPGA 730 may drive LVDS lines, matched in trace length, to each resource slot to ensure synchronization.

Within resource slots 1-4 (e.g., 740), each slot may include several parametric channels that share analog common buses (sense bus 741, force bus 742), for measurements. Each channel may also have local digital-to-analog or analog-to-digital conversion, and may communicate with OFPGA 730 via dedicated high-speed lines. The Analog/Cal Bus 760 may allow calibration references (voltage, current) to be injected into analog front ends of each resource slot; these references may be provided by precision Digital Analog Converters (DACs) or by external calibration sources. Grounding via ground unit 750 ensures consistent common reference among slots and may allow selection between internal chassis ground, isolated analog ground, or external ground via jumper or connector.

Optional configurations might include additional resource slots beyond four, linked by expansion connectors for large channel counts, or hierarchical OFPGAs for multi-tier synchronization. There may be selectable filter networks in line with force or sense paths for noise suppression, e.g. RC or LC filters, perhaps switchable depending on test requirements. Also, the system could include programmable attenuation or scaling blocks in force lines to support both high current (for legacy or power devices) and low current (for leakage or modern scaled devices) within the same slot.

Collectively, the elements numbered 710-736 provide secure compute, storage, timing, and power for the digital backplane; elements 740-742, 750, 760 implement the resource-side analog/digital distribution and grounding needed for phase-coherent, parallel parametric testing.

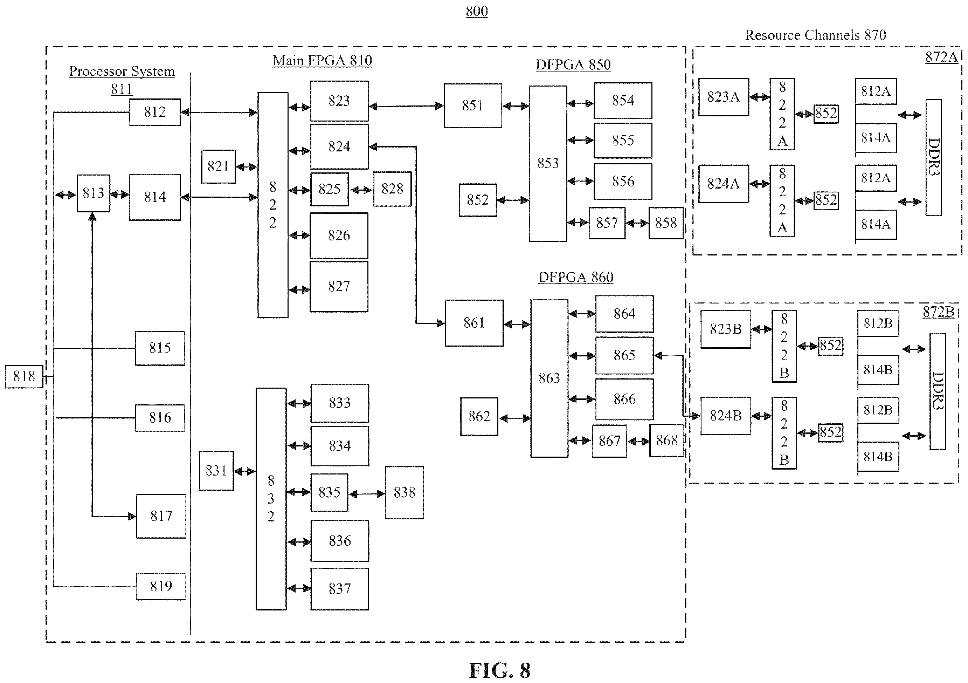

FIG. 8 illustrates a hub architecture and communication 800 according to an embodiment of the present disclosure. As shown in FIG. 8, an exemplary configuration of the present disclosure provides a multi-FPGA hierarchical architecture including a Main FPGA 810, dedicated FPGA (Distributed Field Programmable Gate Array (DFPGA) 850 and DFPGA 860), and a plurality of Resource Channels 870 (shown as Resource Channels 872A and 872B). Through this three-tier structure, large-scale parallel computation and multi-channel data processing may be achieved.

As shown in FIG. 8, Main FPGA 810 can interface with Processor System 811 via ports 812, 815, 816, and 817, each of which may be implemented with Advanced eXtensible Interface (AXI) High Performance interfaces enabling data flow between the programmable logic and processor 813, and peripheral/control logic 814.

External memory module 818 can serve as a buffer for high-capacity storage. Within Main FPGA 810, AXI Interconnect 822 and AXI Interconnect 831 distribute AXI transactions among masters-including processing core 813 and Direct Memory Access (DMA) logic 821- and slaves including DDR4 memory module 828 and multiple Chip2Chip blocks 823, 824, 825, 826, 827, 833, 834, 835, 836, and 837. Blocks 851 and 861 represent Chip2Chip & Aurora link endpoints connecting Main FPGA 810 to DFPGA 850 and DFPGA 860 respectively, thereby enabling high-speed serialized link communication.

Moreover, Resource Channels 870 can include first Resource Channel 872A and second resource channel 872B and each include components analogous to those in Main FPGA 810 and the DFPGAs 850 and 860. For example, Resource Channels may use of AXI-HP interfaces denoted 812A and 812B, control logic denoted 814A and 814B, local DMA logic 852, and local DDR3 memory modules present on each resource channel board. Resource Channels 870 may communicate upstream via Chip2Chip blocks 823-837 in Main FPGA 810 / DFPGAs 850 and 860, enabling scalable fan-out of channel count with local buffering, local control logic, and stimulus/measurement path capability in each resource module.

Main FPGA 810 can also include Processor System 811 and programmable logic fabric. Processor System 811 can include processing core 813 and peripheral/control logic 814. The ports 812, 815, 816, and 817 (AXI-HP0 through AXI-HP3) exchange data with external DDR4 memory 818; DMA logic 821 handles high-volume transfers between processor system 811 and the programmable logic. AXI Interconnects 822 and 831 serve to route transactions among the masters and slaves within Main FPGA 810, maintaining coherency and facilitating distributed communication among Chip2Chip blocks, resource channel interfaces, and memory 828.

Main FPGA 810 can communicate with DFPGAs 850 and 860 via a compact device-to-device interface (e.g., Chip2Chip & Aurora IP) for high-speed data transfer.

DFPGA 850 and DFPGA 860 can serve as intermediate aggregation and distribution nodes. Each DFPGA can include local memory and other processing or buffering logic. DFPGAs 850 receive stimulus/control paths from Main FPGA 810 (via blocks such as 851, 861, 823-827) and fan out data and control to Resource Channels 872A / 872B, for example, through their respective endpoints.

One embodiment of the present disclosure achieves (i) centralized stimulus and control distribution through Main FPGA 810, (ii) parallel buffering, relay, aggregation, and data fan-out via DFPGAs 850 and 860; and (iii) large-scale expansion of Resource Channels 872A / 872B for high channel-count measurement. By integrating endpoints (blocks 823-837, 851, 861) with AXI interconnect architecture (ports 812 / 812A / 812B, interconnects 822 / 831), local DMA logic (821, 852), and buffer memories (DDR4 818 / 828, DDR3 modules in Resource Channels), the system provides high throughput, scalable, low-latency multi-channel test capabilities.

In some embodiments, the Resource Channels 870 may include optional local buffering (e.g., DDR3 or DDR4) to accommodate bursts of measurement data, so that the downstream DFPGAs 850 and 860 or Main FPGA 810 need not keep up continuously in real time. This buffering helps because measurement data (especially for waveforms, transient responses, capacitance sweeps, etc.) can come in bursty fashion. Also, the architecture may allow for local processing (filtering, averaging, correlation) inside resource channels to reduce data volume passed upstream.

As further shown in FIG. 8, processor system 811 can communicate with programmable logic resources in main FPGA 810 through additional high-performance ports, including AXI-HP2 master interface 817. Interface 817 may be implemented as a PS-PL AXI High Performance master that permits burst data movement between the processor's memory subsystem and logic downstream of interconnects 822A and 822B. In some implementations, interface 817 (together with interfaces 812, 815, and 816) streams waveform data, per-die results, and trigger metadata to and from external memory 819. Memory 819 can be realized as a double-data-rate (DDR) memory device, such as DDR3 or DDR4, and can provide additional storage for test programs, operating system images, and high-capacity data buffers used by the processor system 811 during multi-channel test operation.

Within the programmable-logic portion of main FPGA 810, interconnects 822A and 822B (collectively similar to interconnect 822 previously discussed) may be AXI fabric blocks that arbitrate and route AXI transactions between various masters (for example, DMA logic 821 or the PS-side ports) and slaves including local memories 825 and 838 and multiple memory-transfer cores 823A, 823B, 824, 826, 827, 833, 834, 836, and 837. Each memory-transfer core (e.g., cores 823A and 823B in the upper branch and cores 833 and 834 in the lower branch) can be implemented with Chip2Chip, Aurora, or similar serialized-link IP that packetizes AXI traffic for transmission over high-speed transceiver links to DFPGA devices 850, 860 or to downstream resource channels 872A, 872B. Memory-transfer core 824 may, for instance, terminate an AXI region on interconnect 822A and forward transactions to a corresponding endpoint 824A in DFPGA 850, while cores 826 and 827 provide additional links for other subsets of channels. Local memories 825 and 838 can be implemented as DDR-type memories (e.g., discrete DDR3/DDR4 devices or on-chip DDR controllers) that buffer test vectors, captured waveform data, and intermediate per-channel results so that bulk transfers to processor system 811 or DFPGAs can be scheduled independently of instantaneous acquisition timing.

In DFPGA 850, interconnect 853 may serve as an internal AXI-style switching fabric that receives incoming AXI streams from memory-transfer cores such as 851, 852, 823A, and 824A and redistributes them to local logic and buffers. Memory-transfer cores 854, 855, and 856 can act as bridge or endpoint IP similar to cores 823A, 824, 826, and 827 in main FPGA 810, but instantiated within DFPGA 850 to fan out control and data toward individual resource channels in group 872A or to auxiliary processing blocks. For example, core 854 may drive a subset of resource boards dedicated to parametric measurement, while cores 855 and 856 service additional channel groups or specialized resources. Memories 857 and 858 can be implemented as local DDR memories connected to interconnect 853 and provide buffering for bursty stimulus and measurement traffic associated with the channels handled by DFPGA 850. By staging data in memories 857 and 858, the system can decouple high-rate channel I/O from the aggregate bandwidth of the uplinks back to main FPGA 810.

DFPGA 860 can include a similar arrangement. Memory-transfer core 862 may function analogously to core 852 on the upper branch, terminating a Chip2Chip or Aurora link from main FPGA 810 and presenting an AXI interface to interconnect 863. Interconnect 863 can provide the same role as interconnect 853, routing AXI transactions among memory-transfer cores 864, 865, and 866 and local memories 867 and 868. Cores 864-866 may again be implemented as Chip2Chip-type memory-transfer cores that distribute commands and data to additional resource channels 872B or to on-board processing and aggregation logic. Memories 867 and 868, which can also be DDR-type devices, store channel-specific measurement data, waveform segments, or control tables associated with the resources attached to DFPGA 860. This replicated structure of interconnect 863, memory-transfer cores 864-866, and buffer memories 867-868 allows the lower DFPGA 860 to act as an independent aggregation and distribution node, mirroring the behavior of DFPGA 850 and enabling scalable expansion of channel count while maintaining high effective throughput between the resource channels and processor system 811.

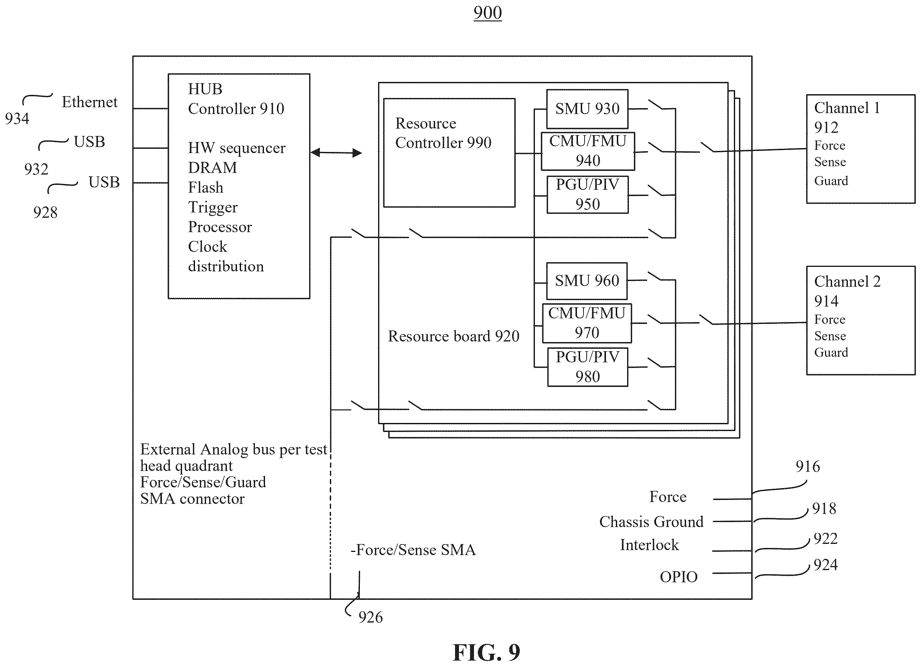

FIG. 9 illustrates a hub controller 900 of multi-channel parallel device testing system 100 according to an embodiment of the present disclosure.

HUB controller 910 may communicate with a host computer via Ethernet and Universal Serial Bus (USB) interfaces, and provides system-level triggering and clock distribution to synchronize downstream measurement modules. The system further may include an external analog bus and Force/Sense/Guard SMA connectors for precision electrical connections to a DUT. HUB controller may communicate via ethernet port 934, first USB port 932, and/or second USB port 928.

HUB controller 910 may include, but is not limited to, a hardware sequencer, Dynamic Random-Access Memory (DRAM) for temporary data storage, flash memory for firmware and test programs, a trigger processor for generating or receiving trigger signals and dispatching them to resource boards 920, and a clock distribution network to provide synchronized clocks to each board. HUB controller 910 communicates bidirectionally with each resource controller 990, as shown by the double arrow in FIG. 9. In some embodiments, hub controller 910 may be implemented as a backplane controller, a processing system, a sequencer, a routing device, and/or a programmable control module that integrates one or more of: an embedded controllers, microcontroller, DSP, FPGA, and/or generally configurable to schedule and coordinate measurement sequences, aligning triggers and clocks across boards, and/or a configuration and discovery manager for enumerating resource boards and performing calibrations, for logging/telemetry subsystem for collecting status, errors, and measurement.

Each resource board 920 may include a resource controller 990 equipped with a hardware sequencer, DRAM, and flash for managing local timing and parameter configurations. Resource board 920 is further provided with multiple measurement and excitation modules, such as SMUs 930, 960 that can supply precise voltage or current and perform corresponding measurements while supporting Kelvin four-wire connections to minimize lead resistance. Resource board 920 also may include CMU/FMU 940, 970 for impedance, capacitance, or frequency-related measurements, and pulse generator units/parametric I-V units (PGU/PIV) 950, 980 for generating pulsed signals and performing parametric current-voltage measurements.

HUB controller 910 also may include status and monitoring outputs including lines 916, 918, 922, and 924. Line 916 ("Force") can carry the force command or the force bias to the force pins of the channels (e.g., to control source currents or voltages). Line 918 ("Chassis Ground") can provide reference ground potential tied to the chassis enclosure of the test head to ensure proper grounding and safety. Line 922 ("Interlock OK") can be set as a safety/status signal indicating that interlocks (mechanical or electrical) are in a proper state before enabling high-voltage or high-current operations. Line 924 ("OPIO") may be used for optional parallel I/O or operational I/O line used for auxiliary signaling, control or multiplexed signals to/from external instrumentation or calibration devices.

The external analog bus per test-head quadrant is accessed via SMA (SubMiniature version A) connectors, such as connector 926, which carry multiple lines per channel including Force, Sense, and Guard. These force/sense/guard SMA connectors can be configured with precision coaxial interfaces intended to maintain low parasitic and low noise paths. Guard lines help shield sense or ground lines from leakage or noise by surrounding force or sense conductors with driven or guarded potentials.

Resource board 920 is shown with multiple channel-specific modules: for example, SMU 930, 960 units that act as source measure units to both inject stimulus (voltage or current) and measure response, CMU/FMU modules 940, 970 for capacitance or frequency measurements or front-end filtering / frequency measurement, and PGU/PIV units 950, 980 that are pulse generator units or parametric I-V units, used for pulsed stimulus (such as for memory cell programming) or performing dynamic I-V sweeps. Channels such as Channel 1 (912) and Channel 2 (914) each include force, sense, and guard connections configured via the modules on the board.

Resource controller 990 can coordinate among the modules on resource board 920, managing local sequencing, configuration settings (e.g., compliance, range, measurement mode), and local timing. It may act on instructions from HUB controller 910 to gate stimuli, route measurement data, and regulate modules (SMU, CMU/FMU, PGU/PIV). The resource controller may also provide feedback via line 922 to ensure each module is safely connected and operational before stimulus is applied.

Test-head housing defines physical partitioning between HUB controller 910, resource board 920, and the external connectors. Housing may include mounting for SMU, CMU/FMU and PGU/PIV modules, cabling harnesses from these modules to the external analog bus, and mechanical support for channels (912, 914). The entire assembly is arranged so that force/sense/guard paths are tightly controlled, shields or grounds are maintained, and signal integrity (low leakage, low capacitance parasitics) is preserved.

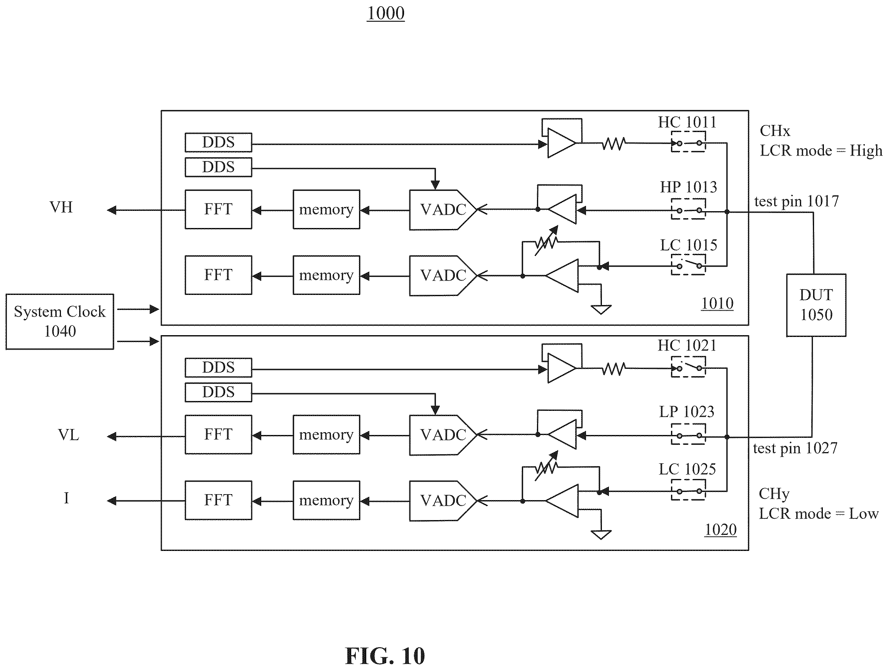

FIG. 10 illustrates a schematic circuit 1000 of test channels 1010, 1020 in multi-channel parallel device testing system 100 according to an embodiment of the present disclosure. In some embodiments, circuit 1000 may implement one or more of the elements in resource board 920. For example, circuit 1000 may implement one or more of the SMU, CMU, FMU, and/or PGU.

Multi-channel parallel device testing system 100 may include a plurality of test channels 1010, 1020. Each of test channels 1010, 1020 may include a high current (HC) switch, a low current (LC) switch, a potential node, a channel clock (e.g., a per-test channel clock), and a system clock. As shown in FIG. 10, test channel 1010 may include HC switch 1011, potential node 1013, and LC switch 1015, and test channel 1020 may include HC switch 1021, potential node 1023, and LC switch 1025. Each of the channel clocks may be configured with a phase offset. The phase offset compensates a phase shift associated with each of the test channels 1010, 1020 during calibration.

Potential node 1013 may be configured for high potential (HP) testing when HC switch 1011 is closed, and may be configured for low potential (LP) testing when LC switch 1021 is closed. In other words, test channel 1010, 1020 of the present disclosure may have only one potential node which happens to be high potential when HC switch 1011 is closed and LC switch 1015 is opened, and happens to be low potential when HC switch 1011 is opened and LC switch 1015 is closed. Therefore, each test channel 1010, 1020 may be a high channel or a low channel. Further, HC switch 1011 and LC switch 1015 can be configured as alternately operable, such that when one is in a closed state the other is maintained in an open state.

In multi-channel parallel device testing system 100, test channels can operate under the same clock to ensure proper synchronization. When a common clock is distributed to each test channel 1010, 1020, the measurement data across test channels 1010, 1020 may share a uniform time reference that allows the results to be aligned and compared accurately. For example, impedance or capacitance measurements rely on precise phase relationships between voltage and current signals. If test channels 1010, 1020 do not share the same clock, phase offsets will occur, which may directly introduce errors into the computed impedance, capacitance, or inductance values.

If different test channels 1010, 1020 operate on different clocks, several problems may arise. First, the measurement data from each test channel 1010, 1020 may not correspond to the same instant in time, and may make the results incomparable across channels. Second, algorithms that require simultaneous multi-channel data. For example, pin-to-pin impedance calculations or multi-source excitations may fail because the inputs are misaligned. Third, the presence of multiple unsynchronized clocks may generate jitter, beat frequencies, or noise coupling between channels, thereby degrading resolution and repeatability.

Accordingly, the present disclosure employs a centralized clock distribution system such that test channels 1010, 1020 share the same reference clock which ensures phase coherence, synchronized triggering, and reliable high-accuracy parallel measurements.

In some embodiments, each test channel 1010, 1020 may have a channel clock. The channel clock in test channels 1010, 1020 has a frequency and a phase. However, in order to measure multiple DUTs 1030 in multi-channel parallel device testing system 100, the channel clocks needs to be the same. Therefore, system clock 1040 may be coupled to test channels 1010, 1020, and may distribute system clock to test channels 1010, 1020 for synchronizing the clock channels. As a result, the channel clock in each of test channels 1010, 1020 can have a frequency and a phase synchronized to system clock.

In some embodiments, each of test channels 1010, 1020 may further include a force line and a sense line. The force line may be connected to potential node 1013, 1023 via HC switch 1011 or LC switch 1025. The force line may provide a signal to DUT 1050. The sense line may be connected to potential node 1013, 1023. The sense line may detect a voltage at the DUT.

Test channels 1010 and 1020 can each be arranged with multiple DDS blocks and FFT + memory + Voltage/Analog-to-Digital Converter (VADC) front ends. In channel 1010, two DDS blocks feed into circuitry that drives the high current (HC) path when HC switch 1011 is closed; similarly, in channel 1020, the DDS blocks feed into its HC path via HC switch 1021. However, this is only a potential implementation and other implementations are possible. Further, the DDS blocks can generate periodic test waveforms under control of the system or channel clock, which may be fed into either the high-voltage amplifier path (HP) 1013 / 1023 or through HC / LC as configured. FFT + memory units in each channel serve to capture time-domain or frequency-domain data: signals from VADC blocks are stored in memory, and processed via FFT engines to extract spectral content or phase information.

The VADC blocks in test channels 1010, 1020 can convert analog signals (coming from the potential node 1013 / 1023 or from sense lines) to digital form. The outputs of the VADC are routed both to memory for buffering, and to the FFT engines for analysis. The outputs of the DDS blocks are also routed toward the amplifiers that feed the test pin 1017 / 1027 through the HC, HP, or LC switches. The signal path may include amplifiers or gain stages (shown between DDS and HC / HP / LC switches) to set appropriate level for force or measurement. Resistive elements (e.g. shown as small variable resistor in test channel 1010 in the HP or LC path) may be used to limit or adjust current or to implement compliance control.

Switches for HC 1011 / 1021, HP 1013 / 1023, and LC 1015 / 1025 can allow selection among different modes: when HC switch is closed and LC switch is open, the potential node (1013 / 1023) is in a high potential mode; when LC is closed and HC open, low potential mode; HP switch may represent high precision or high potential mode with different gain or compliance characteristics. These switches allow a single potential node per channel to be flexibly reconfigured between high and low potential testing modes. Test pins 1017 (for channel 1010) and 1027 (for channel 1020) are the actual electrical nodes that contact the DUT 1050, carrying force, sense and guard connections (guard possibly optionally grounded or driven) depending on measurement requirements.

System clock 1040 can be configured to drive timing in the two test channels 1010, 1020. Each channel has its own channel clock derived from system clock 1040, with configurable phase offset for calibration. The synchronization ensures that when measurements are made across both channels (for example, simultaneous impedance, capacitance, or dual-channel stimulus), data align in time and phase. Without a common reference (system clock), measurements involving phase (like impedance or reactive components) would become uncertain.

DUT 1050 can be connected to both test pins 1017 (of channel 1010) and 1027 (of channel 1020) for force / sense / guard paths. The sense line from DUT 1050 may return voltage to the sense inputs of the respective channels (via sense path through switches and VADC), and the guard line may surround or shield force/sense to reduce leakage or noise. Force line drives stimulus (voltage or current) via the switches and amplifiers. The LC / HP / HC paths carry different current or voltage ranges: LC for very low current / low potential measurements (e.g. leakage), HP for higher precision or high potential mode, HC for high current mode when needed.

As shown in FIG. 10, a system may include a plurality of test channels (e.g., 1010, 1020). The test channels 1010, 1020 may include a high current (HC) switch 1011, 1021, a low current (LC) switch 1015, 1025, and a potential node 1013, 1023 coupled to corresponding test pins 1017, 1027. Each test channel 1010, 1020 may also be associated with a channel clock that derives timing from system clock 1040. Potential node 1013 may be configured for high potential (HP) testing when HC switch 1011 is closed, and potential node 1023 may be configured for low potential (LP) testing when LC switch 1025 is closed. System clock 1040 distributes a common time reference so that channel clocks of test channels 1010, 1020 are synchronized in frequency and phase.

In some embodiments, each test channel 1010, 1020 may further include a force line and a sense line. For example, the force line may be coupled to potential node 1013 through HC switch 1011 or LC switch 1015, and may deliver a signal from test channel 1010 to DUT 1050. The sense line may be connected directly to potential node 1013 and may detect a voltage developed at DUT 1050. Similarly, test channel 1020 may route its force line through HC switch 1021 or LC switch 1025, while its sense line monitors DUT 1050 via potential node 1023.

In one embodiment, the plurality of test channels 1010, 1020 may be part of a larger array of channels in system 100. A first, second, and third test channel may be configured with potential nodes 1013 set to a first dynamic potential by coordinating their respective HC and LC switch states, while a fourth test channel may be configured with potential node 1023 set to a different dynamic potential. Using this arrangement, multi-channel parallel device testing system 100 may perform capacitance-voltage analysis by sweeping the first dynamic potential across multiple channels and comparing capacitance as a function of the second dynamic potential provided by another channel.

As illustrated in FIG. 10, each of test channels 1010, 1020 may include direct digital synthesizer (DDS) circuits. The DDS blocks may generate periodic test signals whose frequency and phase are synchronized to system clock 1040. For example, DDS outputs in test channel 1010 may be routed toward amplifiers and then applied through HC switch 1011 or LC switch 1015 to potential node 1013. Similarly, test channel 1020 may apply its DDS output to potential node 1023 through HC switch 1021 or LC switch 1025. By synchronizing all DDS circuits to system clock 1040, test channels 1010, 1020 may measure DUT 1050 simultaneously with timing coherence derived from system clock 1040.

Each of test channels 1010, 1020 may further include memory, first and second Voltage/Analog-to-Digital Converters (VADC), and first and second DDS circuits. As shown in FIG. 10, outputs from potential nodes 1013, 1023 may be digitized by corresponding VADC blocks, whose outputs are stored in memory. The first DDS may drive potential node 1013 or 1023, while a second DDS may be coupled to one or more of the VADC circuits to provide sampling or reference signals. In this way, each channel 1010, 1020 may include both generation and measurement resources.

Moreover each channel clock of test channels 1010, 1020 may include a programmable phase offset. During calibration, a processor may measure the relative phase shift introduced by each of test channels 1010, 1020 when driven by system clock 1040 and may store an offset value in the corresponding channel clock. The stored phase offset compensates mismatches so that channels 1010, 1020 maintain phase coherence when performing parallel testing of DUT 1050.

In some embodiments, each of test channels 1010, 1020 may also include Fast Fourier Transform (FFT) engines connected to the VADC outputs and memory. For example, FFT blocks may process digitized data from potential node 1013 in channel 1010 or potential node 1023 in channel 1020. The FFT circuits may transform the time-domain VADC output into frequency-domain results, enabling precise measurement of amplitude and phase characteristics at DUT 1050.

At least one of the DDS circuits in each of test channels 1010, 1020 may be configured to generate a test signal for DUT 1050. For example, DDS blocks in test channel 1010 may produce a sinusoidal excitation signal that is driven through HC switch 1011 into potential node 1013, while DDS blocks in test channel 1020 may provide either a synchronous reference signal or an independent excitation waveform for DUT 1050.

Multi-channel parallel device testing system 100 may include eight or more test channels, such as channels 1010 and 1020. Each of the channels may be configurable with a phase and amplitude setting. By synchronizing amplitude and phase across all channels with system clock 1040, system 100 may perform high-density parallel measurements with phase coherence among at least eight channels applied to a DUT array.

In some embodiments, system 100 may include a processor coupled to system clock 1040. Each of test channels 1010, 1020 may include a DDS. The processor may cause system clock 1040 to deliver a calibration signal to test channels 1010, 1020. By comparing responses of DDS-generated signals with the calibration signal, the processor may measure a phase shift for each test channel and program correction values into phase shift registers of the DDS circuits.

In one example, each DDS circuit in test channels 1010, 1020 may implement a numerically controlled oscillator (NCO) driven by system clock 1040. A programmable phase offset may be applied to the NCO to compensate for measured channel-specific delays. As a result, DDS signals applied through HC switch 1011 or LC switch 1015 into potential node 1013 remain in-phase with those applied through HC switch 1021 or LC switch 1025 into potential node 1023. Accordingly, the DDS circuits of test channels 1010, 1020 may be configured to generate test signals that are phase-aligned with system clock 1040. The alignment ensures that measurements across channels 1010, 1020 remain synchronized, enabling simultaneous multi-channel measurement of DUT 1050.

As illustrated in FIG. 10, in some embodiments, each of test channels 1010, 1020 may include both a high potential (HP) circuit and a low potential (LP) circuit. For example, test channel 1010 may route signals through potential node 1013 and HC switch 1011 for HP mode, or through potential node 1013 and LC switch 1015 for LP mode. By reconfiguring HC and LC switches, the test channel can alternate between HP and LP operation depending on test requirements.

In some embodiments, system 100 may include a processor coupled to test channels 1010, 1020. The processor may multiplex a reference signal into both HP and LP circuits by driving through system clock 1040. Synchronization with a trigger signal may align phase across channels 1010, 1020. The processor may then calibrate amplitude and phase of both HP and LP circuits, generate an internally produced second signal to route to the HP circuit, and calibrate based on comparing results between the first and second signals.

The first signal may be a sine wave provided by system clock 1040, and the second signal may be generated by a DDS within test channels 1010, 1020. The processor may measure a phase difference between HP and LP circuits, such as between a potential node in HP mode and potential node in LP mode, and calibrate the LP circuit accordingly.

In some embodiments, calibration results may be stored in memories of test channels 1010, 1020. Correction values may include amplitude gain or phase shift adjustments relative to the first calibration signal. Stored correction values may then be applied during runtime to ensure accurate measurement at DUT 1050.

Disclosed systems may also support a parallel testing mode. For example, processor and system clock 1040 may configure test channels 1010, 1020 and additional channels to operate as high channels, low channels, or measurement channels, depending on the state of HC and LC switches. Each channel may include a DDS that may generate test signals with unique frequency or phase. By synchronizing to system clock 1040, test channels may simultaneously measure multiple pins of DUT 1050.

In some embodiments, each test channel such as 1010, 1020 may include a local processor or controller configured to execute FFT operations on digitized data from its VADC. Channel outputs may be isolated in frequency space by assigning distinct frequency offsets to DDS waveforms, allowing FFT bins to isolate per-channel measurements even during simultaneous excitation of DUT 1050.

Each DDS in test channels 1010, 1020 may include a programmable phase shift register. The register may store a calibration offset unique to its corresponding channel. By applying the stored offset, DDS waveforms across channels are aligned in phase, ensuring synchronous measurement across DUT 1050.

In some embodiments, each test channel 1010, 1020 may include a channel processing circuit, HC switch (1011, 1021), LC switch (1015, 1025), at least one potential node, and DDS. Each channel may be configurable to act as a high channel, low channel, or measurement channel. DDS blocks may be configured to generate test signals at unique frequencies or phases, calibrated to system clock 1040. Channel processing circuits, which may include VADC, FFT, and memory, may perform operations such as converting analog to digital signals, transforming time-domain signals to frequency domain, or transmitting digital measurement data to a processor for analysis.

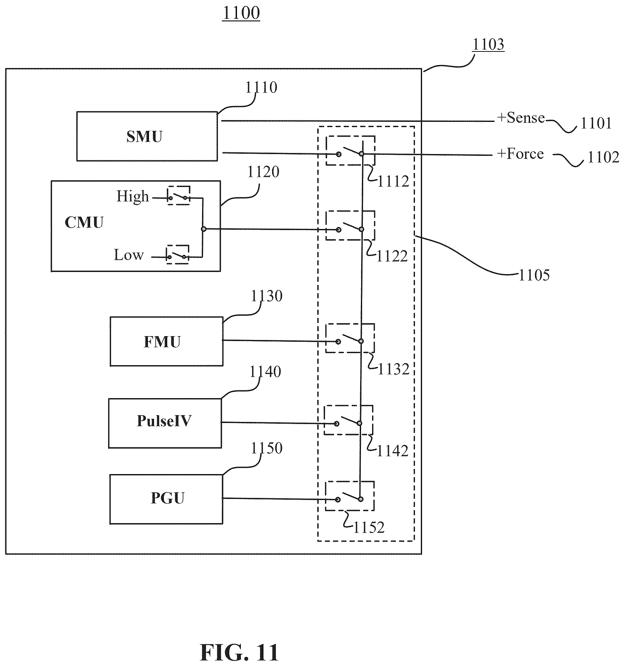

Reference is made to FIG. 11, which illustrates a block diagram for an adaptable testing channel 1100 according to an embodiment of the present disclosure. Channel 1100 interfaces to a device under test (DUT) through a +Sense conductor or line 1101 and a +Force conductor or line 1102 that terminate at a pin interface 1103. As shown in FIG. 11, in channel 1100 a mode switch 1105 couples a plurality of instrument paths to a potential node internal to the assembly. The potential node in turn drives the +Force conductor or line 1102 (and, in some embodiments, a companion sense sub-network in mode switch 1105 routes the associated sense lead to +Sense conductor or line 1101 to maintain a Kelvin connection to the DUT).

Channel 1100 may include multiple instrument blocks: a source measure unit (SMU) 1110, a capacitance measurement unit (CMU) 1120, a frequency measurement unit (FMU) 1130, a PulseIV unit 1140, and a pulse generator unit (PGU) 1150. In various embodiments, SMU 1110, CMU 1120, FMU 1130, and PGU 1150 can collectively be configured to provide a measuring resource. Moreover, PulseIV 1140 can be configured to provide a pulse resource. For example, the measuring resource can have a high-current (HC) switch and a low-current (LC) switch to select operating range and thereby establish high-potential (HP) or low-potential (LP) measurement modes at the potential node. In the example shown, CMU 1120 depicts selectable "High" and "Low" paths that can implement the HC and LC switching; in other embodiments, the HC/LC selection may be distributed across the SMU, FMU, PGU, or a shared front-end of the measuring resource.

Mode switch 1105 can be implemented as a multi-component selection network rather than a single device. As illustrated, mode switch 1105 can include independently controllable sub-switches 1112, 1122, 1132, 1142, and 1152 disposed, respectively, in the SMU, CMU, FMU, PulseIV, and PGU paths. The sub-switches can be relays, solid-state analog switches, a cross-point fabric, or combinations thereof, and may be ganged or interlocked to enforce mutually exclusive selections. The sub-switch outputs converge at the potential node of mode switch 1105. In some embodiments, mode switch 1105 further may include break-before-make timing, bleed/clamp elements, or charge-management networks to minimize transients during instrument handoffs.

In some implementations, when mode switch 1105 connects PulseIV 1140 (the pulse resource) to the potential node, the potential node is configured for pulse testing the DUT via +Force line 1102 while +Sense line 1101 monitors the pin potential. When mode switch 1105 connects the measuring resource to the potential node with the HC switch closed, the potential node is configured for HP testing; when the LC switch is closed, the potential node is configured for LP testing. Thus, the mode switch determines whether the channel performs pulse generation or measurement, and the HC/LC selection within the measuring resource determines the potential range of that measurement.

Channel 1100 can represent one of a plurality of test channels that are coupled to a system clock. The system clock provides timing used to synchronize pulse testing (delivery and measurement) events across channels. A controller or processor can assert timing and configuration strobes to the sub-switches of mode switch 1105 and to the HC/LC selection of the measuring resource to implement disclosed operations, including rapid, deterministic reconfiguration between pulse measurement, HP measurement, and LP measurement at the potential node while preserving Kelvin sensing and isolation of inactive resources.

In some embodiments, SMU 1110, CMU 1120, FMU 1130, and PGU 1150 collectively form a measuring resource selectable to the DUT, and PulseIV 1140 provides a pulse resource that delivers pulsed excitation to the DUT. By way of example, an SMU can force and measure voltage and/or current for DC/parametric tests, a CMU can stimulate a DUT with an AC bias to resolve capacitance/impedance for C-V characterization, and an FMU can acquire frequency-domain quantities referenced to a timing standard; a PGU can provide precisely timed stimulus that the measuring resource uses in time- or frequency-domain measurements.

In some implementations, mode switch 1105 operates as a multi-component selection network rather than a single device. As depicted, mode switch 1105 can include a set of independently controllable sub-switches-e.g., sub-switch 1112 in line with the SMU path, sub-switch 1122 in line with the CMU path, sub-switch 1132 in line with the FMU path, sub-switch 1142 in line with the PulseIV path, and sub-switch 1152 in line with the PGU path. The outputs of the sub-switches converge to a potential node at the interior of mode switch 1105 that feeds the +Force conductor 1102; in some embodiments, a companion sense-side sub-network within mode switch 1105 also routes the selected instrument's sense lead to +Sense line 1101 to maintain connections during measurement.

As shown in FIG. 11, CMU 1120 can internally present "High" and "Low" paths (shown schematically) corresponding to high-range and low-range operating conditions; these paths may embody the high-current (HC) and low-current (LC) switching described elsewhere, enabling the system to configure the potential node for high-potential (HP) or low-potential (LP) testing when the mode switch 1105 connects the measuring resource to the node. When mode switch 1105 connects PulseIV 1140 to the potential node, the channel delivers pulsed waveforms suitable for minimizing self-heating or capturing transient device behavior; examples of pulsed-IV techniques and pulse-generator modules usable in such embodiments are well known in semiconductor parametric testing.

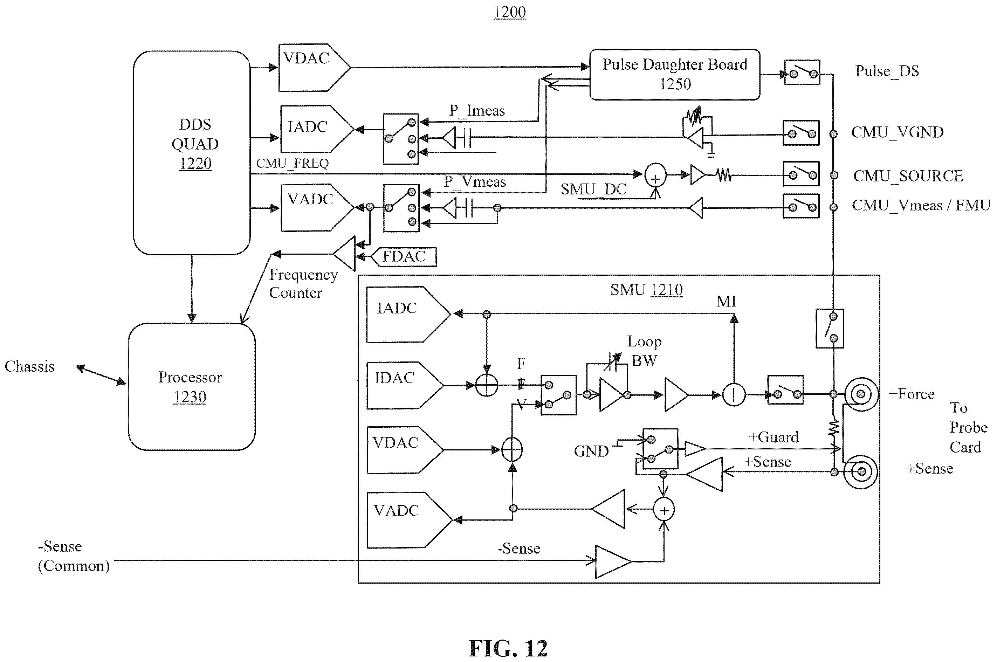

FIG. 12 illustrates a block diagram of a resource card 1200 according to an embodiment of the present disclosure. Stimulus and measurement functions may be implemented by DDS 1220, processor 1230, SMU 1210, and pulse daughter board 1250. DDS 1220 can be implemented as a quad-channel direct digital synthesizer. DDS 1220 may drive three high-speed front ends, e.g., multiple VDAC, IADC, and DDS units. One DDS path may be coupled for frequency counter and DAC for fine frequency or phase trim.

As shown, DDS outputs may pass through nodes "P_Imeas" and "P_Vmeas", each of which may be gated with different switching elements and routed on CMU lines. In some embodiments, CMU voltage path may be summed with SMU lines by a summing amplifier, and bidirectional links may connect to pulse daughter board 1250. Pulse daughter board 1250 may present four front-panel connections, which may route the pulse drive, the CMU virtual ground, the CMU source drive, and the CMU voltage or FMU measurement to the right-hand I/O block identified as to probe card. Resource card 1200 may communicate with the chassis backplane and a-Sense common may provide the shared return reference at the bottom of FIG. 12.

A measurement path may be realized by SMU 1210. SMU 1210 may include IADC for high-resolution current capture, IDAC as a precision current source, and a VDAC as a precision voltage source, and VADC for voltage measurement. A mode selector may switch between force current and force voltage, and a compensation loop may close around the output stage while measurement branch may sense current.

Front-end connections may include +Force and +Sense to the probe card, a driven +Guard referenced to GND to minimize leakage, and a return -Sense path with a large span (e.g., 100 V to 0.5 V). Processor 1230 may configure VDAC, IADC, VADC, FDAC, CMU, SMU units and pulse daughter board 1250, and may collect digitized data from SMU 1210 for transfer across chassis card cage.

As illustrated in FIG. 12, in some embodiments resource card 1200 Pulse Daughter Board 1250 can expose discrete front-panel connections allowing parts of the stimulus / measurement chain to be isolated or used separately. This allows external measurement paths or calibration modules to be appended without disturbing core SMU circuits.

In FIG. 12, the inclusion of separate measurement gating nodes (P_Imeas / P_Vmeas) and programmable gain amplifiers in the CMU / AWG (Arbitrary Waveform Generator) paths can improve control over which path is active and how it is conditioned.

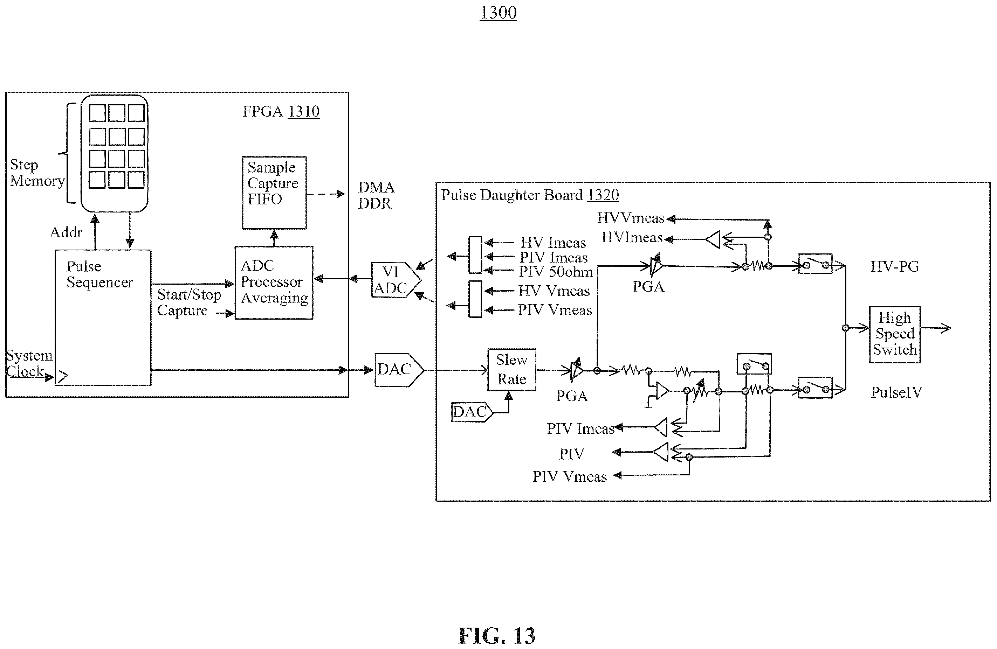

FIG. 13 illustrates a schematic circuit of pulse daughter board system 1300 according to an embodiment of the present disclosure. In some implementation, pulse daughter board system 1300 can be configured for a per-test channel pulse resource and as a pulse analyzer. Control and data-plane functions may be partitioned between FPGA 1310 and pulse daughter board 1320. Inside FPGA 1310, a memory may store opcode sequences addressed by Pulse Sequencer using Opcode List under a system clock. Sequence events may assert Start/Stop Capture toward an ADC, whose results may be queued in a Sample Capture FIFO and transferred to a DDR. Analog observables from the daughter board may be digitized by an ADC, while control waveforms or biases may be produced by DAC and forwarded to the daughter board.

On pulse daughter board 1320, the DAC waveform may first pass a Slew Rate limiter before entering the source path. The high-voltage branch may include a Programmable Gain Amplifier (PGA) and selectable output ranges. Current-range selection may steer the drive into a pulse-IV path where monitored nodes PIV Imeas, PIV, and PIV Vmeas may be buffered for measurement. High-voltage feedback nodes HV Imeas and HV Vmeas may return to an ADC in FPGA 1310 for closed-loop observation and averaging. The output side may provide two logically distinct drives. Collectively, FPGA 1310 and pulse daughter board 1320 may generate programmable pulses with controlled slew, selectable voltage ranges, selectable current ranges, and real-time capture of voltage and current measurements at both high-voltage and pulse-IV nodes. Further, pulse daughter board 1320 may include a high-speed switch positioned at the output stage to steer the drive path between a high-voltage pulse-generation (HV-PG) branch and a pulse-IV (PIV) branch. The high-speed switch may be implemented using a solid-state device such as a GaN or MOSFET-based driver network capable of fast transition times. When commanded by control strobes from FPGA 1310, the switch rapidly connects or isolates the selected branch, enabling transition between voltage-driven and current-driven operation without external relays. In the HV-PG path, the high-speed switch applies the conditioned high-voltage waveform produced by the PGA to the DUT pin, while in the PIV path, it routes the output through the precision current-sense and voltage-measurement network for low-level pulsed characterization. This configuration minimizes parasitic capacitance, preserves waveform fidelity during fast edge transitions, and allows precisely timed pulses to be delivered or measured with minimal distortion. As a result, pulse daughter board 1320 can produce tightly shaped pulses synchronized to the FPGA's sequencer timing, achieving both high-voltage accuracy and high-speed pulse control within the same hardware platform.

In some embodiments, control-plane functions are executed by FPGA 1310 and analog stimulus/measurement functions are executed by a pulse daughter board 1320. In such embodiments, within FPGA 1310, a Step Memory may store the opcode sequences. An Addr line can provide addressing into Step Memory, and a Pulse Sequencer may read the opcodes and issues control strobes under a System Clock. In such embodiments, the sequencer may assert a Start/Stop Capture signal to an ADC Processor/Averaging block that performs per-pulse accumulation or averaging. Averaged samples are written into a Sample Capture FIFO (e.g., at 128K), and a DMA-to-DDR path streams the FIFO contents to system memory for host retrieval.

FPGA 1310 may further include a VI ADC (voltage/current acquisition ADC) and a DAC. The VI ADC can digitize analog observables returned from the daughter board 1320 (described below) and provides those samples to the ADC Processor/Averaging block. The DAC produces an analog control/bias waveform that exits FPGA 1310 and enters pulse daughter board 1320 as the drive/control input to the stimulus chain.

Further, as previously discussed, in some embodiments on pulse daughter board 1320, the DAC drive from FPGA 1310 can be configured to first pass through a Slew Rate limiter, thereby shaping transitions before they enter the analog front end. Further, in the high-voltage branch, the drive may be applied to a PGA (programmable-gain amplifier) whose gain is digitally set to match the required output range. PGAs are commonly used to extend dynamic range and maintain signal-to-noise performance in instrumentation front ends.

Moreover, in some embodiments a board system 1300 may provide three buffered, separately routable measurement nodes: PIV Imeas (pulse-IV current measurement), PIV ohm (a measurement across a defined sense path), and PIV Vmeas (pulse-IV voltage measurement). Further, a second PGA can be configured to condition this branch so the same VI ADC in FPGA 1310 can accurately digitize the PIV observables across a wide dynamic range. Multiplexer symbols at each measurement cluster denote that any of the listed nodes may be selected onto the VI-ADC return line under Pulse Sequencer control. Solid-state analog switches/multiplexers are a standard way to route such analog measurement paths.

In some embodiments, FPGA 1310 may include a high-speed pulse sequencer that executes an opcode/operand program to control waveform synthesis. The sequencer, operating from Step Memory under the System Clock, can decode opcodes with associated operands. By writing operand-defined data values to the DAC at deterministic update intervals, the sequencer generates complex, repeating waveforms such as stepped ladders, ramps, bursts, multi-level pedestal-plus-pulse patterns, or arbitrary sequences. The opcode flow can target the HV-PG or PulseIV path selection lines, enabling coordinated switching and waveform shaping without firmware latency. The opcode stream can also schedule data acquisition. Capture-related opcodes assert Start/Stop gating, define sampling windows, and specify the number of samples M to take directly from the VI ADC during a given waveform interval (e.g., pulse flat-top).

Moreover, an on-FPGA averaging engine accumulates the M samples to compute a mean (and optionally variance or baseline subtraction), producing a decimated, low-noise measurement aligned to the programmed waveform timing. The averaged result is written to the Sample Capture FIFO for DMA transfer, while optional modes permit raw sample streaming. Performing timing, sampling, and averaging entirely within the FPGA reduces host bandwidth, improves SNR, and preserves phase-coherent alignment between stimulus and measurement.

In some embodiments, pulse daughter board 1320 may be configured as a pulse resource and may include a first branch (e.g., the top branch in FIG. 13), a second branch (e.g., the bottom branch in FIG. 13), and a high-speed output switch coupled to both branches (e.g., the High Speed Switch in FIG. 13). A common drive input to the pulse resource may be provided by the DAC path from FPGA 1310 after transition shaping by the Slew Rate limiter. The first branch may implement a voltage-oriented pulse generation path (HV-PG) and may include a pulse generator configured to synthesize a time-varying waveform from the DAC input, a programmable-gain amplifier (PGA) that scales the waveform to selectable output ranges, and a first branch switch positioned electrically downstream of the PGA. The pulse generator may include a driver stage and associated conditioning network arranged to provide fast edge transitions with controlled slew as dictated by opcode-scheduled DAC updates, and the PGA may be digitally set to maintain signal-to-noise performance over multiple high-voltage spans. The first branch switch may be realized as a solid-state analog gating element (e.g., a back-to-back MOSFET or GaN device) operative, under Pulse Sequencer control, to isolate the HV-PG path during off-intervals, to pre-charge or hold a defined output potential, and to mitigate charge injection into the downstream load. The high-speed output switch, which may be implemented using a low-parasitic, fast-transition device, may be coupled to an output node of the first branch and arranged to selectively connect that node to a device-under-test (DUT) pin or to isolate it, thereby steering the conditioned high-voltage pulse toward the DUT with minimal parasitic capacitance and preserved waveform fidelity.

The second branch may implement a pulse-IV characterization path and may include circuitry for pulse current and voltage measurements together with a second branch switch operative to gate the measurement path. The measurement circuitry may include a precision current-sense element and transimpedance/buffer stages to generate a pulse current measurement signal (PIV Imeas), along with Kelvin-referenced voltage taps arranged to provide a pulse voltage measurement signal (PIV Vmeas) and, in some implementations, a defined-resistance observation leg (e.g., a PIV ohmic path) for calibration or range extension.

One or more conditioning amplifiers, which may include a PGA dedicated to the PulseIV path, may scale the sensed signals so that the VI ADC on FPGA 1310 can accurately digitize across wide dynamic ranges. Multiplexer elements may be provided so that any selected measurement node (e.g., PIV Imeas, PIV Vmeas, or an ohmic reference) is routed back to the VI-ADC return under sequencer control for synchronous averaging. The second branch switch may be disposed between the stimulus node and the PIV network to define sampling windows with sub-microsecond precision, to protect the measurement amplifiers during high-energy events, and to reduce settling time by decoupling stray capacitances outside of active intervals. During operation, the Pulse Sequencer may coordinate the first branch switch, the second branch switch, and the high-speed output switch so that the pulse resource alternates, in a time-deterministic manner, between a voltage-drive mode that delivers a shaped HV-PG waveform to the DUT and a pulse-IV mode that routes the stimulus through the current-sense and voltage-sense network for acquisition, enabling high-accuracy delivery and capture within a single hardware platform.

In some embodiments, the pulse resource comprises a digital-to-analog converter (e.g., the DAC driven by FPGA 1310) that fans out to a plurality of programmable-gain amplifiers on pulse daughter board 1320, where the PGA outputs are selectable by a high-speed switch positioned at the output stage. Additionally, or alternatively, the pulse resource may include an analog-to-digital converter for voltage/current (VI ADC) coupled to measurement buffers. For example, the DAC output may concurrently drive a first PGA in the high-voltage pulse-generation (HV-PG) branch and a second PGA in the PulseIV branch, with the high-speed switch steering the selected PGA output toward the DUT pin to realize output ranges. The VI ADC may be coupled to a buffer network that includes, by way of example, (a) unity-gain voltage followers that isolate Kelvin-tapped voltage nodes (HV Vmeas, PIV Vmeas) from ADC sampling kickback; (b) a transimpedance-amplifier (TIA) current buffer that converts sensed current to voltage for the PIV Imeas path and supports selectable feedback elements for range scaling; and (c) instrumentation-amplifier or differential buffers that receive divider-conditioned high-voltage feedback for the HV Imeas path. In one configuration, the HV measurement options can use a resistor-divider with an HV-tolerant buffer into the VI ADC to report HV Vmeas, while a current-sense element with a TIA provides HV Imeas. In another configuration, the PulseIV options selectable by on-board multiplexers include PIV Imeas (through the TIA buffer for low-level pulsed current), PIV Vmeas and an optional PIV 50-ohm leg for calibrated, high-bandwidth measurements. These buffered measurement paths present a low source impedance to the VI ADC, reduce settling time during windowed sampling, and permit the controller to select among HV, PIV, and Imeas observables while the high-speed switch concurrently selects the desired PGA-conditioned drive, thereby supporting the claimed architecture.

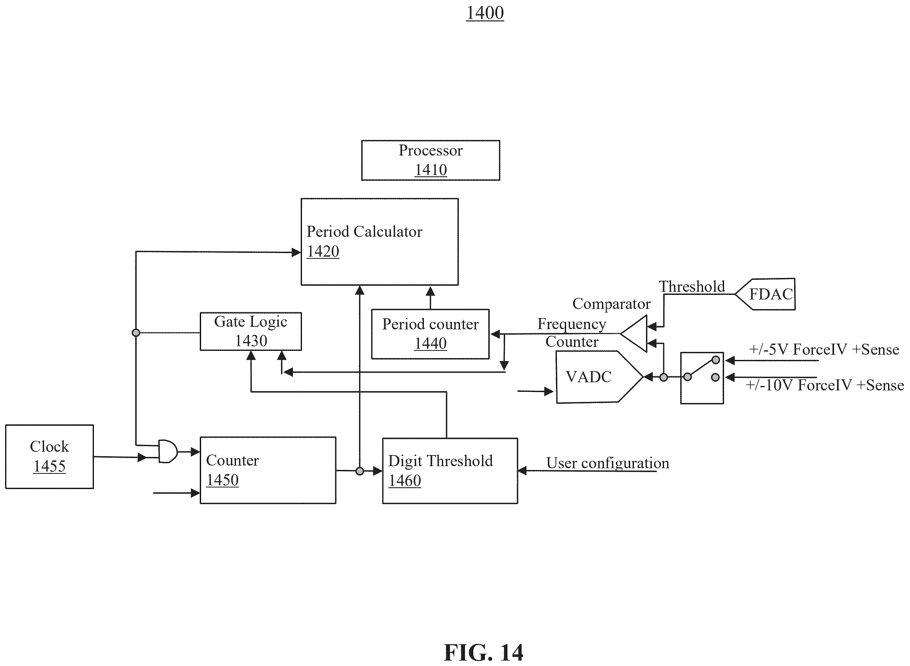

FIG. 14 illustrates a block diagram of a FMU reciprocal mode 1400 according to an embodiment of the present disclosure. Frequency and period measurement may be supervised by microprocessor 1410, which may compute frequency from timing data delivered by downstream counters. Edge timing from a device under test may be acquired by VADC through a range selector that may switch between "ForceIV +Sense" and "ForceIV +Sense". The digitized stream may be applied to a frequency counter and to a comparator whose reference may be set by FDAC to establish an adjustable detection threshold.

Comparator edges may drive period counter 1440 while also feeding gate logic 1430. A counter 1450 may provide the time base, a clock 1455 may provide timing, and digit threshold 1460 may accept a user-specified resolution so that counting may continue for a known number of DUT periods. Gate logic 1430 may enforce actions such as stop next DUT edge after digit threshold," thereby closing the measurement window after the user-defined period and asserting capture.

Period calculator 1420 may then determine the known elapsed time for DUT periods using a counter value, and microprocessor 1410 may compute the corresponding frequency. The arrangement may support input frequencies while allowing threshold control and input ranging (e.g., via the +/-5 V and/or +/-10 V selections). Other selections, however, are also possible and within the scope of the disclosed embodiments.

As shown in FIG. 14, in some embodiments DUT signals can be range-selected (e.g., "±5 V ForceIV +Sense" or "±10 V ForceIV +Sense") and routed in parallel to VADC and a comparator whose trip point is set by FDAC. The comparator can be configured to produce clean timing edges for counting; in some implementations a small hysteresis window can be used to suppress noise-induced chatter and improve edge-time repeatability.

Edges from comparators or counters can be used to drive Period Counter 1440 and Gate Logic 1430. Counter 1450 can supply the time base, while Digit Threshold 1460 may accept a user-chosen timing. Gate Logic 1430 can be configured to stops on the next DUT edge after the digit threshold, so the window spans exactly periods configured by the user.

The arrangement shown in FIG. 14 can have adjustable frequencies and inputs via FDAC, range selection at the front end, and time-base-limited resolution. The parallel VADC path can also archive waveform snapshots for diagnostics or adaptive thresholding, while overall accuracy benefits from a low-jitter time base and clocking (since sampling/clock jitter directly degrades high-speed measurement SNR and timing).

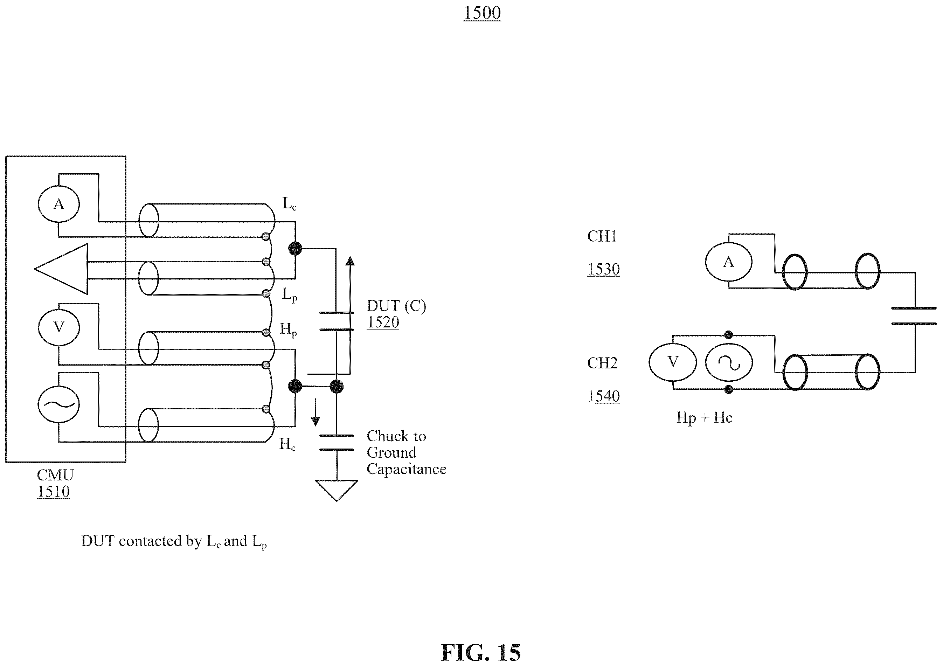

FIG. 15 illustrates a measurement paths 1500 of a CMU according to an embodiment of the present disclosure.

CMU 1510 may contact DUT 1520 with four terminals such "Lc", "Lp", "Hp", and "He." CMU 1510 may provide an AC excitation source, a voltmeter V, a current meter A, and a high-input-impedance amplifier so that stimulus may be applied on "Hp" with return on "Hc", while voltage may be sensed across "Lp" and "Lc" to realize a four-terminal measurement of DUT 1520.

In FIG. 15, CH1 may denote a test channel 1530 and CH2 may denote a test channel 1540. Test channel 1530 may be assigned as a low-side AC current-measurement channel, represented by A. Test channel 1540 may be assigned as a high-side source with voltage sense, depicted by V and the sine source, and "Hp + Hc" indicate the driven high node and its guarded return. The channels may connect to the same capacitor of DUT 1520, demonstrating that any channel in the multi-channel system may be configured as the source side or as the current-measurement side to emulate a classic CMU four-terminal method. Accordingly, the figure does correspond to the previously described multi-channel system and illustrates how one device under test may be measured without a single shared LCR meter while still preserving four-wire accuracy.

Further, as shown in FIG. 15, in the four-terminal pair topology on the left, CMU 1510 sources an AC stimulus between Hp (high-potential) and Hc (high-current/return), senses voltage between Lp (low-potential) and Lc (low-current), and measures current in the Hc/Lc path. This can be implemented for an auto-balancing bridge: the ammeter resides in the low current return, a high-impedance voltmeter senses Hp-Lp, and a guard/shield drives the fixture to minimize stray admittance. Correct assignment and cabling of Hc/Hp/Lp/Lc are standard practice for accurate CV/impedance work.

FIG. 15 also shows chuck-to-ground capacitance from the wafer chuck tied to Hc. In wafer probing parasitic can divert measurement current unless guarded or compensated; therefore, four-wire sensing and driven-guard practice are applied, and open/short (and, where applicable, load) compensation is performed at the fixture to remove residual cable/fixture errors.

Test channel 1530 and 1540 show how the disclosed system can be configured to emulate CMU measurement: CH2 is configured as the source + high-side voltage sense (symbol V with sine, "Hp + Hc/guard"), while CH1 is configured as the low-side current-measurement channel (symbol A). Both channels connect to the same DUT capacitor 1520 so that current is measured in the low return path while voltage is sensed across separate potential leads, preserving four-wire accuracy without a single shared LCR instrument. This arrangement implements the same four-terminal sensing principle used in precision impedance meters.

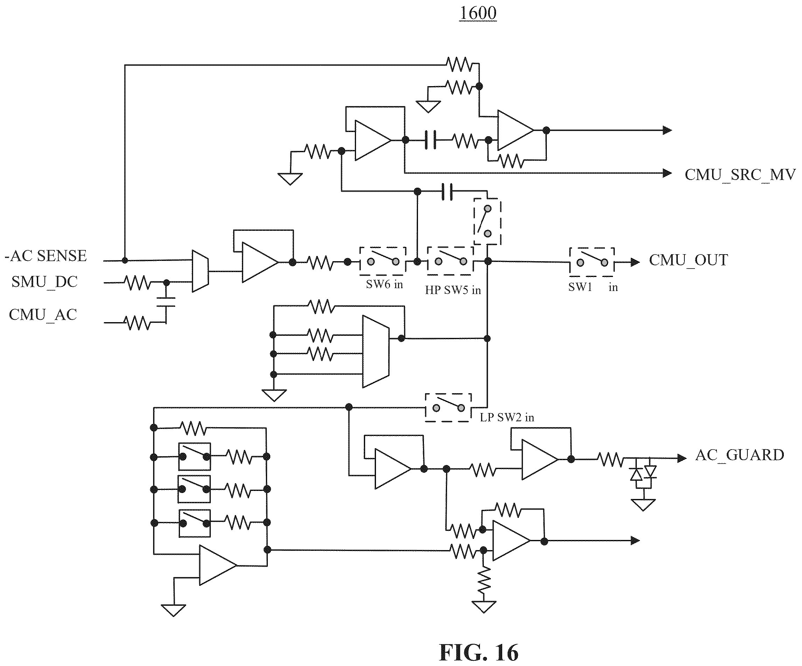

FIG. 16 illustrates a block diagram 1600 of CMU circuit configuration according to an embodiment of the present disclosure. A programmable routing and amplification network may establish the relationship among the measurement node, the source node, and the guard node for a multi-channel system. Inputs "AC_SENSE", "SMU_DC", and "CMU_AC" may enter a buffer chain. The path may include series element (e.g., 50 OHM) and selectable switches SW6, SW5, SW4, and SW1, which may be implemented as MEMS or photo relays. Selectable switches can be specific for different potentials. For example, while SW5 may be a high switch while SW2 may be a low switch. In one embodiment, SW5 (HP_SW5_in) resides in the high-potential branch while SW2 (LP_SW2_in) resides in the low-potential branch; SW6 inserts the series element (e.g., 50 Ω) for damping/protection and SW1 provides output isolation to CMU_OUT during reconfiguration. The controls are interlocked so the HP and LP branches cannot be closed at the same time, and a break-before-make sequence (with optional bleed/clamp) manages charge injection. When the LP branch is selected, an AC_GUARD driver follows the measurement node to suppress leakage and stray capacitance. HP-rated switches prioritize standoff and surge capacity, whereas LP switches use ultra-low-leakage devices to preserve femtoampere-level accuracy.

Further, a programmable resistor network and a shunt node may be tied to and may set ranges and bias. Similarly, the switch blocks may be implemented with MEMS and/or photo relays, including a combination. Through these selections the signal may be directed to output "CMU_OUT" for capacitance or other AC measurements.

In some embodiments, CMU may use a high-speed op amp configured as a buffer followed by a coupling network into a different op amp configured for high-speed amplification. And by switching SW4, SW5, and SW6 the system may change gain and range while coordinating with the left-side measurement shunt network to maintain accuracy.

Further CMU may use an op amp configured for buffering and a selectable resistor ladder to set effective gain and impedance. And cascaded op amp stages may supply drive strength and stability and may produce the guard output "AC_GUARD."

In combination, the operational amplifiers and switches may provide flexible mixing among "AC_SENSE", "SMU_DC", and "CMU_AC", and may expose the three key endpoints "CMU_OUT", "CMU_SRC_MV", and "AC_GUARD."

In some embodiments, inputs AC_SENSE, SMU_DC, and CMU_AC can be configured to enter a high-impedance buffer chain headed by a FET-input, wideband op amp to minimize loading of high-impedance nodes. Downstream, selectable switches SW6, SW5, SW4, and SW1 can establish which source or sense path is active and isolate inactive paths without contact bounce. Further, in such embodiments, a programmable shunt/bias network can be configured to dynamically set input range or DC bias during AC measurements.

In some embodiments, switch states SW4-SW6 can select gain/range combinations that are coordinated with the left-side shunt network so that the effective transconductance and voltage compliance remain within calibration across ranges. Op amps can be used to implement this function, supporting multi-MHz excitation with stable loop response under capacitive loads of DUTs and cabling.

In some embodiments, a low-noise wideband buffer can be configured to feed a selectable resistor ladder (e.g., 160 kΩ, 160 Ω, 1.6 kΩ, 16 kΩ) that sets effective gain/impedance for the guard amplifier pair. The output can be actively driven to track the potential of the adjacent high node, thereby reducing leakage and effective stray capacitance from cabling, probe cards, and wafer chucks to ground.

In some implementations, the circuit in FIG. 16 may be used to enable selection of the input (AC_SENSE, SMU_DC, or CMU_AC), asserting SW1-SW6 to configure range and path, biases the node with the 100 MΩ/100 kΩ network as required, drives CMU_SRC_MV with the programmed excitation, and sets the guard gain/filter so AC_GUARD tracks the source node. The measurement front end then acquires CMU_OUT while the monitor taps verify stimulus integrity.

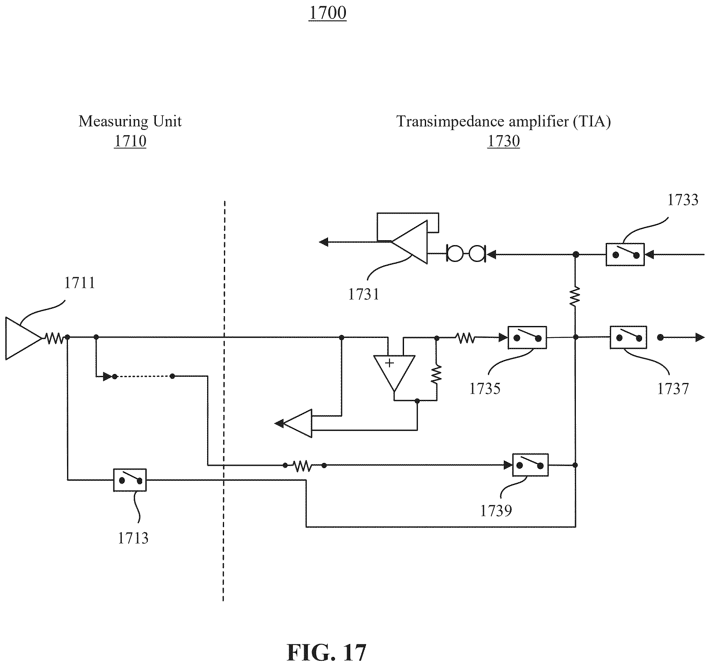

FIG. 17 illustrates a block diagram of circuit 1700 of measuring unit 1710 with TIA 1730 according to an embodiment of the present disclosure. Measuring unit 1710 may receive a signal from a device under test and may precondition or route that signal, as previously discussed in connection with FIGS. 10-16. Front-end buffer 1711 may present a high-impedance input, and selectable switch 1713 may shunt or bypass the input to establish a reference or protection path before the signal reaches transimpedance amplifier TIA 1730.

TIA 1730 may implement precision current-to-voltage conversion. An operational amplifier in 1730 may be configured with a feedback impedance to set the transimpedance gain, and the inverting node may form the summing junction tied to the output of measuring unit 1710. Guard or bootstrapped buffer 1731 may drive a surrounding shield or auxiliary node so that leakage and stray capacitance are reduced at the summing node. Range-select switch 1735 may insert or remove feedback elements to change the effective gain or bandwidth of the TIA. Output-enable switch 1737 and output-enable switch 1733 may couple the conditioned voltage to a downstream bus or converter, while bypass switch 1739 may route the preconditioned input directly to the output path when voltage sensing rather than current sensing is desired.

In some embodiments, measuring unit 1710 can be configured to condition current or voltage from a DUT and presents it to the transimpedance stage. Front-end buffer 1711 may be set as a high-input-impedance amplifier used to minimize loading of picoamp-level sources; suitable devices include electrometer amplifiers with integrated guard drivers. The selectable path with switch 1713 provides input protection and mode setup-e.g., a low-leakage relay or PhotoMOS that can shunt the node to a reference during range changes, connect clamp elements, or short the input for zero/offset calibration before engaging the transimpedance path. Low-capacitance relays can be advantageous here.

In certain embodiments, transimpedance amplifier 1730 may convert input current to voltage using an op-amp with a feedback impedance (Rf // Cf) selected by range-select switch 1735. For example, switch 1735 may select among Rf values (e.g., from 1 kΩ to 1 GΩ) with parallel compensation capacitors. The inverting input of 1730 forms a summing junction tied to the output of measuring unit 1710; the noninverting input may be referenced to a quiet analog ground or a programmable bias for offsetting.

In some embodiments buffer 1731 can be configured as a guard/bootstrapped buffer to drive a surrounding shield (e.g., PCB guard ring or coax guard) at approximately the same potential as the summing node so that leakage and parasitic capacitance from board, socket, or cabling do not steal current from the DUT. In one implementation, buffer 1731 can be an amplifier integrated guard buffer or a dedicated unity-gain stage that drives guard planes and rings around the 1730 inputs; the layout may employ continuous guard rings, guard vias, and keep-outs around the inverting node to suppress leakages.

The conditioned output of 1730 is routed by output-enable switch 1737 to downstream circuitry such as a filter and ADC driver. Further, control of 1713, 1735, 1737, and 1739 can allow multiple modes: (i) high-sensitivity current mode, using a large-value Rf and small Cf for leakage/photocurrent measurement; (ii) wide-band current mode, selecting smaller Rf and larger Cf for higher-speed stimuli; and (iii) voltage mode, engaging switch 1739 and disabling TIA 1730. Range switching may be implemented with low-leakage relays.

Through coordinated control of 1713, 1735, 1737, and 1739, circuit 1700 may operate in multiple modes, including a high-sensitivity current-measurement mode using TIA 1730 and a pass-through voltage-measurement mode using the bypass path. Buffer 1731 together with the selectable feedback network in 1735 may protect the front end and stabilize the summing node.

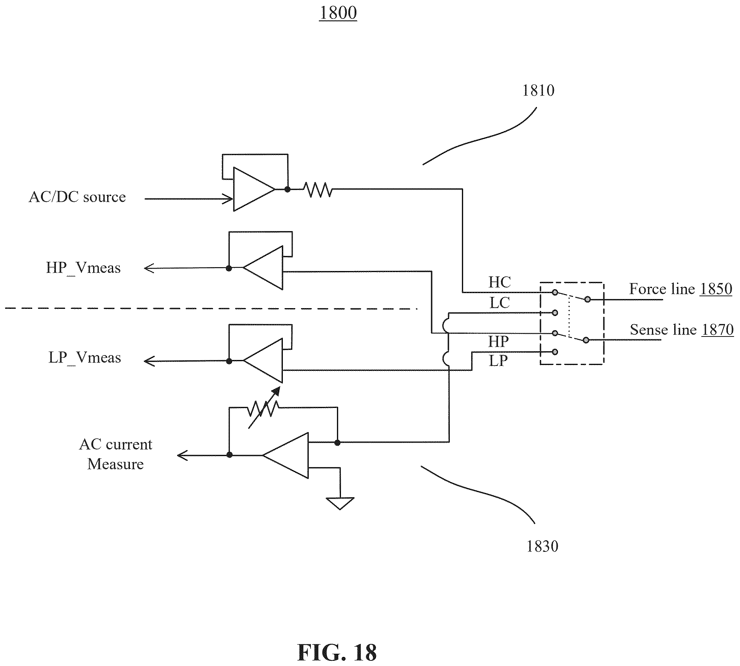

FIG. 18 illustrates a schematic circuit 1800 of the test channel 1810, 1830 of the multi-channel parallel device testing system according to an embodiment of the present disclosure. As shown in FIG. 18, upper test channel 1810 and lower test channel 1830 may be used in multi-channel parallel device testing system 100, where multi-channel parallel device testing system 100 may be connected to multiple DUTs via force line 1850 and sense line 1870.

In some embodiments, circuit 1800 may be implemented with a dual-path test channel architecture with an upper test channel 1810 and a lower test channel 1830 that terminate at a configurable, switching block. The switch can be configured to connect independently selectable nodes to the device interface: force line 1850 and sense line 1870.

In some embodiments, by actuating the switch a given channel can be configured as either a "high" channel (HC with HP closed) or a "low" channel (LC with LP closed), thereby realizing a Kelvin, four-terminal style connection in which current is forced on one pair and voltage is sensed on a separate, high-impedance pair to minimize lead-drop errors.

Upper test channel 1810 can include an AC/DC source driver (left-top op-amp triangle) feeding the switch block through a series resistor (shown inline) that provides current limiting, damping, and cable-match when driving the DUT through force line 1850. A second amplifier can be configured to provide the high-potential (HP) voltage sense. And this node can be routed to the sense line when HP is selected. In one implementation, a driver can be configured as a wide-band op amp to provide DC or AC stimulus.

Lower test channel 1830 may be configured to measure low-potential sense. Additionally, or alternatively, lower test channel 1830 can be configured to provide a complementary measurement. In lower test channel 1830 an amplifier sense can return current from the switch block; the symbolized resistor to ground indicates a transimpedance or shunt-based conversion of DUT current to a voltage for digitization. The amplifier can furnish the low-potential voltage sense lead. However, when the switch selects LC (for Force) and LP (for Sense), the channel acts as the low-side measurement leg: current is measured in the return while voltage is sensed with high impedance at the low-potential node, enabling accurate impedance/C-V measurements even in the presence of series lead resistance and chuck-to-ground parasitics. (Transimpedance conversion and guarding techniques are commonly used for picoamp-to-milliamp AC measurements.)

In FIG. 18, the switch (shown in dashed lines) can be implemented with low-leakage analog switch elements (e.g., PhotoMOS or MEMS relays) chosen to isolate inactive paths. In operation, any two channels in the multi-channel system can be paired: one configured HC+HP to act as the driven source/sense leg, and another configured LC+LP to act as the current-measurement/low-sense leg, thereby emulating a classic LCR/CMU four-terminal setup without a single shared meter. Channel roles can be reassigned under program control to test multiple DUT pins in parallel.

During a measurement, the AC/DC source in upper test channel 1810 can drive the DUT through force line 1850 when HC is closed; simultaneously HP reports the applied terminal voltage on sense line 1870. The DUT return current flows back through the lower path to the AC current measure stage when LC is closed, and LP reports the low-potential terminal voltage.

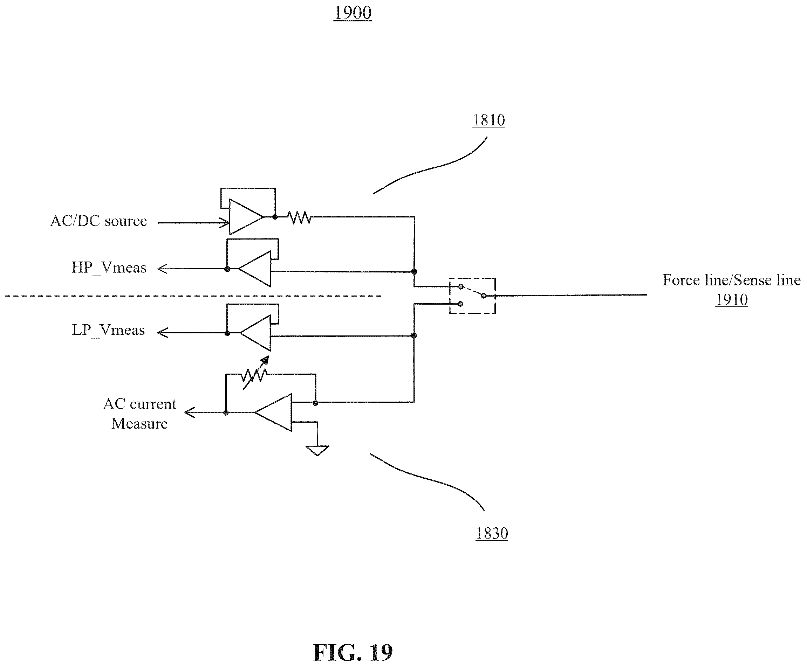

FIG. 19 illustrates a schematic circuit 1900 of the test channel 1910, 1930 of the multi-channel parallel device testing system 100 for high impedance DUT according to an embodiment of the present disclosure. FIG. 19 describes a streamlined design optimized for high-impedance DUTs, using a two-wire connection and omitting Kelvin separation where it is unnecessary.

In FIG. 19 a single Force/Sense line in test channel 1910 driven by a compact channel switch connects the DUT, rather than a switch with independent poles. Selection ties the DUT to either the upper test channel 1810 or lower test channel 1830 as a two-wire connection. Kelvin separation can be purposely omitted because the DUT impedance is sufficiently large that lead/contact resistance is negligible relative to the measured value.

Functionally, test channel 1810 can retain the AC/DC source driver (with series damping) and an HP monitor, and test channel 1830 can retain LP monitor and an AC current Measure stage. Unlike FIG. 18-where HP and LP were routed to a separate high-impedance sense pole-both voltage monitors in FIG. 19 observe the same selected node at the Channel-Select output, so either leg can source/measure without a distinct sense lead. The AC-current stage continues to sense return current for impedance/C-V extraction; however, because only one external conductor is used for both force and sense, the reading reflects the DUT plus any small lead series element (acceptable in the high-impedance regime). This streamlining reduces switch count and associated leakage/capacitance, which is advantageous when measuring very high impedances or small capacitances.

Some embodiments may combine circuits 1800 and 1900. Circuit 1800 in FIG. 18 can be set as a four-terminal option used when accuracy would be limited by lead resistance or contact drops (separate HC/LC force and HP/LP sense to enforce Kelvin), while FIG. 19 can be the two-terminal option used when the DUT impedance is high and a simpler topology improves throughput and minimizes parasitics (single Channel-Select to the Force/Sense line in test channel 1910).

The circuit 1800, 1900 respectively shown in FIG. 18 and FIG. 19 may improve alternative systems that use a single LCR meter. Multi-channel parallel device testing system 100 that uses the circuit 1800, 1900 shown in FIG. 18 and FIG. 19 may measure multiple DUTs at the same time because any test channel 1810, 1820, 1910, 1920 can act as the LCR meter and all test channels can be measured at the same time.

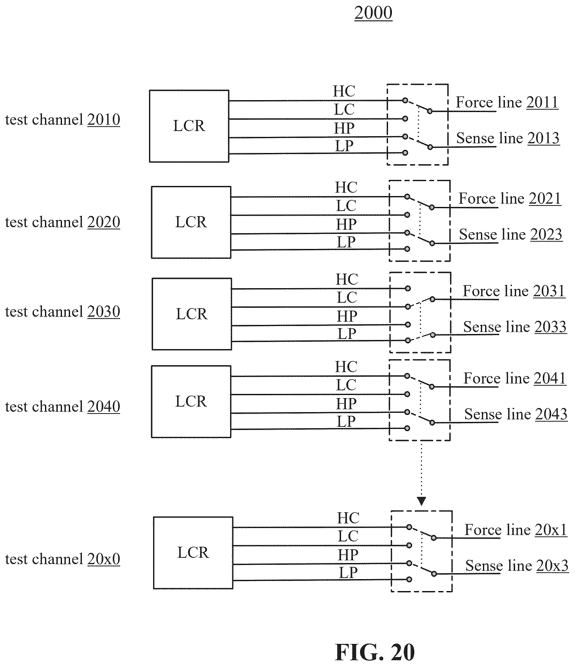

FIG. 20 illustrates a block diagram 2000 describing a system with multiple test channels of the multi-channel parallel device testing system according to an embodiment of the present disclosure. As shown in block diagram 2000, the system may include multiple test channels configurable with dual switches for upper and lower test channels, as discussed in connection with FIG. 18.

FIG. 20 depicts a scalable, per-channel LCR topology that mirrors the dual-path architecture of FIG. 18 but replicates it across many channels. Four representative test channels 2010, 2020, 2030, and 2040 are shown explicitly, with an additional channel 20x0 indicating continuation. Each test channel can integrate an LCR block that provides the four internal terminals HC (high-current force), LC (low-current force/return), HP (high-potential sense), and LP (low-potential sense). These four nodes can implement a four-terminal topology inside each channel so that current is forced on one pair while voltage is sensed on a separate, high-impedance pair.

For example, for test channel 2010 the four LCR nodes feed a two-pole switching module (shown with a dashed outline) that presents a dedicated Force line 2011 and Sense line 2013 to the probe interface. The same structure is repeated for test channel 2020 with Force line 2021 and Sense line 2023, for test channel 2030 with Force line 2031 and Sense line 2033, and for test channel 2040 with Force line 2041 and Sense line 2043. In each instance, the switch selects which internal nodes (HC vs. LC, HP vs. LP) appear on the external force and sense conductors, permitting the channel to operate as a high leg (HC+HP) or a low leg (LC+LP) of a four-terminal pair, as described in FIG. 18. Additional channel 20x0 indicates that the same scheme extends to additional channels, each with its own Force line 20x1 and Sense line 20x3.

At run time, a controller programs the per-channel switch so any channel can serve as the driven source/sense leg (HC+HP) or as the return/current-measurement leg (LC+LP). Because each channel exposes its own force and sense outputs (2011/2013, 2021/2023, 2031/2033, 2041/2043, 20x1/20x3), multiple DUT pins or multiple DUTs can be stimulated and measured in parallel, with true four-terminal accuracy preserved per site. This "per-pin resource" style (one measurement resource per contacted pin) is a recognized way to increase parallelism and eliminate long switch-matrix paths that add leakage and capacitance.

FIG. 20 shows how the system can scale: the left-hand LCR block in each channel generates the AC stimulus and performs voltage/current sensing; the dashed two-pole switch assigns the four internal nodes (HC/LC/HP/LP) to the external Force and Sense conductors unique to that channel; the conductors (2011/2013, 2021/2023, 2031/2033, 2041/2043, 20x1/20x3) route directly to the probe card. By combining four-terminal sensing at the channel with per-pin fan-out, the architecture achieves accurate impedance/C-V results while supporting high-throughput, multi-site testing-an approach consistent with best practices for Kelvin sensing and driven-guarded measurements in precision LCR work.

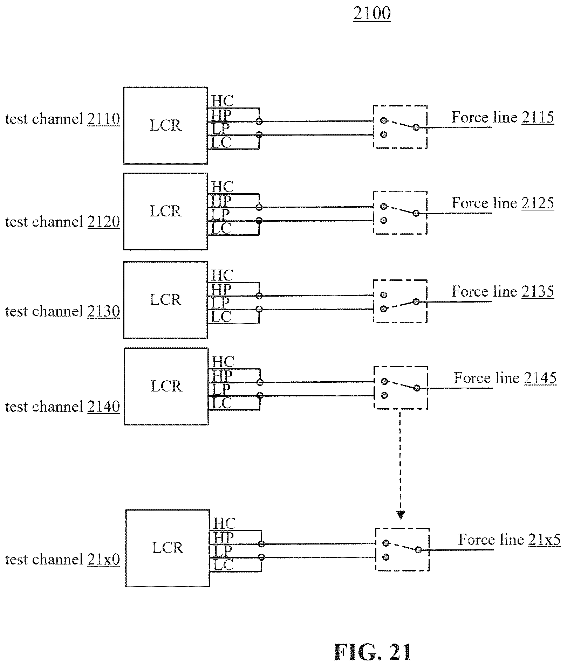

FIG. 21 illustrates a block diagram 2100 describing a system with multiple test channels of the multi-channel parallel device testing system according to an embodiment of the present disclosure. As shown in block diagram 2100, the system may include multiple test channels configurable with compact switches for upper and lower test channels, as discussed in connection with FIG. 19.

FIG. 21 shows a multi-channel topology derived from the two-wire configuration of FIG. 19. Five representative channels-test channel 2110, 2120, 2130, 2140, and 21x0-are illustrated. Each channel may include an LCR block exposing the four internal nodes HC, HP, LP, and LC, but only the HP and LP nodes are routed forward to a compact channel-select switch. The switch selects either HP or LP onto a single external conductor Force line 2115, 2125, 2135, 2145, or 21x5 (one per channel). As shown in FIG. 19, this implements a two-wire, high-impedance connection where the same conductor carries the force and sense function for that channel-appropriate when DUT impedance is sufficiently large that lead/contact resistance is negligible compared with the measured value.

The per-channel HP/LP selection allows each site to be bound to the "high" leg (HP referenced) or to the "low" leg (LP referenced) without a separate Kelvin sense return. Internally, the LCR block can still measure stimulus and response using the channel's own voltage and current monitors, but external cabling can be reduced to the single force line per site. Relative to FIG. 20, FIG. 21 arrangement can reduce the number of cables and switch poles, lower fixture capacitance/leakage and improving practicality for high-Z components or structures where two-wire accuracy is adequate.

The dashed channel-select switches in FIG. 21 may be realized with solid-state relays (e.g., PhotoMOS) or MEMS relays to preserve picoamp-level off currents and low parasitic capacitance at each site. These devices provide bounce-free operation and stable on-resistance across life, making them well-suited to multiplexing high-impedance measurements without corrupting the reading.

In operation, a controller programs each channel's switch to connect either HP or LP to its force line, applies the desired AC/DC stimulus from the LCR block, and acquires voltage/current internally per channel. Because only one conductor exits each site, routing density on the probe card increases and inter-site coupling is reduced.

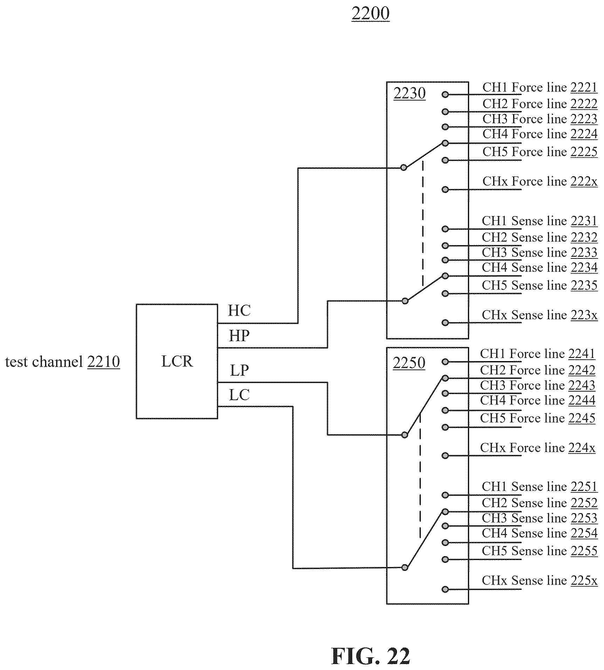

FIG. 22 illustrates an alternative test system 2200 according to an embodiment of the present disclosure. In FIG. 22, one test channel 2210 can be coupled with multiple sense and force lines with a high multiplexer 2230 and a low multiplexer 2250.

As shown in FIG. 22, in the test system 2200 single test channel 2210 exposes four nodes-HC, HP, LP, and LC-to high multiplexer 2230 and low multiplexer 2250. High multiplexer 2230 fans the HC/HP pair to a bank of external lines identified as CH1 Force line 222 to 2225 (plus an expansion port CHx Force line 222x indicating additional force lines can be added) and CH1 Sense line 2231 to 2235 (plus CHx Sense line 223x indicating additional sense lines can be included). Low multiplexer 2250 similarly fans the LC/LP pair to CH1 Force line 2241 to Force line 2245 (plus CHx Force line 224x) and CH1 Sense line 2251 to CH5 Sense line 2255 (plus CHx Sense line 225x).

In some embodiments, one selection is made in the high multiplexer 2230 and one in the low multiplexer 2250 so that the instrument's high (HC/HP) and low (LC/LP) terminals are routed to the same DUT site, preserving a true four-terminal-pair (4TP) connection. The 4TP scheme separates force and sense paths to eliminate lead drops and is standard practice for precision LCR/impedance measurements.

Further, in some embodiments, any one DUT site in the high bank and one in the low bank are selected because each pin can be independently configured. For example, a controller can sequence the two multiplexers so that, for example, to measure Site 3 the system closes the HC→CH3 Force line 2223 and HP→CH3 Sense line 2233 paths in the high multiplexer 2230 while simultaneously closing the LC→CH3 Force line 2243 and LP→CH3 Sense line 2253 paths in the low multiplexer 2250.

The line set in FIG. 22 represents a scan topology. For example, the CH1-CH5 Force lines 2221-2225 (and 2241-2245) can be configured to carry the current-forcing terminals for the selected high and low legs, respectively; the CH1-CH5 Sense lines 2231-2235 (and 2251-2255) carry the corresponding high-impedance voltage sense returns. Expansion identifiers 222x/223x/224x/225x indicate that additional sites can be added in the same manner without altering test channel 2210.

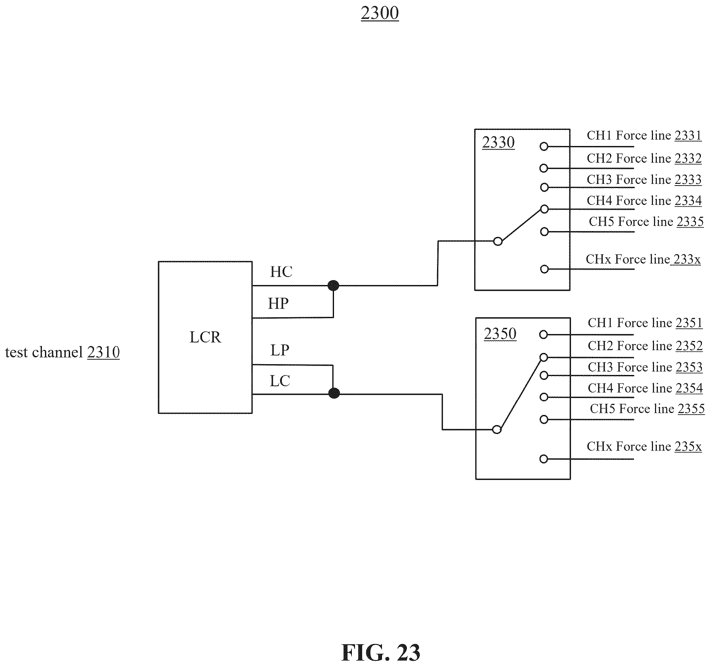

FIG. 23 illustrates the alternative test system 2300 for high impedance DUT according to an embodiment of the present disclosure. The alternative test system 2200 and 2300 may use a single LCR meter that is multiplexed to any 2 pins. One pin gets the high side AC source, and the other one pin gets the low side AC current measure.

In test system 2300 a single test channel 2310 (LCR) HC/HP and LC/LP are shorted and routed. HC/HP feeds a high multiplexer 2330 that fans out to CH1 Force line 2331, CH2 Force line 2332, CH3 Force line 2333, CH4 Force line 2334, CH5 Force line 2335, and an expansion output CHx Force line 233x. In parallel, LC/LP feeds a low multiplexer 2350 that fans out to CH1 Force line 2351, CH2 Force line 2352, CH3 Force line 2353, CH4 Force line 2354, CH5 Force line 2355, and CHx Force line 235x (representing any number of force lines). During a measurement the controller closes one path in 2330 and one path in 2350 so that HC and LC land on the same site number, establishing a two-wire drive/measure connection to that DUT pin.

Moreover, as shown in FIG. 23 two multiplexers (2330 and 2350) are configured without separate HP/LP sense. In FIG. 22, each side (high and low) had two banks (one for Force and one for Sense) to maintain a four-terminal connection. FIG. 23 omits two route relying instead on two lines. One benefit is a substantial reduction in switched paths and connectors, which reduces added leakage and parasitic capacitance from the matrix and harness, speeds scanning (fewer contacts to actuate), and lowers cost/size-advantages that are especially helpful with high-impedance DUTs where two-wire accuracy is adequate.

FIG. 23 configuration may be intended for applications where the DUT impedance is large relative to lead resistance (e.g., high-Z components or structures), while FIG. 22 configuration can be selected for higher accuracy. In some embodiments the multiplexers 2330/2350 are implemented with break-before-make low-leakage switching devices so that only one site per bank is ever connected and no two sites are momentarily shorted during transitions. Using solid-state relays with low C×R and low off-state leakage preserves accuracy with high-impedance sources and maintains bandwidth for AC measurements. The CHx designators (233x, 235x) show that additional sites can be added without changing test channel 2310, allowing time-multiplexed two-wire measurements across many DUT pins with a single precision LCR resource.

The LCR meter of the alternative system shown in FIG. 22 and FIG. 23 may be multiplexed to each pair of pins for a single measurement 24 times. By using the circuit shown in FIG. 18 and FIG. 19 and the multi-channel test system shown in FIG. 20 and FIG. 21, the measurement could be faster than one LCR meter being multiplexed. Therefore, multi-channel parallel device testing system 100 may provide faster testing time, and the faster testing time may provide lower testing cost per DUT.

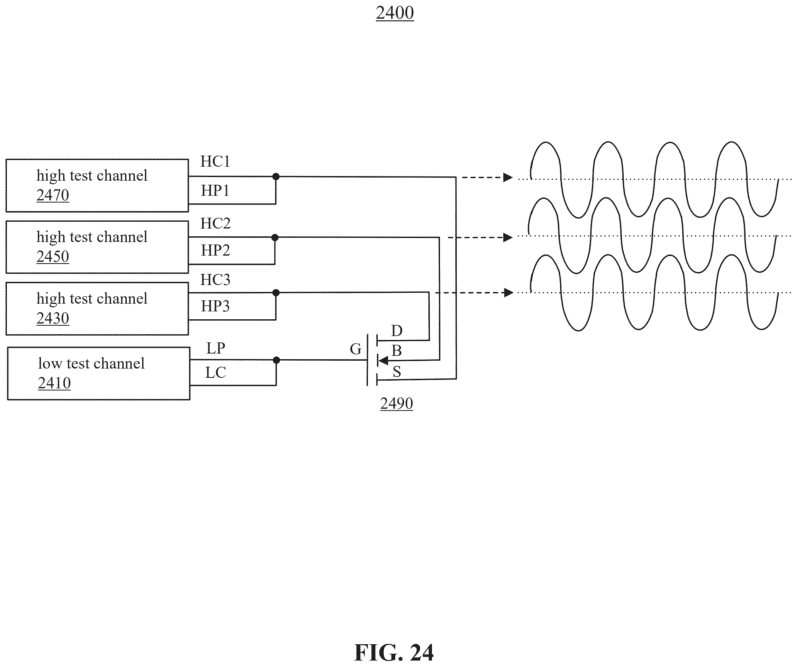

FIG. 24 illustrates a schematic circuit 2400 for measuring a C-V characteristic of a MOSFET on a wafer that multi-channel parallel device testing system 100 is mounted according to an embodiment of the present disclosure. As shown in FIG. 24, test channels may include a first test channel CH1, a second test channel CH2, a third test channel CH3, and a fourth test channel CH4. Multi-channel parallel device testing system 100 may be configurable to set the potential node of first test channel CH1, second test channel CH2, and third test channel CH3 to a first dynamic potential. Multi-channel parallel device testing system 100 may also set the potential node of the fourth test channel CH4 to a second dynamic potential. The second dynamic potential is different than the first dynamic potential. Multi-channel parallel device testing system 100 may perform a capacitance-voltage analysis by applying a voltage and measuring capacitance as a function of the first dynamic potential and the second dynamic potential.

In FIG. 24, three high test channels, test channel 2470 (HC1/HP1), test channel 2450 (HC2/HP2), and test channel 2430 (HC3/HP3), are routed respectively to a DUT that can be a MOSFET 2490 D, B, and S terminals. A low test channel 2410 (nodes LP/LC) is routed to MOSFET 2490 G terminal to provide the low-side reference and measurement return. Waveforms sketched to the right indicate that the three high channels can be driven with identical AC/DC stimuli (equal amplitude, DC offset, frequency, and phase), while the gate is biased/scanned by the low channel to realize a gate-to-(D,S,B) C-V measurement. This arrangement can be the functional equivalent of tying drain/source/bulk together and measuring against the gate, a standard MOSFET/MOS-capacitor C-V technique.

Implementing three synchronized high-side drivers as shown in FIG. 24 can have benefits such as each terminal is driven through its own calibrated path, allowing per-terminal guarding and leakage control; the drivers remain phase-locked so D, S, and B track together, emulating the tied-node condition used in MOS C-V practice; and the architecture can optionally introduce deliberate, known offsets (phase or DC) for advanced methods such as split-C-V or body-bias studies without rewiring.

Test channels 2470/2450/2430 can provide a force node (HCx) and a high-impedance sense node (HPx) to the DUT terminals (D/B/S), the test channel 2410 provides the return (LC) and the low-potential sense (LP) to the G terminal. The three sinusoidal traces emphasize that HC1/HC2/HC3 are equal in amplitude, offset, frequency, and phase, while the gate bias is swept by channel 2410.

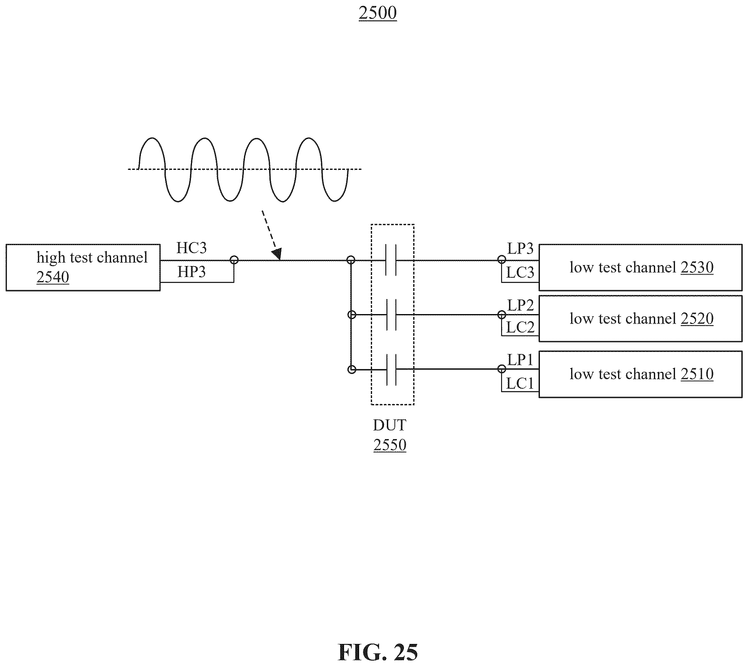

FIG. 25 illustrates a schematic circuit 2500 for measuring a C-V characteristic of a DUT according to an embodiment of the present disclosure. As shown in FIG. 25, test channel 2540 may be configured as a high-side channel to drive the common node through a high current switch HC3 and a potential node HP3 with synchronized AC excitation and optional DC bias. Potential node HP3 may be configured as high potential when the high current switch HC3 is closed. A sinusoid may indicate the applied AC stimulus.

A common node may fan out to multiple branches of a device under test (DUT) 2550. Each lower end connected to a low-side channel, i.e., test channel 2510, 2520, 2530. Each test channel 2510, 2520, 2530 may connect via corresponding low potential node LP1, LP2, LP3 and corresponding low current switch LC1, LC2, LC3 to provide separated low-side voltage-sense and AC current-measure paths.

In some embodiments, DUT 2550 branches may be three parallel capacitors. In some embodiments, resistors, diodes, or other passive or nonlinear elements may also be used. During measurement, high-side drive from test channel 2540 may be generated by a DDS and monitored at high potential node HP3 for accurate amplitude and phase.

In the FIG. 25, test channel 2540 may include the nodes HC3 (high-current force) and HP3 (high-potential sense) that can be shorted. HC3 is closed via a high-current switch when driving the common node of DUT 2550.

The common node from the high-side branch fans out to multiple branches inside DUT 2550, each branch terminating in a separate low-side test channel: test channels 2510, 2520, and 2530. Each of these applies its own low potential node (LP1, LP2, LP3) and low current switch (LC1, LC2, LC3). The LP nodes serve as voltage sense points, while the LC switches provide the return (force) or current measuring path, depending on how routed. These low channels can each measure the capacitance or current associated with their branch, allowing the system to capture multiple branch capacitances in parallel under the same common drive. In practice, each low channel has internal calibration and sense circuitry to resolve small currents and voltages with high fidelity.

The multiple-branch configuration supports performing capacitance-voltage (C-V) sweeps where the gate or common node is driven by the high-side channel while the voltage at the gate (or low side) is varied or stepped by one of the low channels, or by using all low channels concurrently to measure each branch's response. For example, in a MOS array where three source/drain/bulk terminals are tied together (or driven together), this configuration enables measuring the total capacitance to those nodes as a function of gate bias.

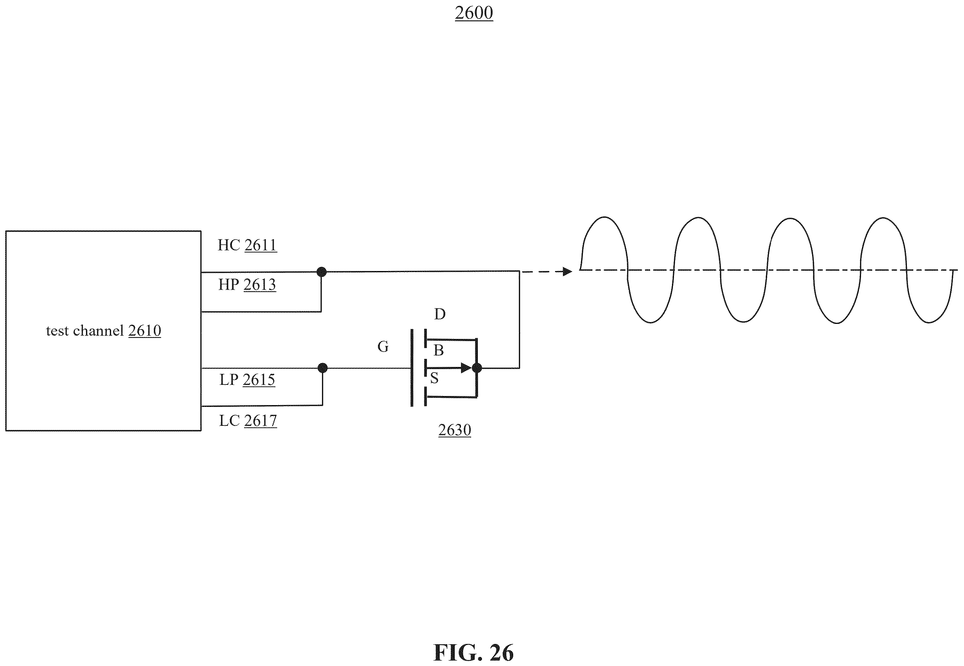

FIG. 26 illustrates a schematic circuit 2600 for a single high channel and other low channels testing according to an embodiment of the present disclosure.

As illustrated in FIG. 26, and previously discussed, HC node 2611, HP node 2613, LP node 2615, and LC node 2617 can be configured to be coupled for a two connection configuration. Specifically, as described above, the potential nodes may be configured as a high-potential node HP/HC and a low-potential node LP/LC. In some embodiments, the node connection shown in FIG. 26 may not be simultaneously active during normal measurement, aside from brief transitions that may occur during calibration. This single-node, programmable-role topology may reduce parasitics and routing imbalance while maintaining four-wire Kelvin separation and amplitude and phase coherence when a channel is assigned as the high side or the low side.

In some embodiments, circuit 2600 may be implemented as a single programmable switchable potential node to implement force/sense separation without requiring separate physical sense leads for high and low roles. As shown in FIG. 26, by reusing the same physical node under different switch states (HC closed → high-potential sense; LC closed → low-potential sense), the hardware avoids duplication of routing and associated parasitic capacitance, leakage, and phase / amplitude mismatch between separate paths.

With the implementation in FIG. 26, accurate matching of phase and amplitude between force and sense during calibration is enabled because the same source amplifier and clock drive both configurations. Example calibration routines might close HC, measure amplitude/phase at HP, open HC, close LC, measure at LP, then store correction coefficients. These corrections compensate for switch-and-routing induced delay or gain differences. Such practices are common in precision LCR / CMU instruments.

Another benefit of the topology of FIG. 26 can be that during non-measurement modes (e.g. during calibration or idle), the unused switch (HC or LC) can be opened, thereby isolating the non-active path. This minimizes the chance of parasitic leakage or capacitive coupling influencing the measurement. Also, because the same physical node is reused, its capacitance and routing layout can be made symmetric for both roles (HP vs LP), helping to reduce systematic error in phase or amplitude when the channel switches role.

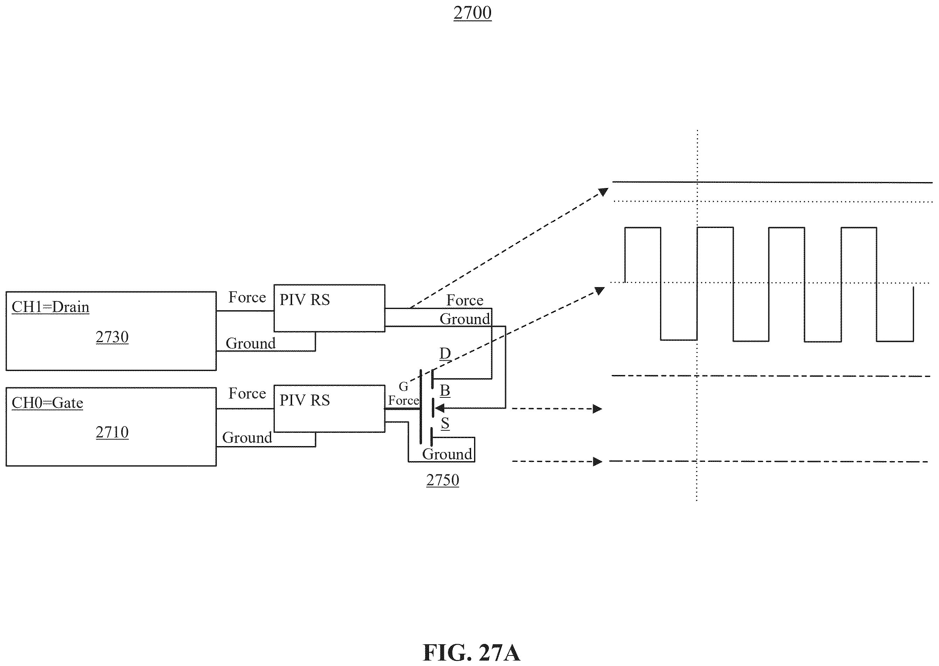

FIG. 27A also illustrates a schematic circuit 2700 for high-speed pulse IV test according to an embodiment of the present disclosure. As illustrated in FIG. 27A, two independently programmable test channels 2710, 2730 may be used. Test channel 2710 may drive the gate G of a device under test through a Pulsed I-V Remote Sense (PIV RS) module, and Test channel 2730 may apply a pulsed bias to the drain D and acquire voltage and current through another Pulsed IV (PIV) Remove Sense (RS) module. Each channel may provide Force and Ground returns to its respective PIV RS module, which may then connect to the device terminals. The PIV RS module may include high-speed switching, programmable source and measure stages, a current sense resistor, and impedance matching so that pulse edges are well controlled, peak current is limited, and sampled values are reported to a controller.

As shown in FIG. 27A MOSFET 2750 can have a source terminal S and body terminal B are shorted to ground, drain terminal D is driven by test channel 2730 through the force line with the corresponding ground return, and gate terminal G is biased by test channel 2710 with its own ground return. The timing diagram on the right may illustrate a drain waveform with an adjustable direct-current pedestal and superimposed pulses, a gate waveform that may be a step or a pulse train, and the source and body held at ground. A vertical dotted line denotes a common trigger instant at which both channels may align their pulse edges to minimize timing jitter.

During the test sequence a controller may program test channel 2730 pulse amplitude, width, rise time, fall time, and repetition rate, and may program a gate bias sweep on test channel 2710. At each pulse flat-top the system may sample drain voltage and the current reported by PIV RS module to form a single IV data point. Repeated sweeps may produce transfer characteristics, output characteristics, or pulsed Rds_on. The pulsed method may reduce self-heating and contact drift errors, and PIV RS module may provide over-voltage, over-current, and short-circuit protection suitable for fast wafer-level characterization.

In some embodiments, circuit 2700 may enable precise high-speed switching (for opening and closing the HC/LC switches). For example, the configuration shown in circuit 2700 can allow pulse rise/fall times on the order nanoseconds or faster, depending on device capacitance and measurement bandwidth.

FIG. 27A describes a possible representation of pulse resources in each test channel including a first branch and a second branch that are coupled by a high-speed switch. In the configuration of FIG. 27A, the PIV-RS force lines may define potential nodes at the DUT drain and gate, each coupled to a corresponding testing pin with a ground return. A mode switch in the test channels can selectively couple the respective potential node either to a pulse resource (e.g., delivering a pedestal-biased pulse train whose edges are aligned to the dotted timing mark) or to a measuring resource. The dotted vertical trigger can indicate timing derived from a common system clock so that pulse application and measurement windows are phase-aligned across the test channels.

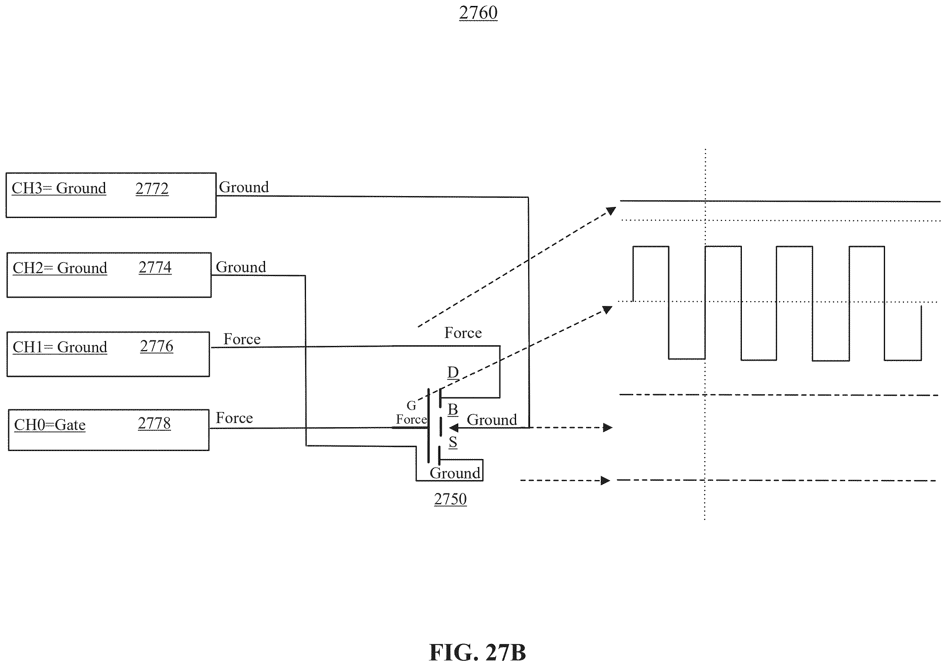

FIG. 27B illustrates a schematic 2760 of a second high-speed pulse IV test according to an embodiment of the present disclosure. As shown, four independently programmable test channels 2772, 2774, 2776, and 2778 may be used. Test channel CH0 (2778) can be configured to drive the gate G of the device under test (DUT) 2750 with a pulsed excitation (Force lead shown). Test channel CH1 (2776) is configured as a low-impedance reference on the drain D; in the illustrated embodiment CH1 forces the drain to a selected reference potential (e.g., ground), thereby providing a stable clamp and, when enabled, a measurement return for drain voltage and/or current. Test channels CH2 (2774) and CH3 (2772) provide ground connections for the body B and source S terminals, respectively, establishing a well-defined reference for the pulsed measurement. In alternative embodiments, CH1 may instead force a fixed DC drain bias while CH2/CH3 continue to provide body/source ground returns.

The right-hand timing diagram corresponds to the configuration of FIG. 27B. The top trace depicts the drain potential held substantially constant by CH1 (either at ground or at a programmed DC bias). The second trace depicts the gate waveform provided by CH0, which may be a pulsed train with programmable amplitude, width, rise time, fall time, and repetition rate. The lower dashed traces indicate the body and source remaining at ground potential via CH2 and CH3. A vertical dotted line denotes a common trigger instant; the channels align their operations to this trigger to minimize timing jitter between the gate pulse and any sampling or monitoring performed on the drain clamp channel.

During a test sequence, a controller may program CH0 to generate the desired gate pulse profile while commanding CH1 to maintain the drain clamp and optionally report drain voltage and current. At each pulse flat-top (or other sampling window), the system may sample the relevant quantities (e.g., gate-referenced current, clamp voltage) to form individual IV data points. Repeating the pulse sequence while sweeping the gate amplitude enables extraction of transfer characteristics (Id-Vg) under pulsed conditions; maintaining the drain at ground can support threshold-voltage or gate-charge-related measurements with minimal self-heating.

In the arrangement of FIG. 27B, the force leads establish potential nodes at the DUT gate and drain that are coupled to corresponding testing pins, and the dotted timing mark represents a trigger derived from a system clock. The mode switch in the gate-drive channel can select a pulse resource so that the gate potential node receives a pedestal-biased pulse train; a high-speed switch within the pulse resource may select between a shaping branch that may include a pulse generator and PGA and a sampling/verification branch used for pulse monitoring. By reconfiguring switches associated with pulse resource, the test channels can be assignable as a pulse channel and their operations can be phase-aligned to the system-clock trigger to support simultaneous pulse delivery and synchronized measurement (either voltage or current measurement) consistent with the disclosed architecture.

The arrangement of FIG. 27B complements the configuration of FIG. 27A. Whereas FIG. 27A employs Pulsed I-V Remote Sense (PIV RS) modules on the drain and gate paths to deliver and measure fast pulses with remote sensing, FIG. 27B illustrates a simplified ground-clamped topology in which additional channels provide dedicated ground or DC-bias references to device terminals while a separate channel supplies the pulsed gate drive. In some embodiments, PIV RS modules may also be inserted in the CH0 and/or CH1 paths of FIG. 27B to add remote sense, current-sense resistors, impedance matching, and protection features similar to those described with respect to FIG. 27A, while preserving the ground-clamped operating mode shown here.

In the configuration of FIG. 27B, the system can designate any of the available test channels as a ground unit. Because this role assignment can be performed within the test system, the user need not add external modules or modify the probe card to perform stress measurements such as NBTI (e.g., gate stress with source/body/drain clamped). The ground units provide the required clamps while another channel supplies the programmed gate pulse or bias. As a result, voltage errors during pulse testing due to IR drop in cables, probe contacts, or the on-resistance (R_on) of internal switches are substantially eliminated at the DUT terminals, yielding accurate stress conditions and repeatable NBTI results without fixture changes.

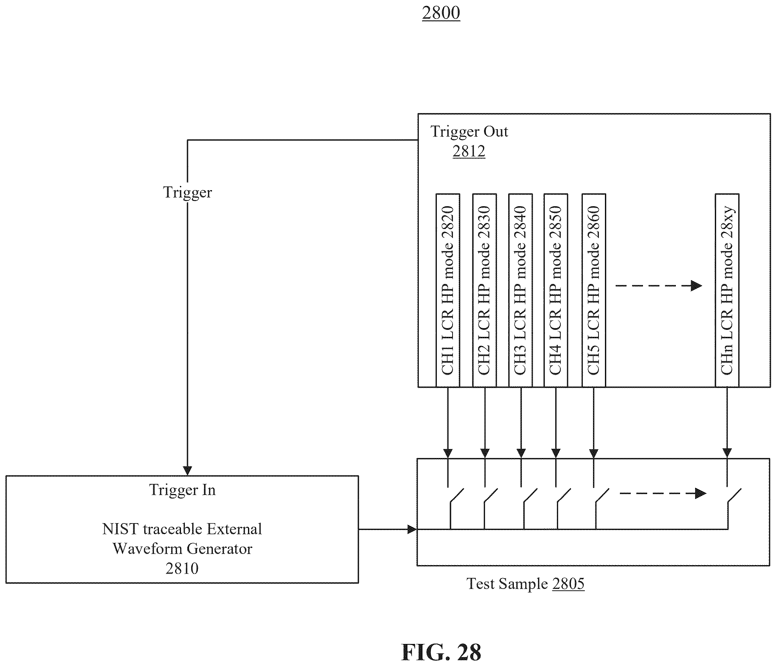

FIG. 28 illustrates a calibration block diagram 2800 according to an embodiment of the present disclosure. In block diagram a trigger out block 2812 may transmit signals to a trigger in block 2812, and both of these may be connected to a test of calibration sample 2805. Test channels 2820, 2830, 2840, 2850, 2860 may be configured in CH1 LCR HP mode, CH2 LCR HP mode 2830, CH3 LCR HP mode 2840, CH4 LCR HP mode 2850, CH5 LCR HP mode 2860, and a representative CHn LCR HP mode 28xy. The system may assert a hardware synchronization signal on trigger out block 2812 and route it to trigger in generator 2810, which may be implemented as an external waveform generator 2810. Receipt of the trigger by trigger in generator 2810 may start a sine source that is phase-locked to the system clock.

The output of the external generator 2810 may be routed through a system-controlled switching network that sequentially connects the reference signal to each channel under calibration. In some embodiments, the calibration may be sequential. For example, dashed arrows in FIG. 28 indicate the progression of this per-channel handoff. When a given channel is selected, the LCR high-potential measurement node may digitize the applied sine and the on-board signal processing may estimate amplitude and phase, for example by coherent detection or FFT. The measured values may be compared to the known reference from the external source in order to compute a per-channel gain correction and a phase offset.

Calibration may be performed at multiple frequencies and at several input levels to cover the intended operating range. The gain and phase corrections obtained for each channel and frequency point may be stored in non-volatile memory associated with that channel and automatically applied during normal measurements. The same arrangement may be used for periodic self-verification in production, allowing the system to refresh correction tables to compensate temperature shifts and long-term drift.

Moreover, each of the HP mode test channels (2820-28x0) can be arranged with measurement paths to receive the reference sine waveform from the external generator as well as generate its own measurement of the AC voltage, capturing both amplitude and phase. The routing block may include switches for each channel that select the calibration input. In this configuration, each channel can compare its internal sense (amplitude/phase) measurement against the external reference to determine offset, gain, and phase error. In this configuration, test channels in HP mode share a synchronized system clock and common reference, so that the calibration of amplitude and phase is consistent across channels. Proper calibration ensures that when the DUT is later driven by AC signals in LCR mode, the internal phase and amplitude response of each channel is known and can be corrected.

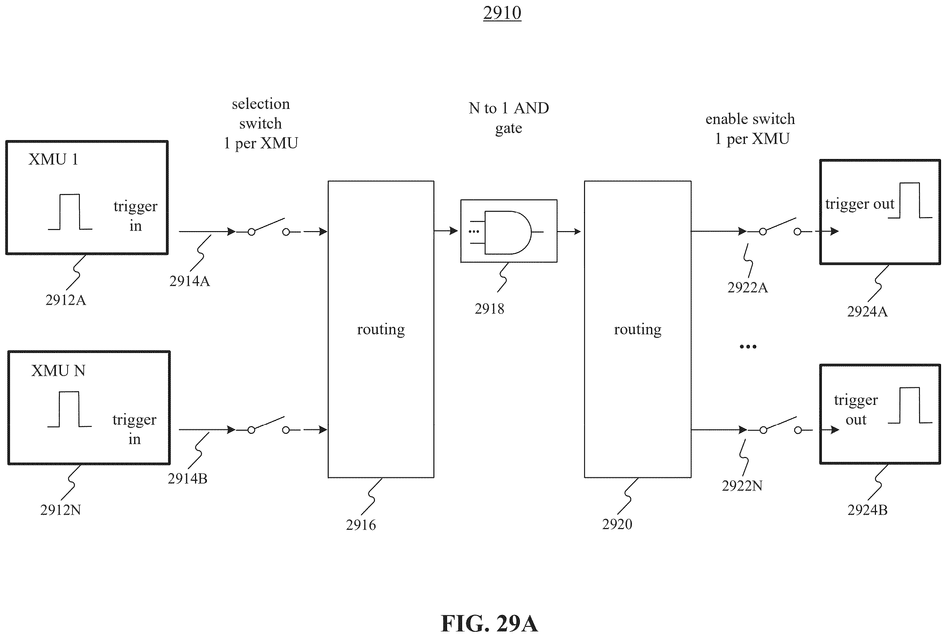

FIG. 29A illustrates a schematic 2910 of a first grouped trigger implementation according to an embodiment of the present disclosure. FIG. 29A illustrates an example implementation of a trigger-group circuit that provides hardware synchronization between multiple channel modules. The figure shows two representative channels, but the structure can scale to many more.

As shown in FIG. 29A, each channel module can connect to a trigger hub through an XMU interfaces 2912A-2912N. For example, XMU interface 2912A generates a trigger-in signal generated locally by the corresponding test channel (for example, when that channel reaches a particular point in its test routine). Between each XMU interfaces 2912A-2912A N and the hub fabric there are selection switches 2914A-2914N. Selection switches 2914A-2914N determine whether the trigger-in from that channel participates in the current trigger group; closing the switch includes the channel in the group, and opening the switch excludes it. The selected trigger-in signals are delivered into a first routing network 2916, which can steer the signals to any desired input position of a logic AND gate 2918. This first routing network allows flexible mapping between physical channels and the inputs of the group logic without rewiring.

The logic AND gate 2918 can receive up to N trigger-in signals for the group and produces a single group trigger candidate. Logic AND gate 2918 output becomes active when participating XMU interfaces 2912A-2912N in that group has asserted its trigger-in, so the gate effectively implements a barrier synchronization across those channels. The output of AND gate 2918 is then passed into a second routing network 2920. This second routing network can replicate or distribute the group trigger to one or more destinations, for example to different subsets of channels or to multiple physical locations on the test head.

Each channel can have an enable switch 2922A-2922N and a trigger interface 2924A-2924N. Enable switches 2922A-2922N may determine whether the group trigger carried by the second routing network 2920 is forwarded to that particular channel's trigger interface 2924. When the enable switch is closed, the trigger interface 2924 presents a trigger-out signal to the associated XMU, indicating that all members of the group have reached the synchronization point. When the enable switch is open, the channel can ignore the group event and continues to operate independently. By independently controlling the selection switches 2914 and enable switches 2922, the system can form arbitrary trigger groups and specify which channels both contribute to and receive the resulting trigger-out events, providing fine-grained control over synchronization behavior.

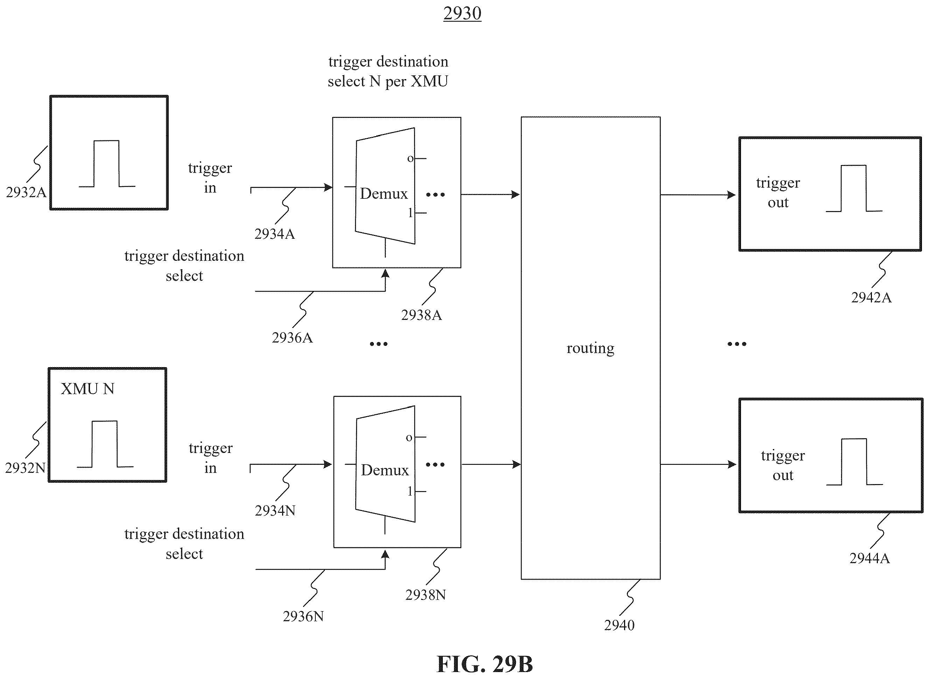

FIG. 29B illustrates a schematic 2930 of a second grouped trigger implementation according to an embodiment of the present disclosure. FIG. 29B illustrates a trigger-distribution circuit that allows each channel to direct its trigger event toward a selected destination, rather than only into a fixed group. The figure shows two representative channels, but the structure can scale to many more.

Each channel can connect to the trigger hub through an XMU interface 2932A-2932N. This interface is similar to the XMU interface used in FIG. 29A and generates a trigger-in signal 2934 produced locally by the channel hardware. In some implementations, XMU interfaces 2932A-2932N can also latch a status bit when a trigger occurs, allowing the channel processor to poll or clear the event.

Each trigger-in signal 2934 can be paired with a trigger select signal 2936. Trigger select signal 2936 may indicate which downstream destination or logical group should receive the event generated by that particular channel. The select value can be a simple binary control that chooses between two destinations, or it can be a multi-bit field that identifies any of several trigger buses, logical groups, or measurement subsystems. The select information may be written by the host processor at the beginning of a test step, or updated dynamically by the channel processor as the local program advances, allowing the same physical channel to direct its triggers to different consumers over time.

Trigger-in signal 2934 and trigger select signal 2936 may feed a demultiplexer 2938A-2938N. This demultiplexer can steer the trigger event onto one of several internal lines, depending on the select value. In a straightforward implementation, demultiplexers 2938A-2938N can be digital logic block in an FPGA or ASIC that converts a single input plus select bits into multiple one-hot outputs. An alternative is to use a small analog switch matrix or pass-gate tree controlled by configuration registers, which can provide very low propagation delay for high-speed triggers. Regardless of the realization, the demultiplexer 2938A-2938N can enable each channel to choose where its trigger propagates, which is useful when different portions of a test sequence should synchronize different sets of channels.

Outputs from the channel-side demultiplexers 2938A-2938N can be inputted in routing network 2940. Routing network 2940 can collect the selected trigger lines from all channels and delivers them to appropriate destinations, which may include group logic, other channels, or external trigger outputs. In one design, routing network 2940 can be implemented as a hierarchical bus structure in an FPGA, where each demultiplexer output connects to one of several trigger buses that fan out across the device. In another design, routing network 2940 can be a matrix of wired-OR lines and repeaters that allow triggers to be OR-combined along rows and columns. The routing network may also include buffers to equalize delay, configurable delay elements to fine-tune timing alignment, or priority encoders to resolve simultaneous events. By centralizing routing in routing network 2940, the system can support flexible trigger topologies-such as point-to-point signaling from one channel to another, fan-out from one channel to many, or multi-stage routing where a trigger first reaches a local cluster and then propagates to a global bus.

Each destination channel can include a trigger interface 2942. The routing network 2940 delivers a selected trigger signal to that interface, which then presents a trigger-out event toward the corresponding XMU or channel processor. In one implementation, the trigger interface 2942 includes synchronizers and edge detectors that convert the incoming level into a clean pulse in the channel's local clock domain. In other implementations, it may support programmable pulse width, polarity inversion, or filtering to reject spurious glitches. The trigger interface 2942 can expose status bits or interrupts to the channel processor, so that software can either poll for triggers or respond immediately via interrupt service routines. In systems with multiple logical trigger types, the interface may also decode a small field encoded on the trigger line-such as different voltage levels or short multi-bit sequences-to distinguish between start, sync, and error events.

The structure of FIG. 29B can allow each XMU interface 2932 to select, through its trigger select signal 2936 and demultiplexer 2938, which destination within the routing network 2940 should receive its trigger. The routing network then carries these events to the appropriate trigger interfaces 2942, which deliver trigger-out signals to the destination channels.

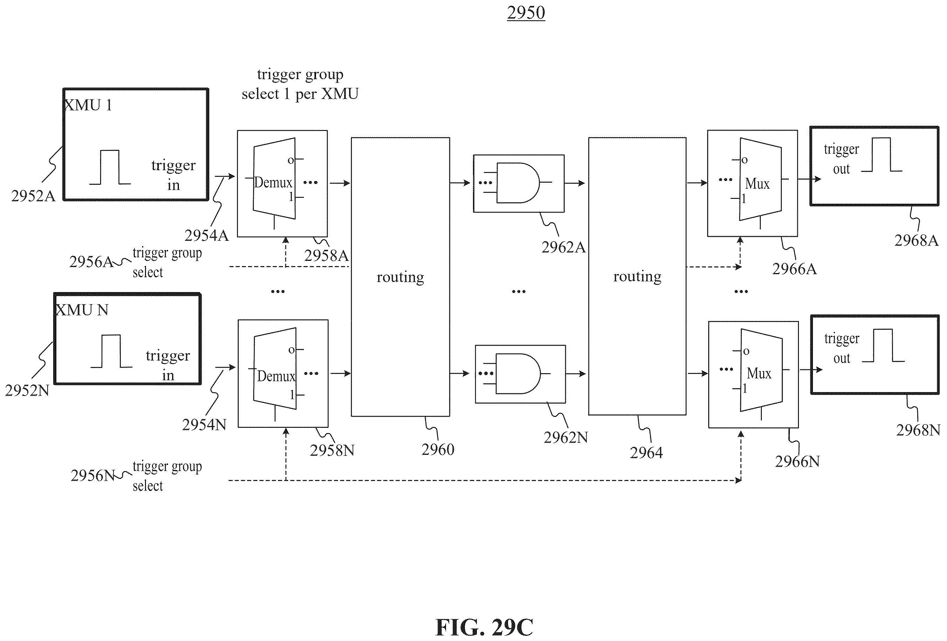

FIG. 29C illustrates a schematic 2950 of a third grouped trigger implementation according to an embodiment of the present disclosure. FIG. 29C illustrates a trigger-group circuit that supports multiple AND-type trigger groups in parallel. This architecture allows different sets of channels to wait on different synchronization events at the same time, overcoming the limitations of prior designs. The figure shows two representative channels, but the structure can scale to many more.

Each test channel connects to the hub through an XMU interface 2952A-2952N. XMU interface 2952A can generate a local trigger-in signal 2954 for that channel, for example when a channel processor finishes a measurement or reaches a particular step in its test sequence. The interface may condition the edge, stretch narrow pulses, and synchronize the trigger-in to a local clock so that the central logic sees a clean digital event.

Each channel can also provide a trigger select signal 2956A-2956N that indicates which trigger group the channel belongs to for the current step of the test. This select information can be a small field stored in a configuration register for each channel, or it can be written dynamically by the host or by the channel processor as the test routine progresses. The select value feeds demultiplexers 2958A-2958N associated with that channel. In one implementation, demultiplexers 2958A-2958N are implemented as FPGA logic blocks that steer the trigger-in signal 2954 onto one of several internal group lines, one per trigger group. In another implementation, demultiplexers 2958A-2958N may be realized as a bank of pass-gate switches or a small on-chip crossbar, giving very low propagation delay. Because the demultiplexers are individually programmable, each channel can be assigned to any group, and those assignments can change between different test phases without re-wiring the hardware.

Outputs from demultiplexers 2958A-2958N can feed a first routing network 2960. This network can collect group-specific trigger lines from all channels and delivers them to the appropriate logic AND gates 2962A-2962N. For example, trigger lines that represent membership in "Group 0" are routed to one AND gate, while lines for "Group 1" are routed to another, and so on. The routing network 2960 may be implemented as a structured bus and crossbar within an FPGA, as a hierarchical tree of digital nets, and/or as a set of wired-OR segments buffered at the inputs of the AND gates. In some implementations, routing network 2960 may be implemented as a substantially fixed network (e.g., hardwired or otherwise specifically routed) and different operation configurations can be achieved with different configurations of demultiplexers 2958A-2958N to drive different predefined routes. Additionally, or alternatively, routing network 2960 can be implemented to let channel's trigger-in reach a desired or targeted AND group. In some embodiments, routing network 2960 can be configurable to permit a given channel's trigger-in event to be coupled to any or multiple AND groups (e.g., any selected AND destination) under control of configuration data. Therefore, in some embodiments, routing network 2960 can be preconfigured such that signals propagate along pre-established paths; in other embodiments, routing network 2980 can be dynamically configurable so that different logical destinations can be defined by configuration rather by pre-determined routes. First routing network 2960 can thus provide flexible, scalable connectivity between different groups, either as a fixed network configurable based on demultiplexer and/or switch configuration or as a dynamic network.

Each logic AND gate 2962A-2962N can correspond to a particular trigger group. When every channel assigned to that group asserts its trigger-in, the corresponding AND gate output becomes active, creating a group-ready signal for that group. Because there are multiple AND gates-one per trigger group-the system can evaluate several group conditions in parallel. This "multiple-group AND trigger" structure allows, for example, one set of channels to wait for all gate-related nodes to settle while another set waits independently for all drain-related nodes, enabling multiple synchronized events to be evaluated concurrently.

The outputs of the logic AND gates 2962 can then enter a second routing network 2964. This routing network distributes each group-ready signal to the channels that should receive it. In one design, second routing network 2964 can be bused structures where each group output drives a dedicated bus that can be tapped by any channel; in another design, second routing network 2964 is a programmable crossbar that allows group signals to be replicated or combined before they reach the outputs. The routing network can also include buffers or programmable delay elements to equalize propagation times between different physical locations within the test head.

Outputs of the second routing network 2964 can feed multiplexers 2966A-2966N associated with each channel. Each multiplexer selects which group-ready signal (if any) should be delivered to that channel's trigger interface 2968A-2968N. The selection control for multiplexer 2966 may reuse the same trigger select signal 2956A-2956N or may use separate destination-select bits, allowing a channel to contribute to one group while listening to a different group's trigger. Multiplexers 2966A-2966N can be realized as a small digital MUX inside the FPGA, a bank of tri-state drivers, or an analog switch matrix depending on the timing and level requirements.

Trigger interface 2968A-2968N can present a trigger-out signal toward the channel hardware. In some implementations, trigger interface 2968 includes synchronizers and edge-detection logic to convert the incoming group signal into a clean pulse in the channel's local clock domain. Each XMU interface 2952A-2952N can select a group via the trigger select 2956 and demultiplexer 2958, the first routing network 2960 aggregates trigger-in signals by group, the logic AND gates 2962 evaluate whether all members of each group have fired, second routing network 2964 distributes the resulting group-ready signals, and multiplexers 2966 and trigger interfaces 2968 deliver the appropriate trigger-out events back to the channels.

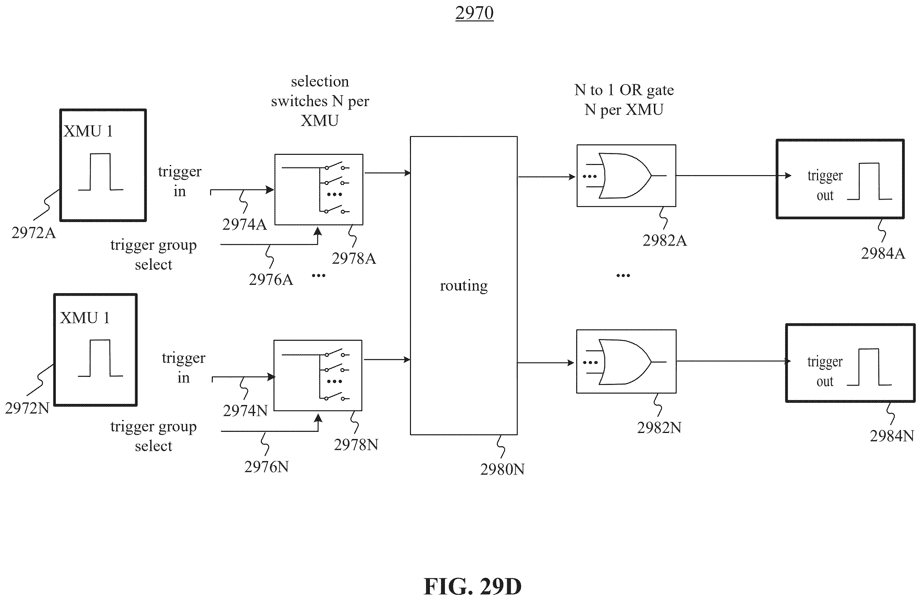

FIG. 29D illustrates a schematic 2970 of a fourth grouped trigger implementation according to an embodiment of the present disclosure. FIG. 29D illustrates an OR-type trigger distribution circuit that lets a channel direct its trigger event to selected peers and, conversely, lets a channel respond when any of several other channels fires. The figure shows two representative channels, but the structure can scale to many more.

Each test channel connects to the trigger hub through an XMU interface 2972A-2972N, similar to the XMU interfaces described earlier. The XMU interface can generate a local trigger-in signal 2974A-2974N from the corresponding channel. That trigger-in may represent events such as "measurement complete," "error detected," or "waveform started." The interface can clean up the signal (edge shaping, pulse stretching, level translation) so that downstream digital logic sees a robust, well-timed event.

Each channel can also supply a trigger select signals 2976A-2976N that defines how its trigger-in is distributed. The trigger select can be as simple as a few configuration bits loaded by the host at the start of a test, or it can be written dynamically by the channel processor as the test progresses. For example, during one phase of a wafer algorithm a channel may choose to wake only a small cluster of related channels; in another phase, it may choose to fan out to a larger set.

Trigger-in signals 2974A-2974N and trigger select signals 2976A-2976N can feed selection switches 2978A-2978N associated with that channel. The selection switches can steer the trigger pulse onto one of several internal lines that represent potential destinations or "OR groups." In one implementation, selection switches 2978 can be digital logic blocks in an FPGA that generates one-hot outputs from the selected trigger; in another, it can be a set of pass-gate switches or transmission-gate networks that offer very low propagation delay for high-speed triggers. This per-channel selection logic specifies which channels may ultimately be triggered by that channel, because it determines which OR gate and downstream distribution path will see the event. Further, in some implementations multiple ones of selection switches 2978A-2978N may be enabled at the same time. For example, a given trigger-in event on a channel can be configured to close two or more of the selection switches 2978A-2978N concurrently so that the trigger pulse is driven onto multiple OR-group lines, thereby causing multiple downstream OR gates 2982A-2982N (and associated trigger-out paths) to assert in response to the single trigger-in pulse (e.g., to synchronously trigger multiple XMUs, to broadcast a timing reference, or to initiate multiple concurrent operations from one source event).

Outputs of the per-channel selection switches 2978A-2978N can be collected by a first routing network 2980. The routing network aggregates all of the selected lines and delivers them to logic OR gates 2982, typically arranging that all signals belonging to the same OR destination feed the same OR gate. The routing network 2980 can be implemented as a bused interconnect in an FPGA, a wired-OR structure with buffers, and/or a crossbar fabric that allows flexible mapping of sources to OR inputs. In some implementations, routing network 2980 may be implemented as a substantially fixed network (e.g., hardwired or otherwise specifically routed), and different operational configurations are achieved by enabling different ones of the selection switches 2978A-2978N to drive different predefined routes. Additionally, or alternatively, routing network 2980 can let channel's trigger-in reach any desired OR group. In some embodiments, routing network 2980 can be configurable to permit a given channel's trigger-in event to be coupled to any of multiple OR groups (e.g., any selected OR destination) under control of configuration data. Therefore, in some embodiments, the routing network 2980 is preconfigured such that signals propagate along pre-established paths; in other embodiments, the routing network 2980 is dynamically configurable so that different logical destinations can be defined by configuration rather than fixed wiring.

Further, logic OR gates 2982A-2982N can correspond to a particular destination group. When any of the inputs to a given OR gate assert, the OR gate output becomes active. That output drives a trigger interface 2984A-2984N associated with one or more channels. From the perspective of a destination channel, the trigger interface 2984A-2984N outputs a trigger-out signal whenever selected source channel in the group has fired. The trigger interface can include synchronizers and edge detectors that convert the incoming level into a clean pulse in the destination channel's clock domain. It may also provide programmable polarity or pulse width so that the event can be interpreted by firmware as "start," "advance," "abort," or some other action. In some implementations, the same destination channel can connect its trigger interface 2984 to more than one OR gate over time by changing configuration bits, allowing it to wait on different groups of source channels during different phases of the test.

OR gates 2982A-2982N and per-channel selection logic-implemented by trigger select 2976 and selection switches 2978-to determine which channels may be triggered by a given source channel. A source channel's XMU interface 2972 can generate a trigger-in signal 2974; the selection switch 2978 can steer that event to the appropriate destination line in routing network 2980; OR gates 2982 can combine such events for that destination; and the trigger interface 2984 presents a trigger-out to the receiving channel or channels.

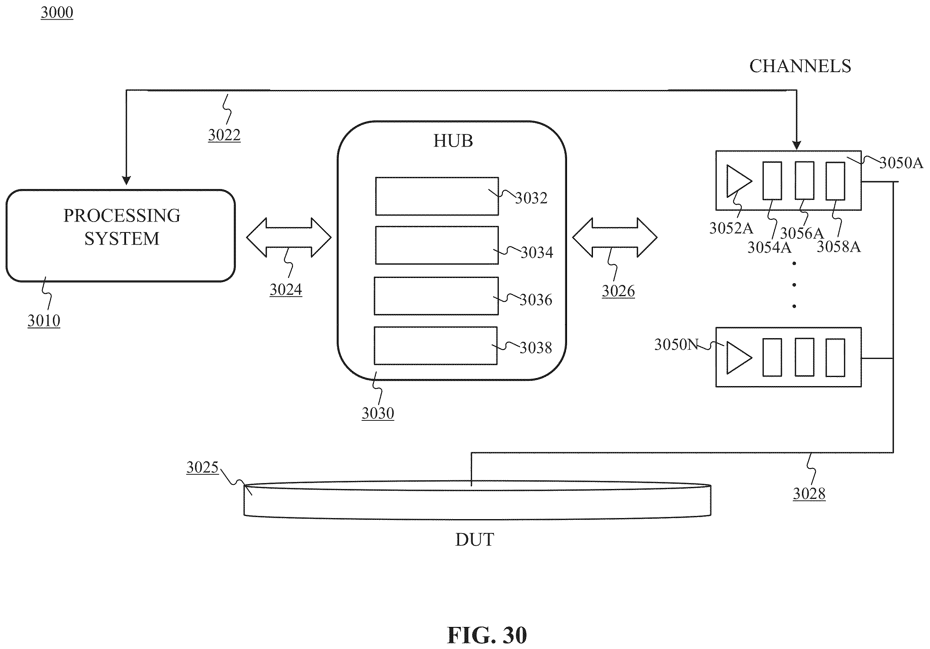

FIG. 30 illustrates a block diagram of a system 3000 including a hub for trigger groups and per-channel processing according to an embodiment of the present disclosure. FIG. 30 shows how a host-side processing system 310, a hub device with trigger logic, and multiple test channels 3050 cooperate to test a device under test (DUT) 3025 with tight hardware-level synchronization.

A processing system 3010 may be implemented as the main controller for the tester. In different implementations this element may be a rack-mounted PC, an industrial controller, a PXI embedded computer, or a system-on-module inside the test head. The processing system can run test development software and a runtime engine that receives a high-level testing routine describing the sequence of measurements, bias conditions, and synchronization points for a wafer or lot. The testing routine can be expressed in a scripting language, a compiled program, or a graphical test flow.

A first connection 3022 links the processing system 3010 to a hub 3030, which as discussed in connection with FIG. 9 can be implemented as hardware configurable to schedule and coordinate measurement sequences; align triggers and clocks across resource boards; perform configuration, discovery, and initialization operations (e.g., enumerating resource boards and loading profiles and/or calibration data); execute calibration routines; and/or implement data routing during measurements. First connection 3022 may be a high-speed digital bus such as PCI Express, PXI backplane lines, Ethernet, or a proprietary serial link. Over this path the host can download trigger-group definitions, write configuration registers in the hub, and read back status or error information. A second connection 3024 couples processing system 3010 to channels 3050. In various embodiments, second connection 3024 carries program code and parameter tables that the host compiles from the testing routine and then loads into per-channel memory structures 3056. The second connection can share the same physical backplane as the first connection or can be a separate control bus optimized for bulk code transfers.

A third connection 3026 extends between hub 3030 and channels 3050. This path carries trigger-related signals both from the channels into the hub and from the hub back out toward the trigger interfaces 3052. Third connection 3026 can be a set of differential trigger lines on a test-head backplane, LVDS links into an FPGA, or cables that connect a trigger module to remote channel cards.

A fourth connection 3028 connects the channel testing circuits 3058 in channels 3050 to the DUT 3025 through a probe card or socket. Each test channel may drive and sense a dedicated pin on the DUT, consistent with per-pin SMU architectures that avoid large analog switch matrices and enable true parallel testing.

Hub 3030 is depicted as a block containing logic gates 3032, configuration registers 3034, multiplexers and demultiplexers 3036, and hub memory 3038. In many implementations hub 3030 can be implemented by a field-programmable gate array (FPGA) clocked from a system clock. The FPGA fabric can host AND and OR logic, programmable routing networks, and small on-chip memories.

Logic gates 3032 can perform digital operations on trigger signals. Some of these gates implement AND behavior: they monitor trigger-in signals from a selected set of channels and produce an output when all of those inputs are active. This enables barrier-type synchronization, where multiple channels must all reach a given point before any proceeds. Other gates in 3032 implement OR behavior: they assert their output when any of several inputs is active. In an FPGA implementation, the gates 3032 may be realized as lookup tables arranged into small trees; in a discrete implementation they may be constructed from standard logic devices.

Configuration registers 3034 store control bits that define how the hub behaves. For example, some registers hold masks indicating which channels belong to each trigger group. A mask might have one bit per channel; a bit value of "1" means that the corresponding channel participates in that group, and "0" means it does not. Other registers can select whether a group uses AND or OR behavior, set priorities when several groups fire simultaneously, or specify how triggers are encoded into multi-bit codes. These registers are written by the processing system 3010 over connection 3022 and can be updated whenever a new test plan or DUT configuration is loaded.

Multiplexers and demultiplexers 3036 provide routing flexibility between the channels and the logic gates. As further discussed in connection with FIGS. 29A-29D, demultiplexers in hub 3030 can steer each channel's trigger-in line onto one of several internal buses that feed different groups of logic gates 3032. For example, a given channel can be assigned to group 0 during one step of a test sequence and to group 3 during a later step, simply by changing configuration bits that control its demultiplexer. On the outbound side, multiplexers can distribute each group's logic output to selected channels as trigger-out signals. These routing elements can be built from FPGA fabric (for example, configurable crossbar structures) or from small analog switch matrices.

Hub memory 3038 may serve as shared storage that both the channels and the processing system can access. This memory may be used to hold global variables such as test limits, shared measurement results, or flags that describe whether a given stage of the test has completed. In one embodiment, hub memory 3038 can be a dual-port RAM block inside the FPGA used for the hub, with one port connected to the host over 3022 and the other port connected to channel processors 3054 over 3026. In another embodiment, hub memory 3038 can be an external SRAM device with an arbiter that grants access in turn to the host and to the channels.

Channels 3050 can be configured to carry out the actual electrical tests at the DUT. They can be implemented as the sense-force channels, test pins, and/or lines discussed in connection with the previous figures (e.g., Channel 912 in FIG. 9, test pin 1017 in FIG. 10, and/or sense 1101 in FIG. 11).

As discussed previously in greater detail, each channel may be connected with different measuring units (e.g., SMU 1110 and FMU 1130) and be associated with different circuitry and cards (e.g., FIG. 12, 13, 18-28). And each one of these components can be generalized as illustrated in FIG. 30 in which channels 3050 include a trigger interface 3052, a channel processor 3054, per-channel memory 3056, and a testing circuit 3058.

Trigger interfaces 3052 can connect directly to the third connection 3026. Each trigger interface can send trigger-in pulses to the hub 3030 and receive trigger-out events from the hub. Inside the trigger interface there may be synchronizers that align incoming trigger edges to the channel's local clock, edge detectors that convert level changes into single pulses, and decoders that interpret multi-bit trigger codes.

The per-channel processors 3054 can execute test routines specific to each channel. These processors may be microprocessors, microcontrollers, soft cores synthesized in an FPGA, or custom state machines. They may fetch instructions and data from their corresponding per-channel memories 3056. Typical tasks for a channel processor include configuring the testing circuit 3058 (for example, selecting voltage or current ranges), initiating force or sense operations, waiting for trigger events from the hub, and performing computations on measured values. For example, a processor might read a current measurement, compare it to a threshold, adjust the forced voltage based on the result, and then decide whether to send a trigger-in pulse to indicate that its step is complete.

Per-channel memory 3056 may store code and data for the channel processors. Before testing begins, the processing system 310 compiles the high-level testing routine into separate channel routines and loads them into these memories over connection 3024. This allows the channels to run complex algorithms locally, such as stepping a bias in small increments, performing multiple measurements at each step, and computing averages or derivatives, while only occasionally reporting condensed results back to the host.

Testing circuits 3058 form front ends that connect the channels to the DUT 3025 through fourth connection 3028. As further discussed previously, a typical testing circuit may include a source/measure unit capable of forcing voltage or current and measuring the complementary quantity, a pulse generator for transient or stress testing, and range switches that select between high-current and low-current measurement paths. A mode switch can connect different resources to a potential node at the test pin, allowing the channel to switch electronically between pulse mode, high-potential measurement, and low-potential measurement without external relays.

During operation, processing system 3010 can receive a testing routine that describes how to characterize a DUT 3025. The host can analyze the routine, determine which channels will be used and what roles they play, and generates code for each per-channel processor 3054. This code can be loaded into the per-channel memories 3056 over connection 3024. The host also programs configuration registers 3034 over connection 3022 to define trigger groups in the hub 3030. For example, three channels might be grouped so that their trigger-in signals feed an AND gate inside block 3032. When any of those channels reach a certain step-such as having applied the correct bias or finished a measurement-they send a trigger-in pulse through their trigger interface 3052. The hub's routing and logic combine those pulses, the AND gate output goes high and the routing logic sends a trigger-out pulse back to the same channels. Their processors see the event and advance to the next stage, such as sampling a current or changing a voltage.

In another example, several channels are configured through so that their trigger-in signals drive an OR gate in block 3032. When any one of those channels detects an error condition-such as a leakage threshold being exceeded-it asserts a trigger-in. The OR gate output becomes active immediately, and the routing logic forwards that output as a trigger-out to a larger set of channels and optionally back to the processing system 310. Those channels can then suspend their current operations, log an error, or reset their state machines. At the same time, the channel that detected the error can write diagnostic data into hub memory 3038, where other channels or the host can read it.

These examples illustrate how the elements in Figure 30 can work together in a system: processing system 310 defines the overall behavior, hub 3030 with its logic gates 3032, configuration registers 3034, multiplexers/demultiplexers 3036, and hub memory 3038 coordinates timing and shared data, and the channels 3050 with their trigger interfaces 3052, processors 3054, memories 3056, and testing circuits 3058 carry out the detailed electrical measurements at the DUT 3025.

For example, in one implementation shown in FIG. 30, a test system 3000 includes a processing system 310 that receives a testing routine and communicates control information over a first connection 3022 and a second connection 3024. The system further includes multiple test channels 3050, each having a channel processor 3054 that executes test code stored in a per-channel memory 3056, a testing circuit 3058 coupled through a test pin and a fourth connection 3028 to a DUT 3025, and a trigger interface 3052 coupled to a third connection 3026. Hub 3030 can be coupled between the processing system 310 and the trigger interfaces 3052 and contains programmable logic gates 3032, configuration registers 3034, and multiplexers/demultiplexers 3036. Hub 3030 associates at least two trigger interfaces 3052 into a trigger group and logically combines their trigger-in events to generate trigger signals that are returned to the channels, where the channel processors 3054 advance their operations in accordance with the testing routine and the received trigger signals.

In some implementations, hub 3030 uses OR behavior to generate trigger-out signals. Trigger-in events from selected trigger interfaces 3052 are routed into logic gates 3032 configured as OR gates. When any participating channel asserts its trigger-in, the OR gate output becomes active, and multiplexers/demultiplexers 3036 forwards a trigger-out signal to the relevant trigger interfaces. Processing system 3010 can treat trigger groups as reusable resources. Software on the processing system maintains a pool of group identifiers, picks an available identifier when preparing a testing routine, and programs hub 3030 via configuration registers 3034 so the selected group associates specific trigger interfaces 3052. Once testing of the DUT 3025 is complete, processing system 3010 clears the configuration for that group and returns its identifier to the pool, allowing other routines to reuse the same hardware group definitions efficiently.

Within each channel 3050, per-channel processor 3054 can control both measurement and stimulus locally. A program running on the processor initiates a sense operation through the testing circuit 3058, acquires a measurement value, and performs arithmetic or comparison operations on that value. Based on the result, the code may branch or loop to refine a bias point or search for a threshold. The processor then adjusts voltages, currents, or pulse parameters in the testing circuit 3058 without waiting for new commands from the processing system 310, reducing communication overhead and enabling fast, adaptive test sequences at the pin. Each channel can include its own memory 3056 for code and data. When a testing routine is defined, the processing system 3010 compiles it into channel-specific programs, determines which channels are needed for a given DUT configuration, and downloads the corresponding programs over connection 3024 into the memories 3056 of those channels before testing begins. With their programs preloaded, channel processors 3054 execute the specified operations locally, including synchronization waits via the trigger interfaces 3052, while unused channels remain idle or run minimal routines.

Channel routines stored in memories 3056 can instruct processors 3054 to perform sense and force operations, as well as local processing. For example, a routine may command the testing circuit 3058 to force a voltage or current, then perform a sense operation to acquire a measurement from the DUT 3025. The processor can process the measurement to compute a local result, such as an average or limit comparison, and then report a compact value or status back to the processing system 310, rather than sending raw data for every sample.

In some designs, hub 3030 can include hub memory 3038 that is accessible to both the channel processors 3054 and the processing system 3010. This memory can hold global variables such as test limits, measured reference values, or flags marking completion of shared steps. Channels read and write these values via the third connection 3026, allowing them to coordinate with one another by sharing small pieces of state without involving the host for every decision. Further, testing circuits 3058 can use a potential node tied to each test pin of the DUT 3025. Further, in some embodiments, hub 3030 encodes trigger information into multi-bit codes rather than simple single-bit pulses. Logic gates 3032 and multiplexers/demultiplexers 3036 generate codes that distinguish, for example, a synchronization event based on an AND combination, a broadcast event based on an OR combination, and an error event.

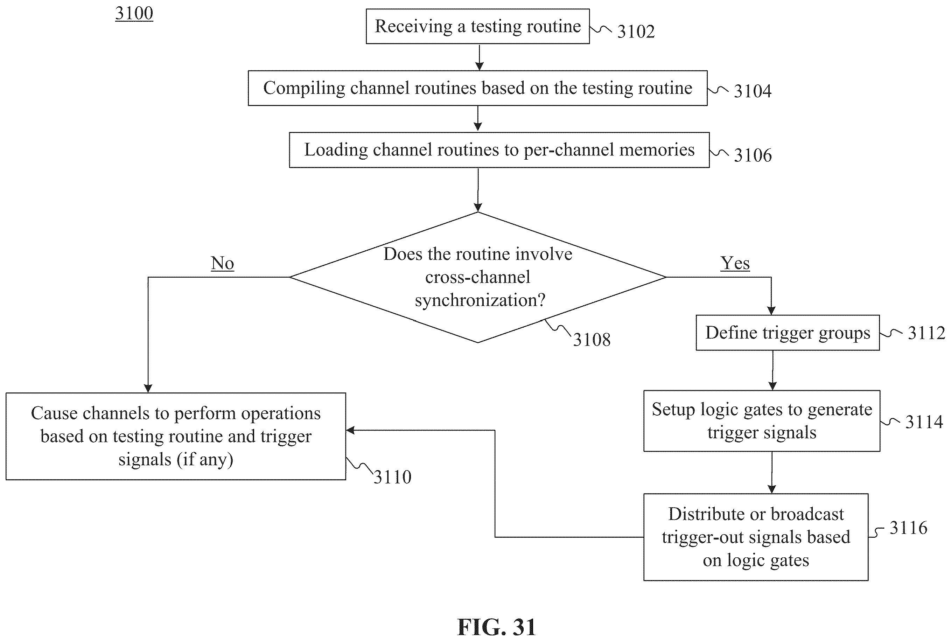

FIG. 31 illustrates a flow chart of a method 3100 for configuration of a testing system according to an embodiment of the present disclosure. Method 3100 may be executed by one or more processors. For example, method 3100 may be executed by elements in system 100. For example, method 3100 may be performed by processing system 711, processor 1230, or other processing devices discussed herein. Alternatively, or additionally, while in some embodiments all steps may be performed by the same processing system, in other embodiments different steps in method 3100 may be performed by different systems. For example, certain steps in method 3100 may be performed by processor system 811 or channel 1100 while others may be performed by other elements in processing system 711.

In step 3102, a processor may receive a testing routine. The routine may be supplied as a script, compiled binary, or graphical test plan and can specify, for example, which DUT 3025 terminals to be connected to which channel testing circuits 3058, what bias waveforms to apply, which measurements to take, and where cross-channel synchronization is required. For example, processing system 3010 can parse this routine into an internal representation that identifies, for each logical DUT pin, the corresponding hardware channel within the channels 3050, and notes any steps that require the hub 3030 to coordinate multiple trigger interfaces 3052.

In step 3104, a processor may compile channel routines based on the testing routine. For example, using the mapping created in step 3102 a processor can generate a separate instruction sequence for each channel processor 3054. These sequences contain low-level commands to configure the associated testing circuits 3058 (for example, selecting ranges, setting force levels, or enabling pulse resources), to interact with the local trigger interface 3052 (for example, issuing "wait for trigger" or "send trigger" operations), and to perform arithmetic or logical operations on measurement data stored in the per-channel memories 3056. As part of compilation, the processing system may insert explicit synchronization points wherever the routine indicates that several channels must align in time, marking those points with metadata that will later drive hub 3030 configuration.

In step 3106, a processor may load routines. For example, processing system 3010 may load channel routines into per-channel memories 3056. Processing system 3010 may transmit the compiled code and associated constants over the second connection 3024 to the channels 3050. Each channel's memory 3056 receives only the code relevant to that channel's role (for example, "gate," "drain," "source," or "monitor" for a given DUT 3025), while unused channels receive a small idle program that keeps their testing circuits 3058 in a safe state. In some implementations, the processing system 3010 also writes initialization data into hub memory 3038 at this stage, such as global thresholds or shared limits that channel processors 3054 may later read over the third connection 3026.

In step 3108, a processor may determine whether the testing routine involves cross-channel synchronization. For example, processing system 3010 may examine the compiled routines and metadata to see if any channel program uses trigger-wait instructions tied to group identifiers or if any step explicitly requires simultaneous action across multiple test channels 3050. If no such requirements are found (step 3108: No), the processor may proceed directly to step 3110, with the channels operating largely independently. If the routine involves cross-channel synchronization (step 3108: Yes)-such as when several testing circuits 3058 must reach specific bias conditions before a measurement or when multiple pins must be pulsed together-the processor may continue to step 3112.
In step 3112, a processor may define trigger groups. For example, based on metadata used during compilation, processing system 3010 can decide which trigger interfaces 3052 should be grouped together. For example, it may assign the channels attached to the gate, drain, and source testing circuits 3058 of a transistor to a first group, and the channels biasing a reference structure to a second group. The processing system then programs configuration registers 3034 in the hub 3030 over the first connection 3022 so that each group is associated with a set of channel identifiers and, optionally, with an indication of whether the group's logic in block 3032 should be AND- or OR-based. Moreover, in step 3112, a processor may compile channel routines associated with the testing routine, identify channels from the plurality of test channels relevant to the testing routine; and load the channel routines into the per-channel memories associated with the identified channels. In some implementations, identifying the relevant channels includes resolving logical pin names and roles in the testing routine (for example, "Gate1," "Drain1," "Source1," or "RefBias") to physical DUT pins and then to specific hardware channels that have the required testing circuits 3058 and ranges available. The processing system 3010 may consult a pin-map or site-map description that associates DUT pins with instrument channels and sites, filter out channels that are disabled or lack necessary capabilities, and generate a list of active channels that will participate in each group. For each such active channel, the processing system can tag its trigger interface 3052 with a group identifier, store that association in configuration registers 3034, and enable only those channels to execute the loaded routines and exchange trigger signals for the corresponding trigger group.

In step 3114, a processor may set up the logic gates to generate trigger signals. For example, logic gates within hub 3030 may get configured to generate trigger signals according to the defined groups. Using the values in the configuration registers 3034, the hub's multiplexers and demultiplexers 3036 route trigger-in lines arriving from the trigger interfaces 3052 (over the third connection 3026) to specific inputs of the programmable logic gates 3032. Hub 3030 may also configure small encoders so that the outputs of these gates not only assert a level but also carry a multi-bit code indicating the type of event, allowing the trigger interfaces 3052 and channel processors 3054 to distinguish between normal synchronization, broadcast, or error conditions.

In step 3116, a processor may be configured to distribute or broadcasts trigger-out signals based on the configured logic gates. For example, hub 3030 may distribute trigger out signals. The routing structures can be programmed so that each logic-gate output is delivered to the appropriate set of trigger interfaces 3052. In some cases, a group-ready signal from an AND gate in 3032 is broadcast back only to the channels that belong to that group, ensuring that their processors 3054 all proceed to the next stage of their routines at nearly the same time. In other cases, the output of an OR gate is routed to a broader set of channels or even to the processing system 310, for example to abort a test when any channel detects a fault. The routing ensures that these trigger-out signals travel over the third connection 3026 with predictable delays so that operations in the testing circuits 3058 can be synchronized at the DUT 3025.

In step 3110, a processor may cause channels to perform operations based on testing routine and trigger signals (if any). For example, processing system 3010 can issue a start command, causing each channel processor 3054 to begin running the program stored in its memory 3056. As the routines execute, the processors configure their respective testing circuits 3058, apply forces and pulses to the DUT 3025 through the fourth connection 3028, acquire measurements, and perform local computations while monitoring their trigger interfaces 3052. When a processor reaches a synchronization point, it can assert a trigger-in signal toward the hub 3030, then wait until a trigger-out event arrives from the same hub before continuing. This coordinated use of the processing system 310, hub 3030, and channels 3050 allows the method 3100 of Figure 31 to implement complex multi-pin test algorithms while still leveraging per-channel autonomy and hardware-level timing control.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only. It is also intended that the sequence of steps shown in figures are only for illustrative purposes and are not intended to be limited to any particular sequence of steps. As such, those skilled in the art can appreciate that these steps can be performed in a different order while implementing the same method.

This disclosure may be described in the general context of customized hardware capable of executing customized preloaded instructions such as, e.g., computer-executable instructions for performing program modules. Program modules may include one or more of routines, programs, objects, variables, commands, scripts, functions, applications, components, data structures, and so forth, which may perform particular tasks or implement particular abstract data types. The disclosed embodiments may also be practiced in distributed computing environments where tasks are performed by remote processing devices that are linked through a communications network. In a distributed computing environment, program modules may be located in local and/or remote computer storage media including memory storage devices.

The present technology includes computer-readable storage mediums for storing instructions, and systems for executing any one of the methods embodied in the instructions addressed in the clauses of the present technology presented below:
Clause i. A test system including:
   (a) a processing system configured to receive a testing routine;
   (b) a plurality of test channels including:
      (1) channel processors configured to execute tests,
      (2) testing circuits coupled to test pins configurable to be connected to a device under test (DUT), and
      (3) trigger interfaces coupled to the testing circuits; and
   (c) a hub device coupled to the processing system and to the trigger interfaces, the hub device including programmable logic gates;
   wherein:
   (d) the hub device is configured to define a trigger group including at least two of the trigger interfaces by configuring at least a portion of the programmable logic gates to logically relate the at least two of the trigger interfaces;
   (e) the hub device is configured to generate trigger signals according to the testing routine; and
   (f) at least a portion of the channel processors are configured to perform an operation according to the testing routine and in response to receipt, at a corresponding one of the trigger interfaces, of one or more of the trigger signals.
Clause ii. The test system of any of clauses i or iii, including:
   (a) trigger signals implemented as trigger-out signals;
   (b) the programmable logic gates including AND gates; and
   (c) the hub device including:
      (1) a plurality of demultiplexers configured to receive trigger-in signals from the test channels and coupled to inputs of the AND gates via a first routing module; and
      (2) a plurality of multiplexers configured to communicate the trigger-out signals and coupled to outputs of the AND gates via a second routing module.
Clause iii. The test system of any of clauses i or ii, including:
   (a) the programmable logic gates including OR gates;
   (b) the hub device including a plurality of selection switches configured to receive signals from the test channels, the selection switches being coupled to inputs of the OR gates via a routing module; and
   (c) outputs of the OR gates generating the trigger signals for the trigger group.
Clause iv. The test system of any of clauses i to iii, including:
   (a) trigger signals implemented as trigger-out signals;
   (b) the programmable logic gates including AND logic gates; and
   (c) the AND logic gates being configured to:
      (1) receive trigger-in signals from the test channels in the trigger group;
      (2) generate the trigger-out signals by combining the trigger-in signals such that the trigger-out signals are asserted after each test channel in the trigger group has asserted its trigger-in signal; and
      (3) distribute the trigger-out signals to at least a portion of the trigger interfaces.
Clause v. The test system of any of clauses i to iv, including:
   (a) the hub device including an FPGA coupled to a system clock; and
   (b) the hub device being configured to associate the DUT with at least a portion of the test pins to define the trigger group.
Clause vi. The test system of any of clauses i to v, including:
   (a) the hub device including a plurality of configuration registers storing positions associated with the test channels; and
   (b) the programmable logic being configured to define the trigger group based on the positions stored in the configuration registers.
Clause vii. The test system of any of clauses i to vi, including:
   (a) trigger signals implemented as trigger-out signals;
   (b) the programmable logic gates including OR gates; and
   (c) the OR gates being configured to:
      (1) receive trigger-in signals from the test channels in the trigger group;
      (2) generate the trigger-out signals by combining the trigger-in signals such that the trigger-out signals are asserted after at least one of the test channels in the trigger group has asserted its trigger-in signal; and
      (3) distribute the trigger-out signals to at least a portion of the trigger interfaces.
Clause viii. The test system of any of clauses i to vii, including a processing system configured to:
   (a) maintain a pool of available trigger groups;
   (b) allocate one of the available trigger groups to the testing routine;
   (c) provide the allocated trigger group to the hub device for configuration of the trigger group; and
   (d) return the allocated trigger group to the pool when testing of the DUT is completed.
Clause ix. The test system of any of clauses i to viii, including:
   (a) operations performed by the channel processors including at least one of a sense operation or a force operation; and
   (b) the channel processors being configured to:
      (1) perform at least one of arithmetic operations or logical comparisons on test values;
      (2) execute conditional branches and loops within a channel routine in response to the arithmetic operations or logical comparisons; and
      (3) adjust stimuli applied by the testing circuits without intervention from the processing system.
Clause x. The test system of any of clauses i to ix, including:
   (a) the test channels including per-channel memories; and
   (b) the processing system being configured to:
      (1) compile channel routines associated with the testing routine;
      (2) identify test channels relevant to the testing routine; and
      (3) load, prior to testing the DUT, the channel routines into the per-channel memories associated with the identified test channels so as to cause the channel processors to implement operations related to the testing routine.
Clause xi. The test system of any of clauses ix or x, including channel routines configured to cause a corresponding channel processor to at least one of:
   (a) acquire a measurement in a sense operation;
   (b) force voltage or current in a force operation; or
   (c) perform local data processing on the measurement to compute a local result and transmit the local result to the processing system.
Clause xii. The test system of any of clauses i to xi, including:
   (a) the hub device having a memory accessible to the channel processors and storing global variables; and
   (b) the channel processors being configured to read or write data values in the global variables.
Clause xiii. The test system of any of clauses i to xii, including testing circuits that each include:
   (a) a pulse resource;
   (b) a measuring resource including a high-current switch and a low-current switch; and
   (c) a mode switch coupled to the pulse resource, the measuring resource, and a potential node coupled to a testing pin;
   wherein:
   (d) the potential node is configured for pulse testing when the mode switch connects the pulse resource with the potential node;
   (e) the potential node is configured for high-potential testing when the high-current switch is closed and the mode switch connects the measuring resource with the potential node; and
   (f) the potential node is configured for low-potential testing when the low-current switch is closed and the mode switch connects the measuring resource with the potential node.
Clause xiv. The test system of any of clauses i to xiii, including:
   (a) programmable logic gates configured to encode the trigger signals as multi-bit trigger codes and to provide the trigger codes to the test channels via the trigger interfaces; and
   (b) channel processors configured to decode the multi-bit trigger codes, the multi-bit trigger codes including:
      (1) a first code corresponding to a first trigger event generated by an AND function;
      (2) a second code corresponding to a second trigger event generated by an OR function; and
      (3) a third code corresponding to an error event.
Clause xv. The test system of any of clauses i to xiv, including at least one of:
   (a) the processing system being configured to compile the testing routine and generate channel routines including trigger instructions that cause the channel processors to wait for trigger signals at points corresponding to operations of the testing routine with cross-channel synchronization;
   (b) the test channels including at least fifty test channel modules;
   (c) the trigger group including at least twenty trigger groups defined within the hub device; or
   (d) the hub device being configured to operate the trigger groups using the programmable logic gates to generate the trigger signals.
Clause xvi. The test system of any of clauses i to xv, including:
   (a) the processing system being configured to:
      (1) load channel routines into per-channel memory devices associated with corresponding channel processors; and
      (2) set a trigger mask between the hub device and the test channels; and
   (b) the channel processors being configured to start the channel routines upon receiving a triggering signal from the hub device.
Clause xvii. The test system of any of clauses i to xvi, including a testing routine that sets at least three of the test channels for testing the DUT, wherein:
   (a) a first test channel is configured as a gate node;
   (b) a second test channel is configured as a drain node;
   (c) a third test channel is configured as a source node; and
   (d) each of the first, second, and third test channels is configured to perform channel routines including a force operation, a sense operation, and a synchronization operation that is a function of the trigger signals.
Clause xviii. The test system of clause xvii or of any of clauses i to xvi when dependent on clause xvii, including channel routines that further include delay operations configured to allow a forced operation in one test channel to settle before a sense operation in another test channel begins.
Clause xix. A device including: (a) a first connection for coupling with a processing system; (b) a second connection for coupling with test channels; (c) a plurality of programmable logic gates; (d) a plurality of demultiplexers configured to receive trigger-in signals from the test channels and coupled to inputs of the programmable logic gates via a first routing module; (e) a plurality of multiplexers configured to provide a trigger-out signal and coupled to outputs of the programmable logic gates via a second routing module; and (f) a plurality of group configuration registers, each group configuration register storing a mask based on membership of the test channels in trigger groups.
Clause xx. A method for operating a parametric test system including a processing system, test channels, and a hub device, the method including:
   (a) receiving, at the processing system, a testing routine that specifies tests for a DUT;
   (b) compiling, by the processing system, the testing routine into channel routines to be executed by channel processors of the test channels;
   (c) loading the channel routines into memories associated with the channel processors;
   (d) configuring the hub device to define at least one trigger group including at least two trigger interfaces associated with at least two of the test channels;
   (e) generating, in the hub device, a trigger signal using programmable logic gates and inputs from at least one of the processing system or the test channels;
   (f) outputting, from the hub device, the trigger signal to the trigger group; and
   (g) causing the at least two test channels to perform operations in accordance with the testing routine and the trigger signal, wherein the channel routines include instructions causing the channel processors to wait for the trigger signal to synchronize operations of a test procedure based on the trigger groups.

## Claims

1. A test system comprising:
a processing system configured to receive a testing routine;
a plurality of test channels comprising:
channel processors configured to execute tests,
testing circuits coupled to test pins configurable to be connected to a device under test, DUT, and
trigger interfaces coupled to the testing circuits; and
a hub device coupled to the processing system and to the trigger interfaces, the hub device comprising programmable logic gates, wherein:
the hub device is configured to define a trigger group including at least two of the trigger interfaces, the trigger group being defined by configuring at least a portion of the programmable logic gates to logically relate the at least two of the trigger interfaces,
the hub device is configured to route trigger signals according to the testing routine, and
at least a portion of the channel processors are configured to perform an operation according to the testing routine and on receipt, at a corresponding one of the trigger interfaces, of one or more of the trigger signals.

2. The test system of claim 1, wherein:
the hub device is configured to generate the trigger signals according to the testing routine;
the trigger signals are trigger-out signals;
the programmable logic gates comprise AND gates;
the hub device comprises:
a plurality of switches configured to receive trigger-in signals from the test channels, the plurality of switches coupled to inputs of the programmable logic gates via a first routing module, and
a plurality of switches communicating the trigger-out signals, the plurality of switches being coupled to outputs of the programmable logic gates via a second routing module.

3. The test system of claim 1 or 2, wherein:
at least a portion of the plurality of test channels receive the testing routing from the processing system and generate at least a portion of the trigger signals;
the programmable logic gates comprise OR gates;
the hub device comprises a plurality of selection switches configured to receive signals from the test channels, the plurality of selection switches being coupled to inputs of the programmable logic gates via a routing module; and
outputs of the OR gates generate the trigger signals for the trigger group.

4. The test system of any of claims 1 to 3, wherein:
the generated trigger signals are trigger-out signals;
the programmable logic gates comprise AND logic gates; and
the programmable logic gates are configured to:
receive trigger-in signals from the plurality of test channels in the trigger group;
generate the trigger-out signals by combining the trigger-in signals using the AND logic gates such that the trigger-out signals are asserted after each test channel in the trigger group has asserted its trigger-in signal; and
distribute the trigger-out signals to at least a portion of the trigger interfaces.

5. The test system of any of claims 1 to 4,
wherein:
the hub device comprises an FPGA,
the FPGA is coupled to a system clock, and
to define the trigger group, the hub device is configured to associate the DUT with at least a portion of the test pins; and/or
wherein:
the hub device comprises a plurality of configuration registers storing positions associated with the plurality of test channels, and
the programmable logic defines the trigger group based on the positions in the configuration registers.

6. The test system of any of claims 1 to 5, wherein:
the generated trigger signals are trigger-out signals;
the programmable logic gates comprise OR gates; and
the programmable logic gates are configured to:
receive trigger-in signals from the plurality of test channels in the trigger group,
generate the trigger-out signals by combining the trigger-in signals using the OR logic gates such that the trigger-out signals are asserted after at least one of the test channels in the trigger group has asserted its trigger-in signal, and
distribute the trigger-out signals to at least a portion of the trigger interfaces.

7. The test system of any of claims 1 to 6,
wherein the processing system is configured to:
maintain a pool of available trigger groups,
allocate one of the available trigger groups to the testing routine,
provide the one of the available trigger groups to the hub device, and
return the one of the available trigger groups to the pool when testing of the DUT is completed; and/or
wherein:
the operation comprises at least one of a sense operation or a force operation, and
the channel processors are configured to:
perform at least one of arithmetic operations or logical comparisons on test values,
execute conditional branches and loops within a channel routine in response to the at least one of the arithmetic operations or the logical comparisons, and
adjust stimuli applied by the testing circuits without intervention from the processing system.

8. The test system of any of claims 1 to 7, wherein:
the plurality of test channels comprise per-channel memories; and
the processing system is configured to:
compile channel routines associated with the testing routine,
identify channels from the plurality of test channels relevant to the testing routine; and
load, prior to testing the DUT, the channel routines into the per-channel memories associated with the identified channels, the channel routines being configured to cause the channel processors to implement operations related to the testing routine;
optionally wherein the channel routines are configured to cause the corresponding channel processor to at least one of:
acquire a measurement in a sense operation,
force voltage or current in a force operation, or
perform local data processing on the measurement to compute a local result and transmit the local result to the processing system.

9. The test system of any of claims 1 to 8,
wherein:
the hub device comprises a memory accessible to the channel processors storing global variables, and
the channel processors are configured to read or write data values in the global variables; and/or
wherein the testing circuits comprise:
a pulse resource;
a measuring resource comprising a high current switch and a low current switch; and
a mode switch coupled to the pulse resource, the measuring resource, and a potential node, the potential node being coupled to the testing pin, wherein:
the potential node is configured for pulse testing when the mode switch connects the pulse resource with the potential node,
the potential node is configured for high potential testing when the high current switch is closed and the mode switch connects the measuring resource with the potential node, and
the potential node is configured for low potential testing when the low current switch is closed and the mode switch connects the measuring resource with the potential node.

10. The test system of any of claims 1 to 9, wherein:
the programmable logic gates are configured to:
encode the trigger signals as multi-bit trigger codes, and
provide the trigger codes to the test channels via the trigger interfaces;
the channel processors are configured to decode the multi-bit trigger codes, and
the multi-bit trigger codes comprise:
a first code corresponding to a first trigger event generated by an AND function;
a second code corresponding to a second trigger event generated by an OR function; and
a third code corresponding to an error event.

11. The test system of any of claims 1 to 10, wherein at least one of:
the processing system is configured to compile the testing routine and generate channel routines, the channel routines comprising trigger instructions causing the channel processors to wait for the trigger signals at points corresponding to operations of the testing routine with cross-channel synchronization;
the plurality of test channel comprise at least fifty test channel modules;
the trigger group comprises at least twenty trigger groups; or
the hub device is configured to operate trigger groups using the programmable logic gates to generate the trigger signals.

12. The test system of any of claims 1 to 11, wherein:
the processing system is configured to:
load channel routines into per-channel memory devices associated with corresponding channel processors, and
set a trigger mask between the hub device and the plurality of test channels; and
the channel processors are configured to start the channel routines upon receiving the triggering signal from the hub device.

13. The test system of claim of any of claims 1 to 12, wherein the testing routine sets at least three of the plurality of test channels, for testing the DUT, comprising:
a first channel from the plurality of test channels being configured as a gate node,
a second channel from the plurality of test channels being configured as a drain node, and
a third channel from the plurality of test channels being configured as a source node,
each of the first, second, and third channels being configured to perform channel routines comprising a force operation, a sense operation, and a sync operation that is a function of the trigger signals;
optionally wherein the channel routines further comprise delay operations that allow a forced operation in one test channel from the plurality of test channels to settle before a sense operation on another test channel from the plurality of test channels begins.

14. A device comprising:
a first connection for coupling with a processing system;
a second connection for coupling with test channels;
a plurality of programmable logic gates;
a plurality of switches configured to receive trigger-in signals from the test channels, the plurality of switches coupled to inputs of the programmable logic gates via a first routing module;
a plurality of multiplexers configured to provide a trigger-out signal, the plurality of multiplexers being coupled to outputs of the programmable logic gates via a second routing module; and
a plurality of group configuration registers, each group configuration register storing a mask based on membership of the test channels in trigger groups.

15. A method for operating a parametric test system comprising a processing system, a plurality
of test channels, and a hub device, the method comprising:
receiving, at the processing system, a testing routine that specifies tests for a device under test, DUT;
compiling, by the processing system, the testing routine into channel routines to be executed by channel processors;
loading the channel routines into memories associated with the channel processors of the plurality of test channels;
configuring the hub device to define at least one trigger group comprising at least two trigger interfaces associated with at least two of the plurality of test channels;
generating, in the hub device, a trigger signal using a plurality of programmable logic gates and inputs from at least one of the processing system or the plurality of test channels;
outputting, from the hub device, the trigger signal to the at least one trigger group; and
causing the at least two test channels to perform operations in accordance with the testing routine and the trigger signal,
wherein the channel routines comprise instructions causing the channel processors to wait for the trigger signal to synchronize operations of the test procedure based on trigger groups.
